(19) Europäisches Patentamt
European Patent Office
Office européen des brevets

(11) EP 4 317 217 A1

(12) EUROPEAN PATENT APPLICATION
published in accordance with Art. 153(4) EPC

(43) Date of publication:
**07.02.2024 Bulletin 2024/06**

(21) Application number: **22779954.1**

(22) Date of filing: **11.03.2022**

(51) International Patent Classification (IPC):
***C08F 212/14*** *(2006.01)* ***G03F 7/004*** *(2006.01)*
***G03F 7/039*** *(2006.01)* ***G03F 7/20*** *(2006.01)*

(52) Cooperative Patent Classification (CPC):
**C08F 212/14; G03F 7/004; G03F 7/039; G03F 7/20**

(86) International application number:
**PCT/JP2022/010808**

(87) International publication number:
**WO 2022/209733 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.03.2021 JP 2021055493**

(71) Applicant: **FUJIFILM Corporation**
**Tokyo 106-8620 (JP)**

(72) Inventors:
- **TAKAHASHI Kotaro**
  **Haibara-gun, Shizuoka 421-0396 (JP)**
- **YOSHINO Fumihiro**
  **Haibara-gun, Shizuoka 421-0396 (JP)**

(74) Representative: **HGF**
**HGF Limited**
**1 City Walk**
**Leeds LS11 9DX (GB)**

# (54) ACTIVE LIGHT-SENSITIVE OR RADIATION-SENSITIVE RESIN COMPOSITION, RESIST FILM, METHOD FOR FORMING PATTERN, AND METHOD FOR PRODUCING ELECTRONIC DEVICE

(57) An object of the present invention is to provide an actinic ray-sensitive or radiation-sensitive resin composition with which a pattern having excellent LWR and excellent resolution can be obtained, a resist film, a pattern forming method, and a method for manufacturing an electronic device. The actinic ray-sensitive or radiation-sensitive resin composition of the present invention is an actinic ray-sensitive or radiation-sensitive resin composition containing a resin A including a repeating unit a represented by Formula (1), which has a photoacid generating group represented by Formula (c) in a side chain, and a repeating unit b having a group which is decomposed by action of acid to generate a polar group, in which a content of the repeating unit a is 0.40 to 1.50 mmol/g per a total solid content mass of the composition, the actinic ray-sensitive or radiation-sensitive resin composition further contains an acid diffusion control agent which is decomposed by irradiation with an actinic ray or a radiation to generate an acid having a pKa higher than a pKa of an acid generated from the photoacid generating group by 0.50 or more, and Qp obtained by Expression (d) is 0.40 to 1.00.

EP 4 317 217 A1

## Description

## BACKGROUND OF THE INVENTION

1. Field of the Invention

The present invention relates to an actinic ray-sensitive or radiation-sensitive resin composition, a resist film, a pattern forming method, and a method for manufacturing an electronic device.

2. Description of the Related Art

Examples of a pattern forming method include the following method.
An actinic ray-sensitive or radiation-sensitive resin film (hereinafter, also referred to as "resist film") formed of an actinic ray-sensitive or radiation-sensitive resin composition (hereinafter, also referred to as "resist composition") is exposed to light to cause a change in solubility of the resist film in a developer in a region reflecting the exposed pattern. Thereafter, development is performed using a developer (for example, alkali water-based developer, organic solvent-based developer, or the like) to remove an exposed portion or non-exposed portion of the resist film, thereby obtaining a desired pattern.
As the resist composition, for example, JP2012-037876A discloses "radiation-sensitive resin composition containing a polymer having at least one of a repeating unit represented by Formula (I) or a repeating unit represented by Formula (II) and a compound (X1) represented by Formula (B1)".

## SUMMARY OF THE INVENTION

The present inventors have conducted studies on the resist composition disclosed in JP2012-037876, and have found that it is difficult to achieve both roughness performance (Line Width Roughness; LWR) and resolution of a pattern to be obtained.
An object of the present invention is to provide an actinic ray-sensitive or radiation-sensitive resin composition with which a pattern having excellent LWR and excellent resolution can be obtained.
Another object of the present invention is to provide a resist film, a pattern forming method, and a method for manufacturing an electronic device, which relate to the actinic ray-sensitive or radiation-sensitive resin composition.
The present inventors have found that the above-described objects can be achieved by the following configurations.

[1]
An actinic ray-sensitive or radiation-sensitive resin composition comprising:

a resin A including a repeating unit a represented by Formula (1) described later, which has a photoacid generating group represented by Formula (c) described later in a side chain, and
a repeating unit b having a group which is decomposed by action of acid to generate a polar group,
in which a content of the repeating unit a is 0.40 to 1.50 mmol/g per a total solid content mass of the composition,
the actinic ray-sensitive or radiation-sensitive resin composition further contains an acid diffusion control agent which is decomposed by irradiation with an actinic ray or a radiation to generate an acid having a pKa higher than a pKa of an acid generated from the photoacid generating group by 0.50 or more, and
Qp obtained by Expression (d) described later is 0.40 to 1.00.

[2] The actinic ray-sensitive or radiation-sensitive resin composition according to [1],
in which A is a group represented by any of Formulae (a-1) to (a-6) described later.
[3] The actinic ray-sensitive or radiation-sensitive resin composition according to [1],
in which the repeating unit a includes at least one selected from the group consisting of a repeating unit represented by Formula (a1) described later and a repeating unit represented by Formula (a2) described later.
[4] The actinic ray-sensitive or radiation-sensitive resin composition according to any one of [1] to [3],
in which the content of the repeating unit a is 0.60 to 1.50 mmol/g per the total solid content mass of the composition.
[5] The actinic ray-sensitive or radiation-sensitive resin composition according to any one of [1] to [4],
in which the resin A further includes a repeating unit represented by Formula (A2) described later.
[6] The actinic ray-sensitive or radiation-sensitive resin composition according to any one of [1] to [5],
in which Qp is 0.50 to 1.00.
[7] The actinic ray-sensitive or radiation-sensitive resin composition according to any one of [1] to [6],

in which the acid diffusion control agent generates an acid having a pKa higher than the pKa of the acid generated from the photoacid generating group by 1.00 or more.
[8] The actinic ray-sensitive or radiation-sensitive resin composition according to any one of [1] to [7],
in which the acid diffusion control agent includes at least one selected from the group consisting of a compound represented by Formula (C1) described later and a compound represented by Formula (C2) described later.
[9] The actinic ray-sensitive or radiation-sensitive resin composition according to any one of [1] to [8],
in which the actinic ray-sensitive or radiation-sensitive resin composition further contains the other photoacid generator.
[10] A resist film formed of the actinic ray-sensitive or radiation-sensitive resin composition according to any one of [1] to [9].
[11] A pattern forming method comprising:

a step of forming a resist film on a substrate using the actinic ray-sensitive or radiation-sensitive resin composition according to any one of [1] to [9];
a step of exposing the resist film; and
a step of developing the exposed resist film using a developer.

[12] The pattern forming method according to [10],
in which the exposing step is a step of exposing the resist film using a multi-electron beam.
[13] A method for manufacturing an electronic device, comprising:
the pattern forming method according to [11] or [12].

According to the present invention, it is possible to provide an actinic ray-sensitive or radiation-sensitive resin composition having excellent LWR and excellent resolution.
In addition, according to the present invention, it is possible to provide a resist film, a pattern forming method, and a method for manufacturing an electronic device, which relate to the actinic ray-sensitive or radiation-sensitive resin composition.

## DESCRIPTION OF THE PREFERRED EMBODIMENTS

Hereinafter, the present invention will be described in detail.
Description of configuration requirements described below may be made on the basis of representative embodiments of the present invention in some cases, but the present invention is not limited to such embodiments.
In notations for a group (atomic group) in the present specification, in a case where the group is cited without specifying that it is substituted or unsubstituted, the group includes both a group having no substituent and a group having a substituent as long as it does not impair the spirit of the present invention. For example, an "alkyl group" includes not only an alkyl group having no substituent (unsubstituted alkyl group), but also an alkyl group having a substituent (substituted alkyl group).
In addition, an "organic group" in the present specification refers to a group including at least one carbon atom.
A substituent is preferably a monovalent substituent unless otherwise specified.
"Actinic ray" or "radiation" in the present specification means, for example, a bright line spectrum of a mercury lamp, far ultraviolet rays typified by an excimer laser, extreme ultraviolet rays (EUV light), X-rays, or electron beams (EB).
"Light" in the present specification means actinic ray or radiation.
In the present specification, unless otherwise specified, "exposure" encompasses not only exposure by a bright line spectrum of a mercury lamp, far ultraviolet rays typified by an excimer laser, extreme ultraviolet rays, X-rays, EUV light, or the like, but also drawing by particle beams such as electron beams and ion beams.
In the present specification, a numerical range expressed using "to" is used in a meaning of a range that includes the preceding and succeeding numerical values of "to" as the lower limit and the upper limit, respectively.
A bonding direction of divalent groups cited in the present specification is not limited unless otherwise specified. For example, in a case where Y in a compound represented by Formula "X-Y-Z" is -COO-, Y may be -CO-O- or -O-CO-. In addition, the above-described compound may be "X-CO-O-Z" or "X-O-CO-Z".
In the present specification, (meth)acrylate represents acrylate and methacrylate, and (meth)acryl represents acryl and methacryl.
In the present specification, a weight-average molecular weight (Mw), a number-average molecular weight (Mn), and a dispersity (hereinafter, also referred to as "molecular weight distribution") (Mw/Mn) are defined as values expressed in terms of polystyrene by means of gel permeation chromatography (GPC) measurement (solvent: tetrahydrofuran, flow amount (amount of a sample injected): 10 μL, columns: TSK gel Multipore HXL-M manufactured by Tosoh Corporation, column temperature: 40°C, flow rate: 1.0 mL/min, and detector: differential refractive index detector) using

a GPC apparatus (HLC-8120GPC manufactured by Tosoh Corporation).

In the present specification, an acid dissociation constant (pKa) represents a pKa in an aqueous solution, and is specifically a value determined by computation from a value based on a Hammett's substituent constant and database of publicly known literature values, using the following software package 1.

Software Package 1: Advanced Chemistry Development (ACD/Labs) Software V 8.14 for Solaris (1994 - 2007 ACD/Labs).

In addition, the pKa can also be determined by a molecular orbital computation method. Examples of a specific method therefor include a method for performing calculation by computing $H^+$ dissociation free energy in an aqueous solution based on a thermodynamic cycle. With regard to a computation method for $H^+$ dissociation free energy, the $H^+$ dissociation free energy can be computed by, for example, density functional theory (DFT), but various other methods have been reported in literature and the like, and are not limited thereto. There are a plurality of software applications capable of performing DFT, and examples thereof include Gaussian 16.

As described above, the pKa in the present specification refers to a value determined by computation from a value based on a Hammett's substituent constant and database of publicly known literature values, using the software package 1, but in a case where the pKa cannot be calculated by the method, a value obtained by Gaussian 16 based on density functional theory (DFT) shall be adopted.

In addition, the pKa in the present specification refers to a "pKa in an aqueous solution" as described above, but in a case where the pKa in an aqueous solution cannot be calculated, a "pKa in a dimethyl sulfoxide (DMSO) solution" shall be adopted.

"Solid content" is intended to be components which form the resist film, and does not include a solvent. In addition, even in a case where a component is liquid, the component is included in the solid content as long as the component forms the resist film.

Hereinafter, the resist composition according to the embodiment of the present invention will be described in detail.

The resist composition may be either a positive tone resist composition or a negative tone resist composition. In addition, the resist composition according to the embodiment of the present invention may be either a resist composition for alkali development or a resist composition for organic solvent development.

The resist composition is typically a chemically amplified resist composition.

Hereinafter, first, various components of the resist composition will be described in detail.

[Resist Composition]

The actinic ray-sensitive or radiation-sensitive resin composition according to the embodiment of the present invention is an actinic ray-sensitive or radiation-sensitive resin composition containing a resin A including a repeating unit a represented by Formula (1), which has a photoacid generating group represented by Formula (c) described later in a side chain, and a repeating unit b having a group (hereinafter, also referred to as "acid-decomposable group") which is decomposed by action of acid to generate a polar group, in which a content of the repeating unit a is 0.40 to 1.50 mmol/g per a total solid content mass of the composition, the actinic ray-sensitive or radiation-sensitive resin composition further contains an acid diffusion control agent (hereinafter, also referred to as "specific acid diffusion control agent") which is decomposed by irradiation with an actinic ray or a radiation to generate an acid having a pKa higher than a pKa of an acid generated from the photoacid generating group by 0.50 or more, and Qp obtained by Expression (d) described later is 0.40 to 1.00.

A working mechanism by which the object can be achieved by adopting the above-described configuration is not always clear, but the present inventors have presumed that, in the case of the above-described configuration, since a resist film formed of the resist composition according to the embodiment of the present invention has excellent exposure latitude, a pattern having excellent LWR and excellent resolution is obtained.

Hereinafter, the fact that at least one effect of LWR or resolution is more excellent is also referred to as "effect of the present invention is more excellent".

<Qp>

Qp is a value obtained by Expression (d).

Each component will be described below.

$$Qp = X/Y \qquad (d)$$

X represents a molar amount of the specific acid diffusion control agent in the resist composition.

In a case where the resist composition contains other photoacid generator as a component other than the resin A and the specific acid diffusion control agent, Y represents a total molar amount of the molar amount of the specific acid diffusion control agent, a molar amount of the repeating unit a, and a molar amount of the other photoacid generator, or in a case where the resist composition does not contain other photoacid generator as a component other than the resin A and the specific acid diffusion control agent, Y represents a total molar amount of the molar amount of the specific acid diffusion control agent and a molar amount of the repeating unit a.

In other words, in a case where the resist composition contains the above-described other photoacid generator, Qp is obtained by [(Molar amount of specific acid diffusion control agent)/(Total molar amount of molar amount of specific acid diffusion control agent + molar amount of repeating unit a + molar amount of other photoacid generator)], and in a case where the resist composition does not contain the above-described other photoacid generator, Qp is obtained by [(Molar amount of specific acid diffusion control agent)/(Total molar amount of molar amount of specific acid diffusion control agent + molar amount of repeating unit a)].

Qp is 0.40 to 1.00, and from the viewpoint that the effect of the present invention is more excellent, it is preferably 0.50 to 1.00, more preferably 0.60 to 1.00, and still more preferably 0.70 to 1.00.

As a method for measuring Qp, for example, each component can be specified by a known method and calculated from the content thereof.

<Resin A>

The resist composition contains the resin A.

The resin A includes a repeating unit a and a repeating unit b.

(Repeating Unit a)

The repeating unit a is a repeating unit represented by Formula (1), which has a photoacid generating group represented by Formula (c) in a side chain.

The side chain corresponds to a monovalent group portion extending from a main chain portion which is a carbon chain having the largest number of carbon atoms in the resin. For example, a partial structure of "$-L^{a1}-A_{a1}^{-} Z_{a1}^{+}$" in Formula (a1) described later corresponds to the side chain. In addition, for example, A in Formula (1) described later and Y in Formula (a2) described later do not correspond to the side chain.

A content of the repeating unit a is 0.40 to 1.50 mmol/g per total solid content mass of the resist composition, and from the viewpoint that the effect of the present invention is more excellent, it is preferably 0.60 to 1.50 mmol/g, more preferably 0.80 to 1.50 mmol/g, still more preferably 1.00 to 1.50 mmol/g, and particularly preferably 1.20 to 1.50 mmol/g.

The content of the repeating unit a per total solid content mass of the resist composition can be calculated from contents of each component contained in the resist composition, and for example, the content can be calculated by the following method.

In a case where the resist composition contains the resin A including the repeating unit a and the repeating unit b, the specific acid diffusion control agent, and a solvent, the above-described content can be calculated by [Molar amount of repeating unit a)/(Total solid content mass of resin A and specific acid diffusion control agent)]. In such a case, the total solid content mass of the resin A and the specific acid diffusion control agent corresponds to the total solid content mass of the resist composition.

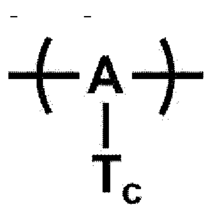

(1)

In Formula (1), A represents a group constituting a main chain, and $T_c$ represents the photoacid generating group represented by Formula (c).

A represents a group constituting a main chain.

A is preferably a group represented by any one of Formulae (a-1) to (a-6), and more preferably a group represented by any one of Formula (a-1), Formula (a-2), or Formulae (a-4) to (a-6). It is preferable that A does not have a fluorine atom.

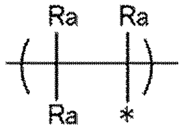

(a-1)

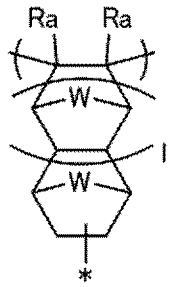

(a-2)

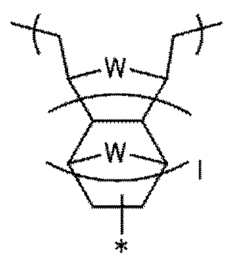

(a-3)

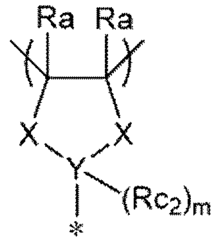

(a-4)

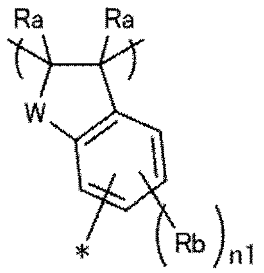

(a-5)

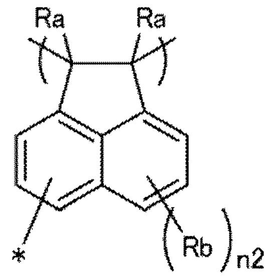

(a-6)

In Formulae (a-1) to (a-6), Ra's each independently represent a hydrogen atom, an alkyl group, or $-CH_2-O-Ra_2$. $Ra_2$ represents a hydrogen atom, an alkyl group, or an acyl group. In a case where a plurality of Ra's are present in the same formula, two Ra's may be bonded to each other to form a ring. The above-described alkyl group may be linear or branched, and the number of carbon atoms therein is preferably 1 to 6. In addition, it is preferable that the above-described alkyl group and the above-described acyl group do not have a fluorine atom.

W's each independently represent a methylene group, an oxygen atom, or a sulfur atom.

X's each independently represent $-C(Rc_1)_2-$ or -C(=O)-.

$Rc_1$'s each independently represent a hydrogen atom, an alkyl group, or an alkoxy group. In addition, it is preferable that the above-described alkyl group and the above-described alkoxy group do not have a fluorine atom.

Y represents a nitrogen atom or a carbon atom. m represents 0 or 1. In a case where Y is a nitrogen atom, m is 0, and in a case where Y is a carbon atom, m is 1.

$Rc_2$ represents a hydrogen atom or a substituent. In addition, it is preferable that the above-described substituent does not have a fluorine atom. Rb's each independently represent an organic group. In addition, it is preferable that the above-described organic group does not have a fluorine atom. n1 represents an integer of 0 to 3. n2 represents an integer of 0 to 5. l represents 0 or 1. * represents a bonding position.

In addition, it is also preferable that A in Formula (1) is a group consisting of only atoms selected from the group consisting of a hydrogen atom and a carbon atom.

$T_c$ represents the photoacid generating group represented by Formula (c).

The photoacid generating group is a group consisting of an anionic group and a cation, and is a group which generates an acid by irradiation with actinic ray or radiation. As the photoacid generating group, a group which generates an organic acid by exposure is preferable.

$$*-L^c-A^- Z_c^+ \qquad (c)$$

In Formula (c), $A^-$ represents an anionic group, $Z_c^+$ represents an organic cation, $L^c$ represents a single bond or a divalent linking group having no fluorine atom, and * represents a bonding position.

$A^-$ represents an anionic group.

Examples of $A^-$ include a sulfonic acid anionic group ($-SO_3^-$), a carboxylic acid anionic group, a phosphate anionic group ($-OP(=O)(OH)O^-$), a sulfate anionic group ($-OS(=O)_2O^-$), a phosphonate anionic group ($-P(=O)(OH)O^-$), a phosphinate anionic group ($-PH(=O)O^-$), an amide anionic group ($-N^--R$), and a carboanionic group ($-C^-RR$). R's each independently represent a substituent.

As $A^-$, a sulfonic acid anionic group ($-SO_3^-$) or a carboxylic acid anionic group ($-COO^-$) is preferable, and a sulfonic acid anionic group ($-SO_3^-$) is more preferable.

$L^c$ represents a single bond or a divalent linking group having no fluorine atom.

Examples of the divalent linking group include -O-CO-O-, -COO-, -CONH-, -CO-, -O-, -S-, -SO-, $-SO_2-$, an alkylene group (preferably having 1 to 6 carbon atoms) having no fluorine atom, a cycloalkylene group (preferably having 3 to 15 carbon atoms) having no fluorine atom, an alkenylene group (preferably having 2 to 6 carbon atoms) having no fluorine atom, an arylene group (having 6 to 12 carbon atoms) having no fluorine atom, and a group formed by a combination of these groups.

The above-described divalent linking group may further have a substituent which does not have a fluorine atom. The above-described substituent is preferably an iodine atom. In addition, as the above-described divalent linking group, an alkylene group having no fluorine atom, a cycloalkylene group having no fluorine atom, or an arylene group having no fluorine atom is preferable, and an alkylene group having an iodine atom or an arylene group having an iodine atom is more preferable.

As the partial structure represented by "$*-L^c-A^-$", among other photoacid generators described later, a group formed by removing one hydrogen atom from "$X^-$" having no fluorine atom in the other photoacid generator is preferable.

$Z_c^+$ represents an organic cation.

The organic cation has the same meaning as, for example, $M^+$ in the other photoacid generator described later, and a suitable aspect thereof is also the same. $Z_c^+$ may have a fluorine atom.

A pKa of the acid generated from the photoacid generating group represented by Formula (c) is preferably -5.00 to 5.00, more preferably -3.00 to 3.00, and still more preferably -3.00 to 2.00.

Examples of a method for measuring the pKa of the acid generated from the photoacid generating group represented by Formula (c) include a method in which, for example, in the photoacid generating group represented by "$*-L^c-A^- Z_c^+$", using a compound that * is replaced with a hydrogen atom and $Z_c^+$ is replaced with $H^+$ to obtain "$H-L^c-A^- H^+$", a pKa of the compound is calculated by the pKa calculation method described above (for example, software package 1 or the like). Specifically, in a case of a photoacid generating group represented by Formula (Q1), a pKa of the acid generated from the photoacid generating group means a pKa of the acid generated from a compound represented by Formula (Q2).

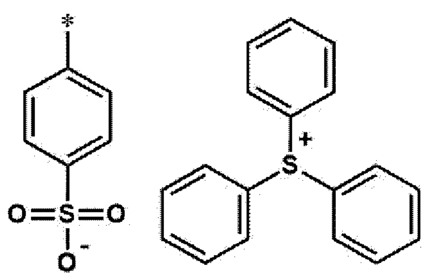

(Q1)

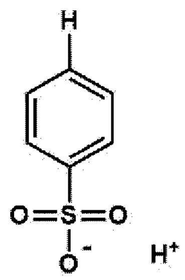

(Q2)

As the repeating unit a, at least one selected from the group consisting of a repeating unit represented by Formula (a1) and a repeating unit represented by Formula (a2) is preferable, and a repeating unit represented by Formula (a1) is more preferable.

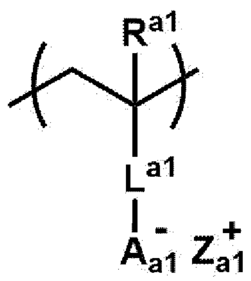

(a1)

In Formula (a1), $R^{a1}$ represents a hydrogen atom or a substituent, $L^{a1}$ represents a single bond or a divalent linking group having no fluorine atom, $A_{a1}^-$ represents an anionic group, and $Z_{a1}^+$ represents an organic cation.

$R^{a1}$ represents a hydrogen atom or a substituent.

Examples of the substituent include an alkyl group, a cycloalkyl group, a halogen atom, a cyano group, and an alkoxycarbonyl group, and an alkyl group is preferable and a methyl group is more preferable.

$L^{a1}$ represents a single bond or a divalent linking group having no fluorine atom.

Examples of the divalent linking group having no fluorine atom include the divalent linking group having no fluorine atom, which can be adopted as $L^c$ in Formula (c) described above.

Each of $A_{a1}^-$ and $Z_{a1}^+$ has the same meaning as $A^-$ and $Z_c^+$ in Formula (c) described above, and a suitable aspect thereof is also the same.

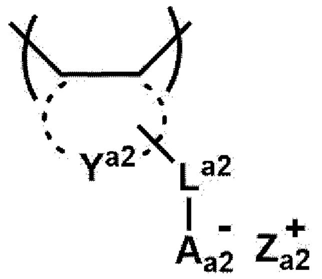

(a2)

In Formula (a2), $Y^{a2}$ represents a ring group, $L^{a2}$ represents a single bond or a divalent linking group having no fluorine atom, $A_{a2}^-$ represents an anionic group, and $Z_{a2}^+$ represents an organic cation.

$Y^{a2}$ represents a ring group. In other words, $Y^{a2}$ is a ring group having two or more carbon atoms.

Examples of a ring forming the ring group include an alicyclic ring, an aromatic ring, and a ring formed by a combination of these rings. In addition, the above-described ring may be a monocycle or a polycycle.

The number of ring member atoms in the above-described ring is preferably 5 to 20. Ring member atoms of the above-described aromatic ring group may have one or more (for example, one to five) heteroatoms (for example, oxygen atom, sulfur atom, nitrogen atom, and the like).

The number of rings in the ring forming the ring group is preferably 1 to 5 and more preferably 1 to 3.

Examples of the alicyclic ring include a monocyclic alicyclic ring such as a cycloalkane ring (cyclopentane ring, cyclohexane ring, and the like) and a cycloalkene ring; and a polycyclic alicyclic ring such as a bicycloundecane ring, a decahydronaphthalene ring, a norbornene ring, a norbornadiene ring, and an adamantane ring.

Examples of the aromatic ring include an aromatic homocyclic ring such as a benzene ring, a naphthalene ring, and an anthracene ring; and an aromatic heterocyclic ring such as a thiazole ring, for example, benzothiazole, and an aromatic homocyclic ring is preferable and a benzene ring or a naphthalene ring is more preferable.

As the ring formed by a combination of the alicyclic ring and the aromatic ring, a benzocyclobutane ring, an indane ring, or an acenaphthene ring is preferable.

The ring group may further have a substituent. The above-described substituent is preferably an alkyl group.

The above-described ring group is preferably a ring group having no fluorine atom.

$L^{a2}$ represents a single bond or a divalent linking group having no fluorine atom.

Examples of the divalent linking group having no fluorine atom include the divalent linking group having no fluorine atom, which can be adopted as $L^c$ in Formula (c) described above.

$L^{a2}$ is preferably a single bond.

Each of $A_{a2}^-$ and $Z_{a2}^+$ has the same meaning as $A_{a1}^-$ and $Z_{a1}^+$ in Formula (a1), and a suitable aspect thereof is also the same.

A content of the repeating unit a is preferably 1% by mole or more, more preferably 5% by mole or more, and still more preferably 10% by mole or more with respect to all repeating units in the resin A. The upper limit thereof is preferably 50% by mole or less, more preferably 40% by mole or less, and still more preferably 30% by mole or less with respect to all repeating units in the resin A.

(Repeating Unit b)

The repeating unit b is a repeating unit having an acid-decomposable group.

In the pattern forming method according to the embodiment of the present invention, typically, in a case where an alkali developer is adopted as a developer, a positive tone pattern is suitably formed, and in a case where an organic developer is adopted as a developer, a negative tone pattern is suitably formed.

As the repeating unit having an acid-decomposable group, in addition to (repeating Unit having an acid-decomposable group) described below, (repeating unit having an acid-decomposable group including an unsaturated bond) is preferable.

The acid-decomposable group is a group which is decomposed by action of acid to form a polar group. The acid-decomposable group preferably has a structure in which a polar group is protected by a leaving group which is eliminated by action of acid. The resin including the repeating unit having an acid-decomposable group has an increased polarity by action of acid, an increased solubility in an alkali developer, and a decreased solubility in an organic solvent.

As the polar group, an alkali-soluble group is preferable, and examples thereof include an acidic group, such as a carboxy group, a phenolic hydroxyl group, a fluorinated alcohol group, a sulfonic acid group, a phosphoric acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group; and an alcoholic hydroxyl group.

Among these, as the polar group, a carboxy group, a phenolic hydroxyl group, a fluorinated alcohol group (preferably, a hexafluoroisopropanol group), or a sulfonic acid group is preferable.

Examples of the leaving group which is eliminated by action of acid include groups represented by Formulae (Y1) to (Y4).

Formula (Y1): $-C(Rx_1)(Rx_2)(Rx_3)$

Formula (Y2): $-C(=O)OC(Rx_1)(Rx_2)(Rx_3)$

Formula (Y3): $-C(R_{36})(R_{37})(OR_{38})$

Formula (Y4): $-C(Rn)(H)(Ar)$

In Formula (Y1) and Formula (Y2), $Rx_1$ to $Rx_3$ each independently represent a (linear or branched) alkyl group, a (monocyclic or polycyclic) cycloalkyl group, an (linear or branched) alkenyl group, or a (monocyclic or polycyclic) aryl group. In a case where all of $Rx_1$ to $Rx_3$ are (linear or branched) alkyl groups, it is preferable that at least two of $Rx_1$ to $Rx_3$ are methyl groups.

Among these, it is preferable that $Rx_1$ to $Rx_3$ each independently represent a linear or branched alkyl group, and it is more preferable that $Rx_1$ to $Rx_3$ each independently represent a linear alkyl group.

Two of $Rx_1$ to $Rx_3$ may be bonded to each other to form a monocycle or a polycycle.

As the alkyl group of $Rx_1$ to $Rx_3$, an alkyl group having 1 to 5 carbon atoms, such as a methyl group, an ethyl group, an n-propyl group, an isopropyl group, an n-butyl group, an isobutyl group, and a t-butyl group, is preferable.

As the cycloalkyl group of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of $Rx_1$ to $Rx_3$, an aryl group having 6 to 10 carbon atoms is preferable, and examples thereof include a phenyl group, a naphthyl group, and an anthryl group.

As the alkenyl group of $Rx_1$ to $Rx_3$, a vinyl group is preferable.

A cycloalkyl group is preferable as the ring formed by the bonding of two of $Rx_1$ to $Rx_3$. As a cycloalkyl group formed by the bonding of two of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable, and a monocyclic cycloalkyl group having 5 or 6 carbon atoms is more preferable.

In the cycloalkyl group formed by the bonding of two of $Rx_1$ to $Rx_3$, one of methylene groups constituting the ring may be replaced with a heteroatom such as an oxygen atom, with a group including a heteroatom, such as a carbonyl group, or with a vinylidene group. In addition, in the cycloalkyl group, one or more of the ethylene groups constituting the cycloalkane ring may be replaced with a vinylene group.

With regard to the group represented by Formula (Y1) or Formula (Y2), for example, an aspect in which $Rx_1$ is a methyl group or an ethyl group and $Rx_2$ and $Rx_3$ are bonded to each other to form the above-described cycloalkyl group is preferable.

For example, in a case where the resist composition is a resist composition for EUV exposure, it is also preferable that the alkyl group, cycloalkyl group, alkenyl group, and aryl group represented by $Rx_1$ to $Rx_3$ and the ring formed by bonding two of $Rx_1$ to $Rx_3$ further have a fluorine atom or an iodine atom as a substituent.

In Formula (Y3), $R_{36}$ to $R_{38}$ each independently represent a hydrogen atom or a monovalent organic group. $R_{37}$ and $R_{38}$ may be bonded to each other to form a ring. Examples of the monovalent organic group include an alkyl group, a cycloalkyl group, an aryl group, an aralkyl group, and an alkenyl group. It is also preferable that $R_{36}$ is a hydrogen

atom.

The alkyl group, the cycloalkyl group, the aryl group, and the aralkyl group may include a heteroatom such as an oxygen atom, and/or a group including a heteroatom, such as a carbonyl group. For example, in the above-described alkyl group, cycloalkyl group, aryl group, and aralkyl group, one or more of methylene groups may be replaced with a heteroatom such as an oxygen atom and/or with a group including a heteroatom, such as a carbonyl group.

In addition, $R_{38}$ and another substituent included in the main chain of the repeating unit may be bonded to each other to form a ring. A group formed by the mutual bonding of $R_{38}$ and another substituent on the main chain of the repeating unit is preferably an alkylene group such as a methylene group.

For example, in a case where the resist composition is a resist composition for EUV exposure, it is also preferable that the monovalent organic group represented by $R_{36}$ to $R_{38}$ and the ring formed by bonding $R_{37}$ and $R_{38}$ with each other further have a fluorine atom or an iodine atom as a substituent.

As Formula (Y3), a group represented by Formula (Y3-1) is preferable.

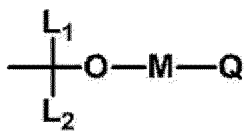 (Y3-1)

In Formula (Y3-1), $L_1$ and $L_2$ each independently represent a hydrogen atom, an alkyl group, a cycloalkyl group, an aryl group, or a group formed by a combination thereof (for example, a group formed by a combination of an alkyl group and an aryl group).

M represents a single bond or a divalent linking group.

Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by a combination thereof (for example, a group formed by a combination of an alkyl group and a cycloalkyl group).

In the alkyl group and the cycloalkyl group, for example, one of methylene groups may be replaced with a heteroatom such as an oxygen atom or with a group including a heteroatom, such as a carbonyl group.

It is preferable that one of $L_1$ or $L_2$ is a hydrogen atom, and the other is an alkyl group, a cycloalkyl group, an aryl group, or a group formed by a combination of an alkylene group and an aryl group.

At least two of Q, M, or $L_1$ may be bonded to each other to form a ring (preferably a 5- or 6-membered ring).

From the viewpoint of pattern miniaturization, $L_2$ is preferably a secondary or tertiary alkyl group, and more preferably a tertiary alkyl group. Examples of the secondary alkyl group include an isopropyl group, a cyclohexyl group, and a norbornyl group, and examples of the tertiary alkyl group include a tert-butyl group and an adamantane group. In these aspects, since a glass transition temperature (Tg) and an activation energy are increased, it is possible to suppress fogging in addition to ensuring a film hardness.

It is also preferable that the alkyl group, cycloalkyl group, aryl group, and group formed by a combination thereof, represented by $L_1$ and $L_2$, further have a fluorine atom or an iodine atom as a substituent. In addition, it is also preferable that the above-described alkyl group, cycloalkyl group, aryl group, and aralkyl group include a heteroatom such as an oxygen atom in addition to the fluorine atom and the iodine atom (that is, in the above-described alkyl group, cycloalkyl group, aryl group, and aralkyl group, for example, one of methylene groups may be replaced with a heteroatom such as an oxygen atom or with a group including a heteroatom, such as a carbonyl group).

In addition, in the alkyl group which may include a heteroatom, the cycloalkyl group which may include a heteroatom, the aryl group which may include a heteroatom, the amino group, the ammonium group, the mercapto group, the cyano group, the aldehyde group, and the group formed by a combination thereof, which are represented by Q, the heteroatom is also preferably a heteroatom selected from the group consisting of a fluorine atom, an iodine atom, and an oxygen atom.

In Formula (Y4), Ar represents an aromatic ring group. Rn represents an alkyl group, a cycloalkyl group, or an aryl group. Rn and Ar may be bonded to each other to form a non-aromatic ring. Ar is preferably an aryl group.

It is also preferable that the aromatic ring group represented by Ar and the alkyl group, cycloalkyl group, and aryl group represented by Rn further have a fluorine atom or an iodine atom as a substituent.

From the viewpoint that the acid decomposability of the repeating unit is excellent, in a case where a non-aromatic ring is directly bonded to a polar group (or a residue thereof) in a leaving group which protects the polar group, it is also preferable that a ring member atom adjacent to the ring member atom directly bonded to the polar group (or a residue thereof) in the non-aromatic ring has no halogen atom such as a fluorine atom as a substituent.

In addition, the leaving group which is eliminated by action of acid may be a 2-cyclopentenyl group having a substituent (an alkyl group and the like), such as a 3-methyl-2-cyclopentenyl group, and a cyclohexyl group having a

substituent (an alkyl group and the like), such as a 1,1,4,4-tetramethylcyclohexyl group.

The repeating unit b having an acid-decomposable group is preferably a repeating unit represented by any one of Formulae (3) to (7), more preferably a repeating unit represented by Formula (6) or (7), and still more preferably a repeating unit represented by Formula (6).

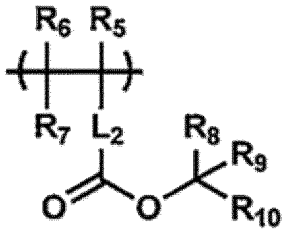

(3)

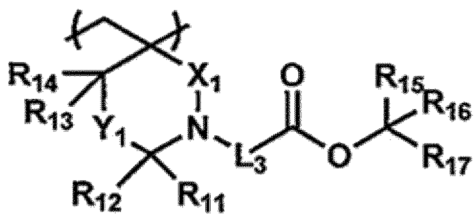

(4)

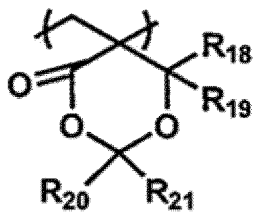

(5)

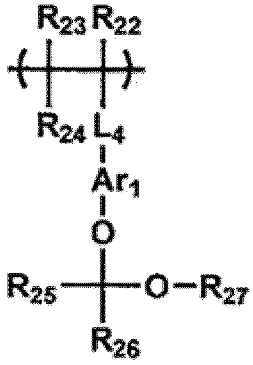

(6)

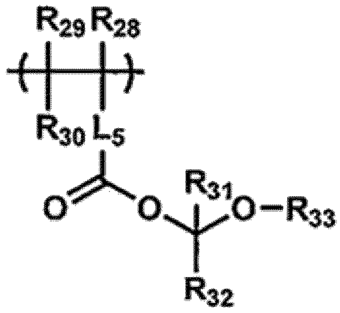

(7)

In Formula (3), $R_5$ to $R_7$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

Among these, $R_5$ is preferably a hydrogen atom or an alkyl group.

$R_6$ and $R_7$ are each independently preferably a hydrogen atom.

In Formula (3), $L_2$ represents a single bond or a divalent linking group.

Examples of the above-described divalent linking group include -CO-, -NR-, -CO-, -O-, -S-, -SO-, $-SO_2-$, an alkylene group (preferably having 1 to 6 carbon atoms; which may be linear or branched), a cycloalkylene group (preferably having 3 to 15 carbon atoms), an alkenylene group (preferably having 2 to 6 carbon atoms), a divalent aliphatic heterocyclic group (preferably a ring having the number of ring member atoms of 5 to 10, in which at least one of a nitrogen atom, an oxygen atom, a sulfur atom, or a selenium atom is included as the ring member atom), a divalent aromatic heterocyclic group (preferably a ring having the number of ring member atoms of 5 to 10, in which at least one of a nitrogen atom, an oxygen atom, a sulfur atom, or a selenium atom is included as the ring member atom), a divalent aromatic hydrocarbon ring group (preferably a ring having the number of ring member atoms of 6 to 10), and a divalent linking group formed by a combination of a plurality of these groups. R in -NR- represents a hydrogen atom or an organic group. The above-described organic group is preferably an alkyl group (for example, having 1 to 6 carbon atoms).

In Formula (3), $R_8$ to $R_{10}$ each independently represent an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_8$ to $R_{10}$ in Formula (3) include the same groups described as the alkyl group, the cycloalkyl group, the aryl group, the aralkyl group, and the alkenyl group represented by $Rx_1$ to $Rx_3$ in Formula (Y1) and Formula (Y2) described above.

Two of $R_8$ to $R_{10}$ may be bonded to each other to form a ring.

Examples of the ring formed by bonding two of $R_8$ to $R_{10}$ in Formula (3) to each other include the same ring described as the ring formed by bonding two of $Rx_1$ to $Rx_3$ in Formula (Y1) and Formula (Y2) above.

In Formula (4), $R_{11}$ to $R_{14}$ each independently represent a hydrogen atom or an organic group (preferably

having 1 to 6 carbon atoms). However, at least one of $R_{11}$ or $R_{12}$ represents an organic group.

In Formula (4), $X_1$ represents -CO-, -SO-, or -$SO_2$-.

In Formula (4), $Y_1$ represents -O-, -S-, -SO-, -$SO_2$-, or -$NR_{34}$-. $R_{34}$ represents a hydrogen atom or an organic group. The above-described organic group is preferably an alkyl group (for example, having 1 to 6 carbon atoms).

In Formula (4), $L_3$ represents a single bond or a divalent linking group.

Examples of the divalent linking group represented by $L_3$ in Formula (4) include the same group described as the divalent linking group represented by $L_2$ in Formula (3) described above.

In Formula (4), $R_{15}$ to $R_{17}$ each independently represent an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_{15}$ to $R_{17}$ in Formula (4) include the same groups described as the alkyl group, the cycloalkyl group, the aryl group, the aralkyl group, and the alkenyl group represented by $Rx_1$ to $Rx_3$ in Formula (Y1) and Formula (Y2) described above.

Two of $R_{15}$ to $R_{17}$ may be bonded to each other to form a ring.

Examples of the ring formed by bonding two of $R_{15}$ to $R_{17}$ in Formula (4) to each other include the same ring described as the ring formed by bonding two of $Rx_1$ to $Rx_3$ in Formula (Y1) and Formula (Y2) above.

In Formula (5), $R_{18}$ and $R_{19}$ each independently represent a hydrogen atom or an organic group (preferably having 1 to 6 carbon atoms).

In Formula (5), $R_{20}$ and $R_{21}$ each independently represent a hydrogen atom, an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_{20}$ and $R_{21}$ in Formula (5) include the same groups described as the alkyl group, the cycloalkyl group, the aryl group, the aralkyl group, and the alkenyl group represented by $Rx_1$ to $Rx_3$ in Formula (Y1) and Formula (Y2) described above.

$R_{20}$ and $R_{21}$ may be bonded to each other to form a ring.

Examples of the ring formed by bonding $R_{20}$ and $R_{21}$ in Formula (5) to each other include the same ring described as the ring formed by bonding two of $Rx_1$ to $Rx_3$ in Formula (Y1) and Formula (Y2) above.

In Formula (6), $R_{22}$ to $R_{24}$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

In Formula (6), $L_4$ represents a single bond or a divalent linking group.

Examples of the divalent linking group represented by $L_4$ in Formula (6) include the same group described as the divalent linking group represented by $L_2$ in Formula (3) described above.

In Formula (6), An represents an aromatic ring group. The above-described aromatic ring group may be monocyclic or polycyclic, and may or may not have one or more (for example, one to three) heteroatoms as ring member atoms. The number of ring member atoms in the above-described aromatic ring group is preferably 5 to 15.

An is preferably a benzene ring group.

In Formula (6), $R_{25}$ to $R_{27}$ each independently represent a hydrogen atom, an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_{25}$ to $R_{27}$ in Formula (6) include the same groups described as the alkyl group, the cycloalkyl group, the aryl group, the aralkyl group, and the alkenyl group represented by $Rx_1$ to $Rx_3$ in Formula (Y1) and Formula (Y2) described above.

$R_{26}$ and $R_{27}$ may be bonded to each other to form a ring.

In a case where $R_{26}$ and $R_{27}$ in Formula (6) are bonded to each other to form a ring, it is preferable that $R_{26}$ and $R_{27}$ jointly form one divalent linking group. Examples of such a divalent linking group include the same group described as the divalent linking group represented by $L_2$ in Formula (3) described above, and an alkylene group is preferable.

In addition, $R_{24}$ or $R_{25}$ may be bonded to An.

In a case where $R_{24}$ is bonded to An, it is preferable that $R_{24}$ is a single bond or a divalent linking group and is bonded to a ring member atom of the aromatic ring group represented by An. Examples of such a divalent linking group include the same group described as the divalent linking group represented by $L_2$ in Formula (3) described above, and an alkylene group is preferable.

In addition, in a case where $R_{25}$ is bonded to An, it is preferable that $R_{25}$ is a divalent linking group and is bonded to a ring member atom of the aromatic ring group represented by An. Examples of such a divalent linking group include the same group described as the divalent linking group represented by $L_2$ in Formula (3) described above, and an alkylene group is preferable.

In Formula (7), $R_{28}$ to $R_{30}$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).
In Formula (7), $L_5$ represents a single bond or a divalent linking group.
Examples of the divalent linking group represented by $L_5$ in Formula (7) include the same group described as the divalent linking group represented by $L_2$ in Formula (3) described above.
$R_{31}$ and $R_{32}$ each independently represent a hydrogen atom, an alkyl group, a cycloalkyl group, an aryl group, an aralkyl group, or an alkenyl group.
$R_{33}$ represents an alkyl group, a cycloalkyl group, an aryl group, an aralkyl group, or an alkenyl group.
Examples of the alkyl group, the cycloalkyl group, the aryl group, the aralkyl group, and the alkenyl group represented by $R_{31}$ to $R_{33}$ in Formula (7) include the same groups described as the alkyl group, the cycloalkyl group, the aryl group, the aralkyl group, and the alkenyl group represented by $Rx_1$ to $Rx_3$ in Formula (Y1) and Formula (Y2) described above.
$R_{32}$ and $R_{33}$ may be bonded to each other to form a ring.
In a case where $R_{32}$ and $R_{33}$ in Formula (7) are bonded to each other to form a ring, it is preferable that $R_{32}$ and $R_{33}$ jointly form one divalent linking group. Examples of such a divalent linking group include the same group described as the divalent linking group represented by $L_2$ in Formula (3) described above, and an alkylene group is preferable.
As the repeating unit b having an acid-decomposable group, a repeating unit represented by Formula (A) is also preferable.

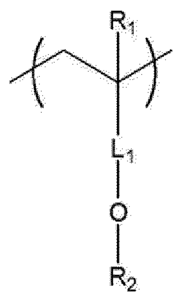

(A)

$L_1$ represents a divalent linking group. $R_1$ represents a hydrogen atom or an alkyl group. $R_2$ represents a leaving group which is eliminated by action of acid.
$L_1$ represents a divalent linking group.
Examples of the divalent linking group include -CO-, -O-, -S-, -SO-, $-SO_2-$, a hydrocarbon group (for example, an alkylene group, a cycloalkylene group, an alkenylene group, an arylene group, and the like), and a linking group in which a plurality of these groups are linked. Among these, as $L_1$, an alkylene group, -COO-, an arylene group, or a group formed by a combination thereof is preferable.
As the arylene group, a phenylene group is preferable.
The alkylene group may be linear or branched. The number of carbon atoms in the alkylene group is preferably 1 to 10 and more preferably 1 to 3.
The above-described divalent linking group may further have a substituent. As the substituent, a halogen atom is preferable, and a fluorine atom or an iodine atom is more preferable.
$R_1$ represents a hydrogen atom or an alkyl group.
The alkyl group may be linear or branched. The number of carbon atoms in the alkyl group is preferably 1 to 10 and more preferably 1 to 3.
The above-described alkyl group may further have a substituent. As the substituent, a halogen atom is preferable, and a fluorine atom or an iodine atom is more preferable.
$R_2$ represents a leaving group which is eliminated by action of acid.
The leaving group is preferably a group represented by Formulae (Y1) to (Y4) described above.
The resin A may have, as the repeating unit having an acid-decomposable group, a repeating unit which has an acid-decomposable group including an unsaturated bond.
As the repeating unit having an acid-decomposable group including an unsaturated bond, a repeating unit represented by Formula (B) is preferable.

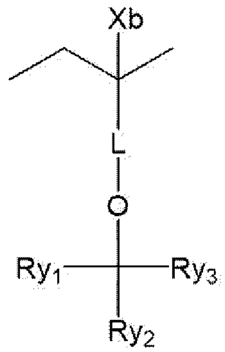

(B)

In Formula (B), Xb represents a hydrogen atom, a halogen atom, or an alkyl group which may have a substituent. L represents a single bond or a divalent linking group which may have a substituent. Ryi to $Ry_3$ each independently represent a linear or branched alkyl group, a monocyclic or polycyclic cycloalkyl group, an alkenyl group, an alkynyl group, or a monocyclic or polycyclic aryl group. However, at least one of $Ry_1$, $Ry_2$, or $Ry_3$ represents an alkenyl group, an alkynyl group, a monocyclic or polycyclic cycloalkenyl group, or a monocyclic or polycyclic aryl group.

Two of Ryi to $Ry_3$ may be bonded to each other to form a monocycle or a polycycle (monocyclic or polycyclic cycloalkyl group, cycloalkenyl group, or the like).

Examples of the alkyl group which may have a substituent, represented by Xb, include a methyl group and a group represented by $-CH_2-R_{11}$. $R_{11}$ represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom. Among these, an alkyl group having 3 or less carbon atoms is preferable, and a methyl group is more preferable. Xb is preferably a hydrogen atom, a fluorine atom, a methyl group, a trifluoromethyl group, or a hydroxymethyl group.

Examples of the divalent linking group of L include a -Rt- group, a -CO- group, a -COO-Rt- group, a -COO-Rt-CO- group, a -Rt-CO- group, and an -O-Rt- group. In the formulae, Rt represents an alkylene group, a cycloalkylene group, or an aromatic ring group, and an aromatic ring group is preferable.

L is preferably a -Rt- group, a -CO- group, a -COO-Rt-CO- group, or a -Rt-CO-group. Rt may have a substituent such as a halogen atom, a hydroxyl group, and an alkoxy group. An aromatic group is preferable.

As the alkyl group of Ryi to $Ry_3$, an alkyl group having 1 to 4 carbon atoms, such as a methyl group, an ethyl group, an n-propyl group, an isopropyl group, an n-butyl group, an isobutyl group, and a t-butyl group, is preferable.

As the cycloalkyl group of Ryi to $Ry_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of Ryi to $Ry_3$, an aryl group having 6 to 10 carbon atoms is preferable, and examples thereof include a phenyl group, a naphthyl group, and an anthryl group.

As the alkenyl group of Ryi to $Ry_3$, a vinyl group is preferable.

As the alkynyl group of Ryi to $Ry_3$, an ethynyl group is preferable.

As the cycloalkenyl group of Ryi to $Ry_3$, a structure in which a part of a monocyclic cycloalkyl group such as a cyclopentyl group and a cyclohexyl group includes a double bond is preferable.

As the cycloalkyl group formed by the bonding of two of Ryi to $Ry_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable. Among these, a monocyclic cycloalkyl group having 5 or 6 carbon atoms is more preferable.

In the cycloalkyl group or cycloalkenyl group formed by the bonding of two of Ryi to $Ry_3$, for example, one of methylene groups constituting the ring may be replaced with a heteroatom such as an oxygen atom, with a group including a heteroatom, such as a carbonyl group, a $-SO_2-$ group, and a $-SO_3-$ group, with a vinylidene group, or with a combination of these groups. In addition, in the cycloalkyl group or cycloalkenyl group, one or more of the ethylene groups constituting the cycloalkane ring or cycloalkene ring may be replaced with a vinylene group.

With regard to the repeating unit represented by Formula (B), for example, an aspect in which Ryi is a methyl group, an ethyl group, a vinyl group, an allyl group, or an aryl group and $Ry_2$ and $Rx_3$ are bonded to each other to form the above-described cycloalkyl group or cycloalkenyl group is preferable.

In a case where each of the above-described groups has a substituent, examples of the substituent include an alkyl group (having 1 to 4 carbon atoms), a halogen atom, a hydroxyl group, an alkoxy group (having 1 to 4 carbon atoms), a carboxy group, and an alkoxycarbonyl group (having 2 to 6 carbon atoms). The substituent preferably has 8

or less carbon atoms.

The repeating unit having an acid-decomposable group is exemplified below.

In the following formulae, $Xa_1$ represents any of H, $CH_3$, $CF_3$, or $CH_2OH$, Rxa and Rxb each independently represent a linear or branched alkyl group having 1 to 5 carbon atoms (a methyl group, an ethyl group, an n-propyl group, an isopropyl group, an n-butyl group, an isobutyl group, a t-butyl group, or the like).

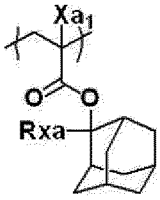 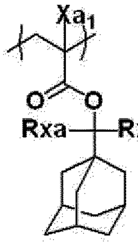 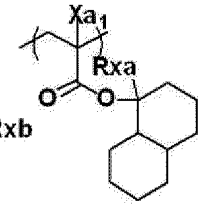 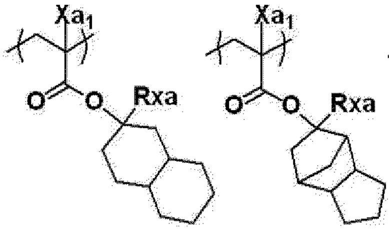 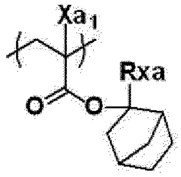

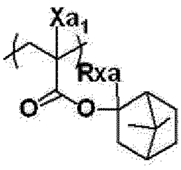 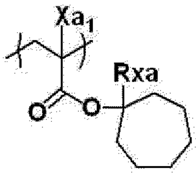 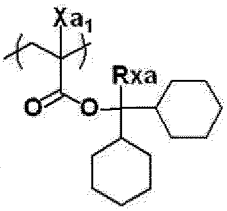 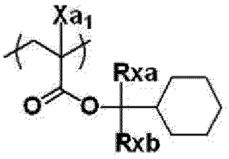 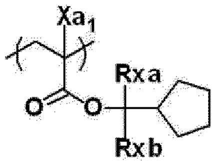

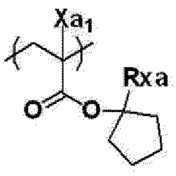 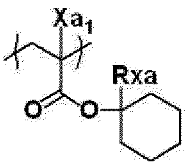 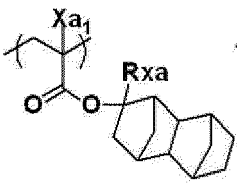 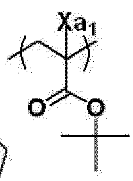 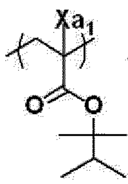 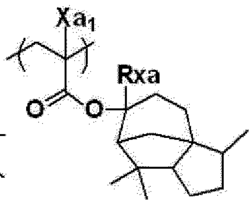

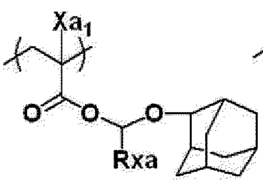 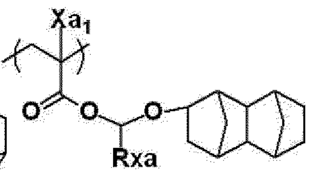 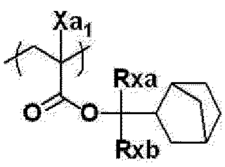 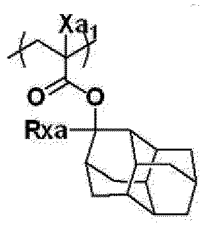

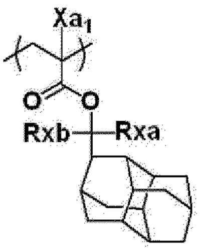 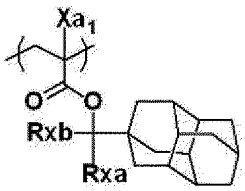 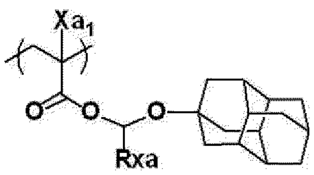 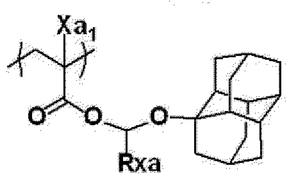

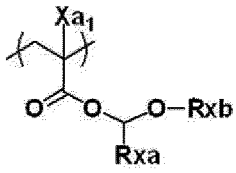
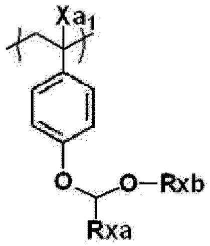
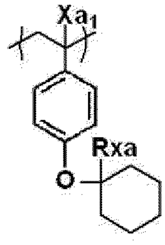
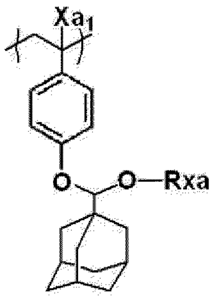

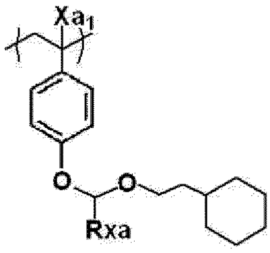
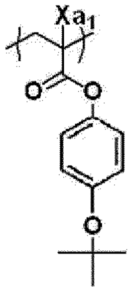

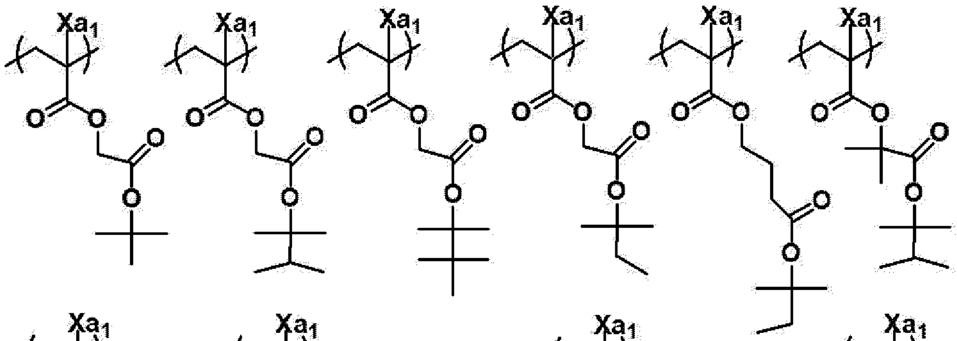

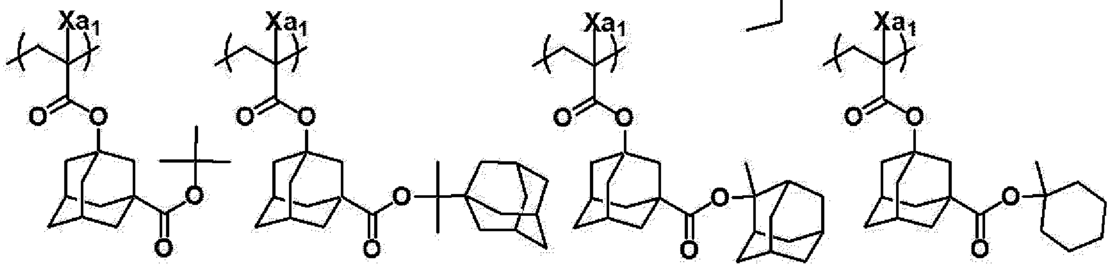

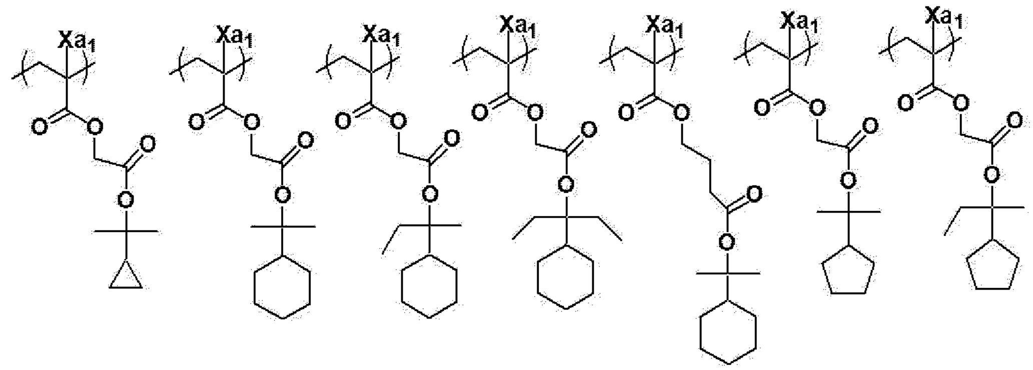

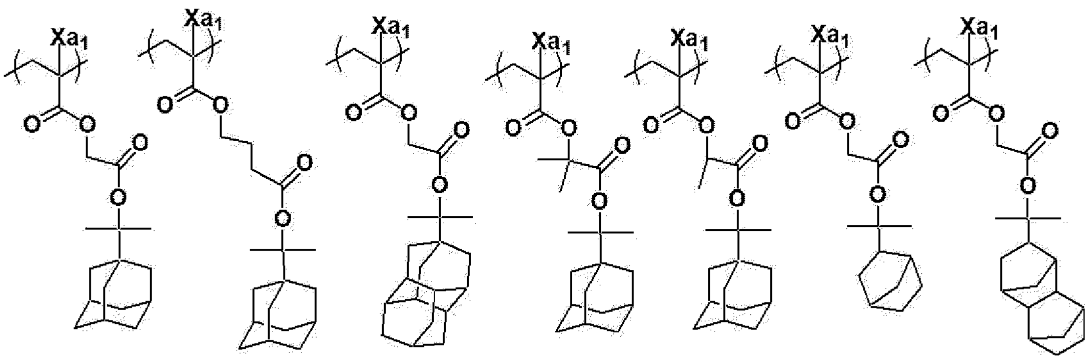

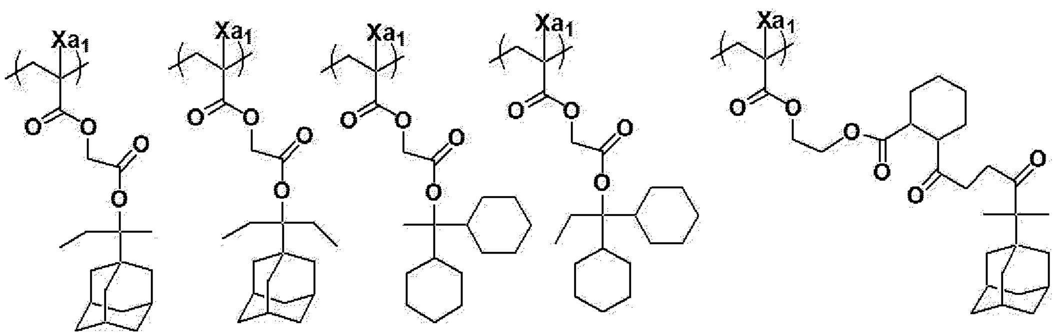

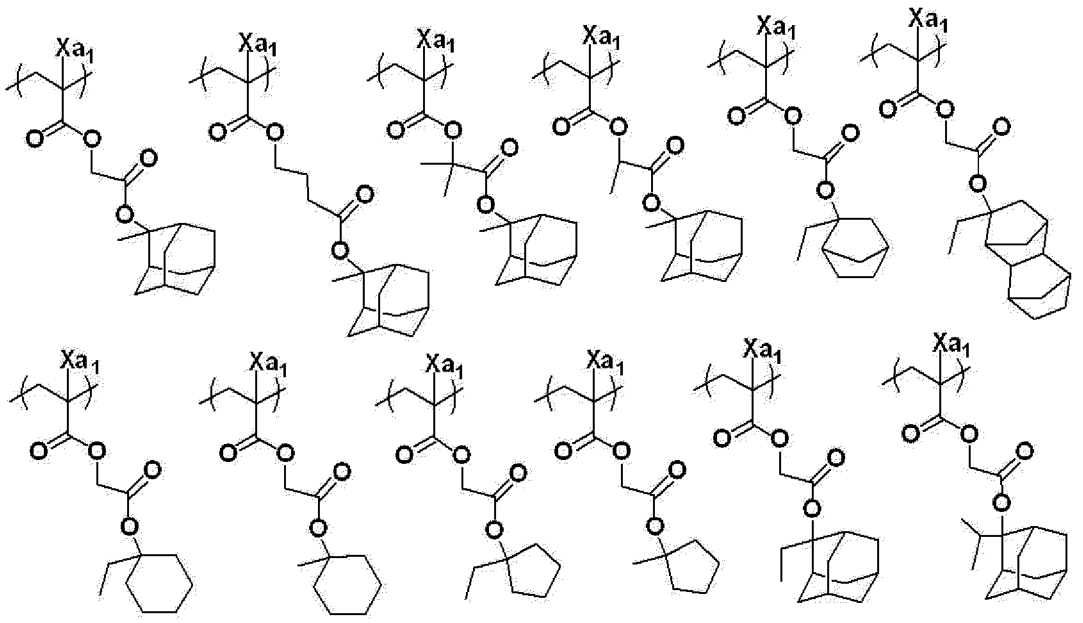

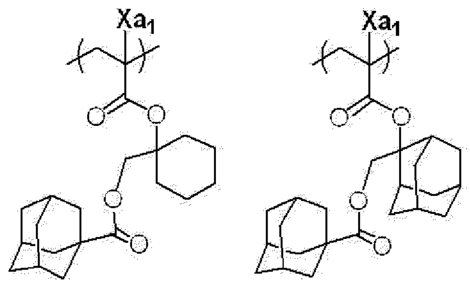

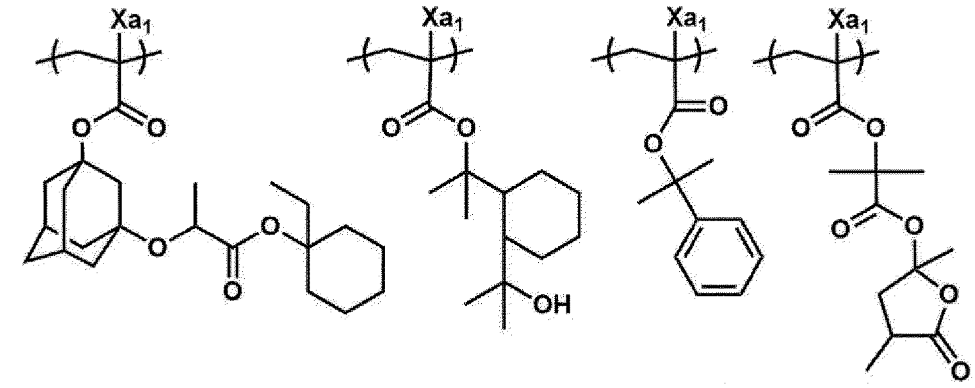

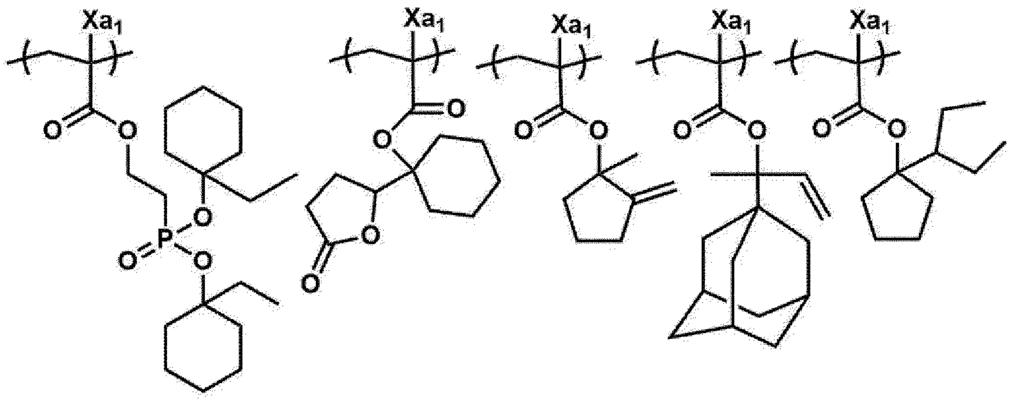

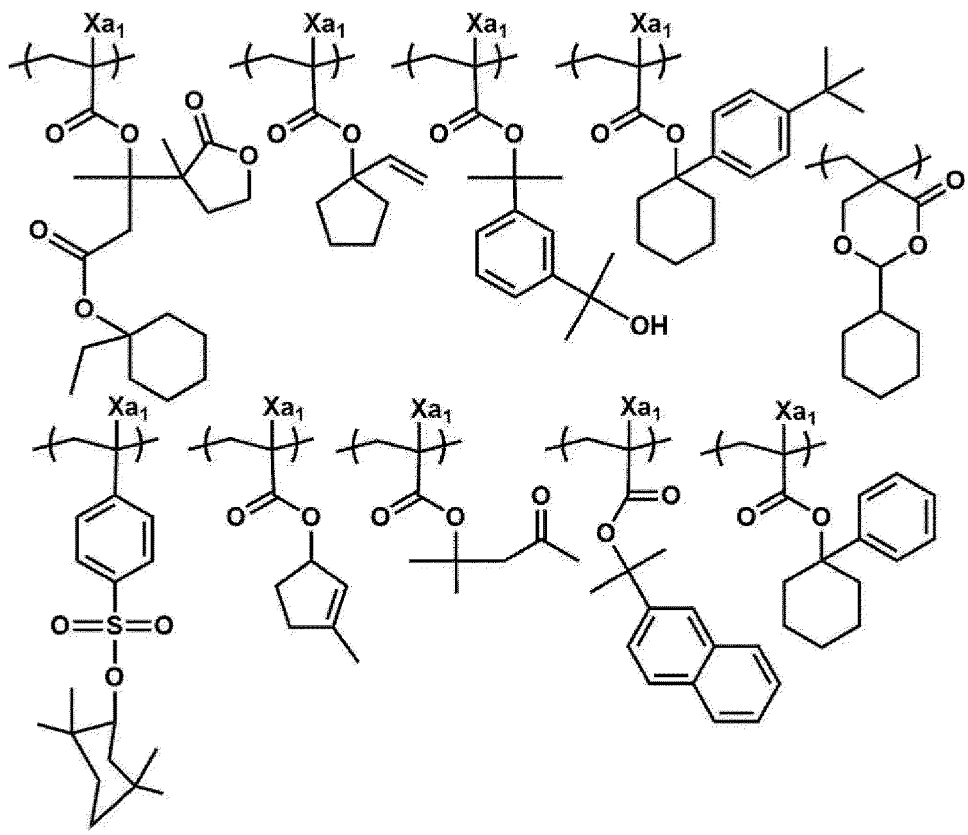

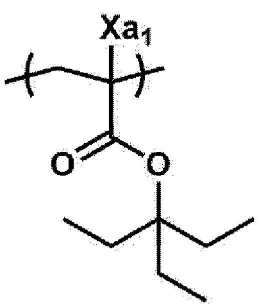
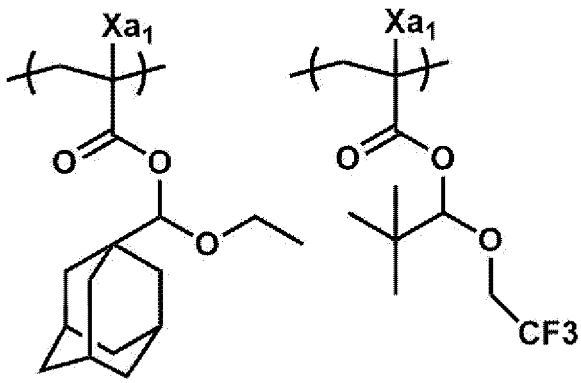

A content of the repeating unit having an acid-decomposable group is preferably 15% by mole or more, more preferably 20% by mole or more, still more preferably 30% by mole or more, and particularly preferably 40% by mole or more with respect to all the repeating units in the resin A. The upper limit thereof is preferably 90% by mole or less, more preferably 80% by mole or less, still more preferably 70% by mole or less, and particularly preferably 60% by mole or less with respect to all repeating units in the resin A.

The resin A may include at least one repeating unit selected from the group consisting of the following group A and/or at least one repeating unit selected from the group consisting of the following group B. Among these, it is preferable to include a repeating unit having an acid group. In addition, it is preferable that the repeating unit of the group A or the group B is different from the above-described repeating units.

Group A: group consisting of the following repeating units (20) to (28)

(20) repeating unit having an acid group, which will be described later
(21) repeating unit having neither an acid-decomposable group nor an acid group and having a fluorine atom, a bromine atom, or an iodine atom, which will be described later
(22) repeating unit having a lactone group, a sultone group, or a carbonate group, which will be described later
(23) repeating unit represented by Formula (V-1) or Formula (V-2), which will be described later
(24) repeating unit represented by Formula (A), which will be described later
(25) repeating unit represented by Formula (B), which will be described later
(26) repeating unit represented by Formula (C), which will be described later
(27) repeating unit represented by Formula (D), which will be described later
(28) repeating unit represented by Formula (E), which will be described later

Group B: group consisting of the following repeating units (29) to (31)

(30) repeating unit having at least one group selected from a lactone group, a sultone group, a carbonate group, a hydroxyl group, a cyano group, or an alkali-soluble group, which will be described later
(31) repeating unit having an alicyclic hydrocarbon structure and not exhibiting acid decomposability, which will be described later
(32) repeating unit represented by Formula (III) having neither a hydroxyl group nor a cyano group, which will be described later

The resin A preferably has an acid group, and preferably includes a repeating unit having an acid group. The definition of the acid group will be described later together with a suitable aspect of the repeating unit having an acid group. In a case where the resin A has an acid group, interaction the resin A and the acid generated from the photoacid generator is more excellent. As a result, diffusion of the acid is further suppressed, and a cross-sectional shape of the formed pattern can be more rectangular.

In a case where the resist composition is used as an actinic ray-sensitive or radiation-sensitive resin composition with EUV, it is preferable that the resin A has at least one repeating unit selected from the group consisting of the above-described group A.

In addition, in a case where the resist composition is used as an actinic ray-sensitive or radiation-sensitive resin composition with EUV, it is preferable that the resin A includes at least one of a fluorine atom or an iodine atom. In a case where the resin A includes both a fluorine atom and an iodine atom, the resin A may have one repeating unit including both a fluorine atom and an iodine atom, and the resin A may include two kinds of repeating units, that is, a

repeating unit having a fluorine atom and a repeating unit having an iodine atom.

In addition, in a case where the resist composition is used as an actinic ray-sensitive or radiation-sensitive resin composition with EUV, it is also preferable that the resin A has a repeating unit having an aromatic group.

In a case where the resist composition is used as an actinic ray-sensitive or radiation-sensitive resin composition with ArF, it is preferable that the resin A has at least one repeating unit selected from the group consisting of the above-described group B.

In a case where the resist composition is used as an actinic ray-sensitive or radiation-sensitive resin composition with ArF, it is preferable that the resin A does not include a fluorine atom and a silicon atom.

In addition, in a case where the resist composition is used as an actinic ray-sensitive or radiation-sensitive resin composition with ArF, it is preferable that the resin A does not have an aromatic group.

(Repeating Unit Having Acid Group)

The resin A may have a repeating unit having an acid group.

As the acid group, an acid group having a pKa of 13 or less is preferable. An acid dissociation constant (pKa) of the above-described acid group is preferably 13 or less, more preferably 3 to 13, and still more preferably 5 to 10.

In a case where the resin A has an acid group having a pKa of 13 or less, a content of the acid group in the resin A is usually 0.2 to 6.0 mmol/g. Among these, 0.8 to 6.0 mmol/g is preferable, 1.2 to 5.0 mmol/g is more preferable, and 1.6 to 4.0 mmol/g is still more preferable. In a case where the content of the acid group is within the above-described range, the development proceeds satisfactorily, the formed pattern shape is excellent, and the resolution is also excellent.

As the acid group, for example, a carboxy group, a phenolic hydroxyl group, a fluorinated alcohol group (preferably, a hexafluoroisopropanol group), a sulfonic acid group, a sulfonamide group, or an isopropanol group is preferable.

In addition, in the above-described hexafluoroisopropanol group, one or more (preferably one or two) fluorine atoms may be substituted with a group (an alkoxycarbonyl group and the like) other than a fluorine atom.

$-C(CF_3)(OH)-CF_2-$ formed as above is also preferable as the acid group. In addition, one or more fluorine atoms may be substituted with a group other than a fluorine atom to form a ring including $-C(CF_3)(OH)-CF_2-$.

The repeating unit having an acid group is preferably a repeating unit different from the repeating unit having the structure in which a polar group is protected by the leaving group which is eliminated by action of acid as described above, and the repeating unit having a lactone group, a sultone group, or a carbonate group, which will be described later.

The repeating unit having an acid group may have a fluorine atom or an iodine atom.

The repeating unit having an acid group is also preferably a repeating unit represented by Formula (A2), and the resin A preferably has the repeating unit represented by Formula (A2).

The repeating unit represented by Formula (A2) is a repeating unit having an aromatic hydroxyl group (phenolic hydroxyl group) as the acid group.

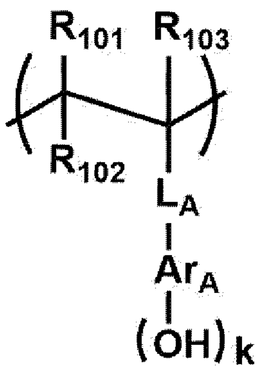

(A2)

In Formula (A2), $R_{101}$, $R_{102}$, and $R_{103}$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

In Formula (A2), $L_A$ represents a single bond or a divalent linking group.

Examples of the divalent linking group represented by $L_A$ in Formula (A2) include the same group described as the divalent linking group represented by $L_2$ in Formula (3) described above.

$Ar_A$ represents an aromatic ring group (benzene ring group or the like).

The above-described aromatic ring group may be monocyclic or polycyclic, and may or may not have one or more (for example, one to three) heteroatoms as ring member atoms. The number of ring member atoms in the above-described aromatic ring group is preferably 5 to 15.

$Ar_A$ is preferably a benzene ring group.

In Formula (A2), k represents an integer of 1 to 5.

However, $R_{102}$ may be bonded to $Ar_A$, and in this case, $R_{102}$ represents a single bond or an alkylene group (which may be linear or branched; the number of carbon atoms is, for example, 1 to 6).

In this case, the aromatic ring group represented by $Ar_A$ is bonded to a carbon atom constituting the main chain (carbon atom to which $R_{101}$ is bonded) through the above-described single bond or the above-described alkylene group.

Examples of the repeating unit having an acid group include the following repeating units.

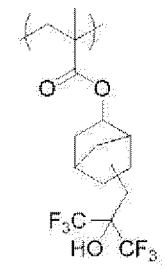
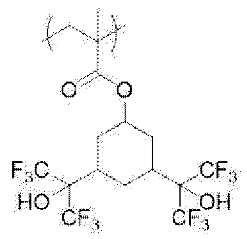
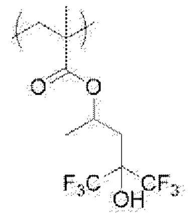
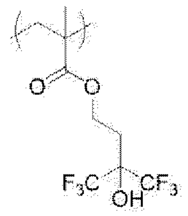

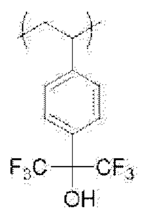
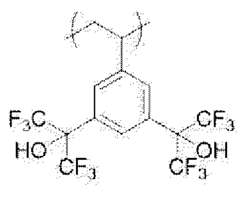
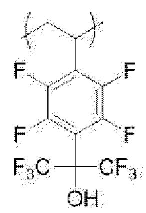
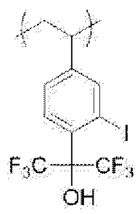

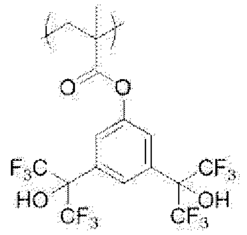
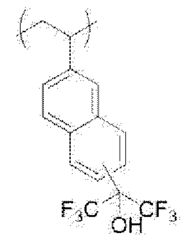

The repeating unit having an acid group is exemplified below. In the formulae, a represents 1 or 2.

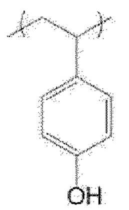
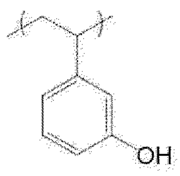
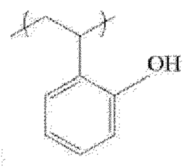

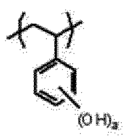
(B-1)

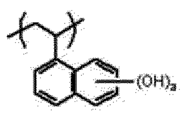
(B-2)

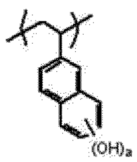
(B-3)

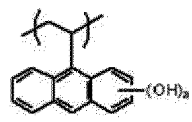
(B-4)

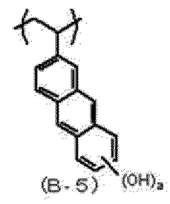
(B-5)

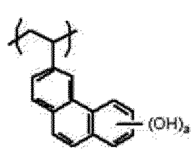
(B-6)

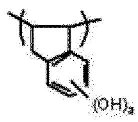
(B-7)

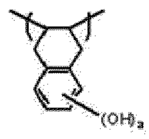
(B-8)

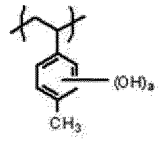
(B-9)

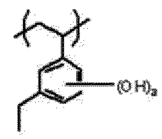
(B-10)

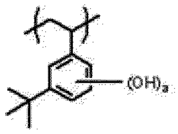
(B-11)

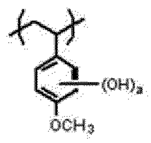
(B-12)

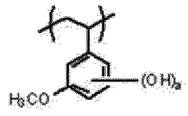
(B-13)

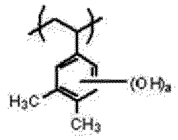
(B-14)

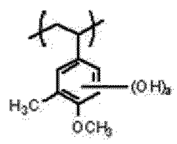
(B-15)

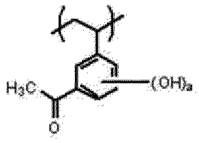
(B-16)

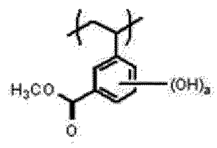
(B-17)

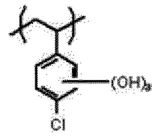
(B-18)

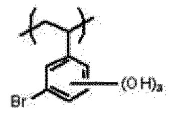
(B-19)

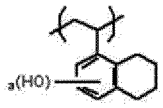
(B-20)

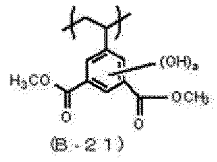
(B-21)

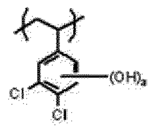
(B-22)

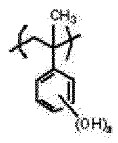
(B-23)

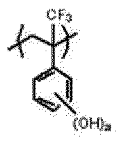
(B-24)

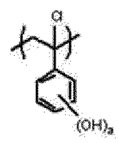
(B-25)

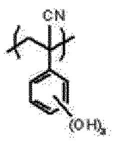
(B-26)

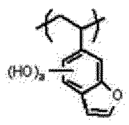
(B-27)

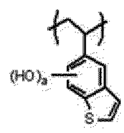
(B-28)

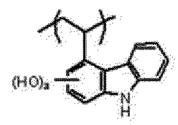
(B-29)

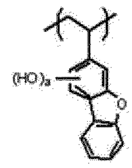
(B-30)

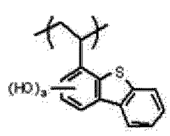
(B-31)

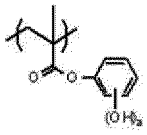
(B-32)

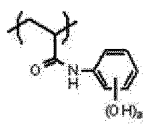
(B-33)

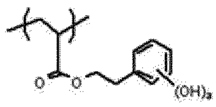
(B-34)

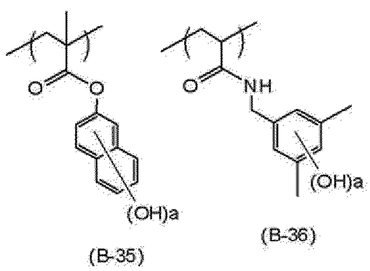
(B-35)

(B-36)

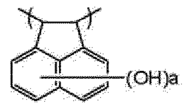
(B-37)

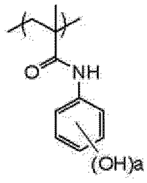
(B-38)

Among the above-described repeating units, repeating units specifically shown below are preferable. In the formulae, R represents a hydrogen atom or a methyl group, and a represents 2 or 3.

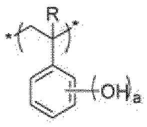 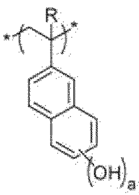 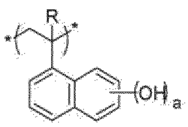 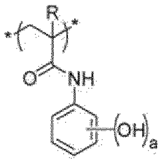

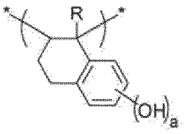 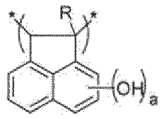 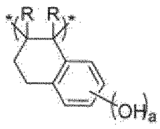 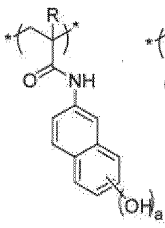 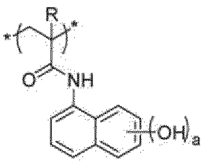

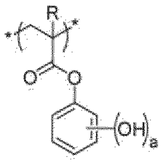 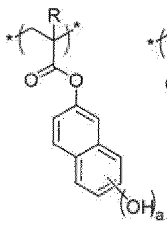 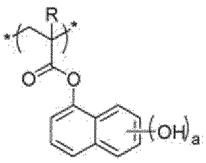 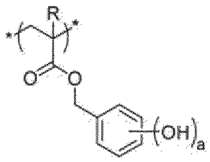 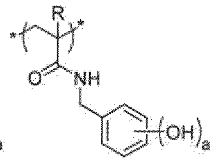

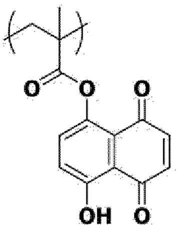 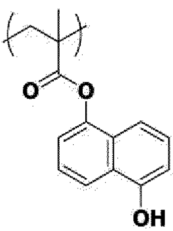 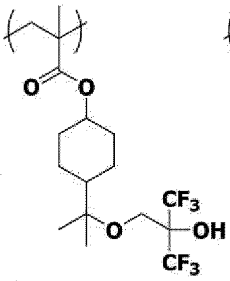 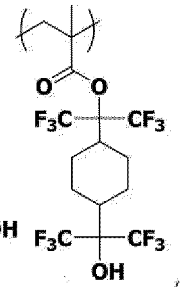 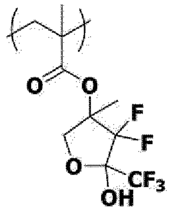 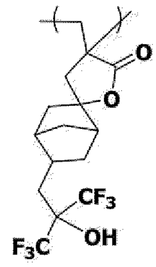

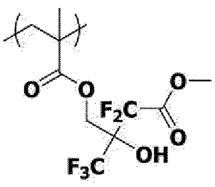 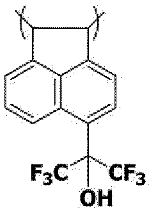 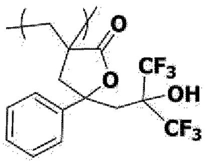 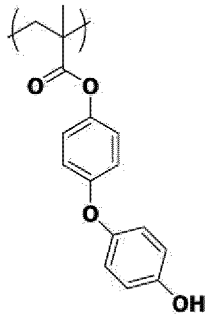 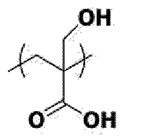 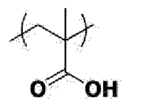

A content of the repeating unit having an acid group is preferably 10% by mole or more, more preferably 15% by mole or more, and still more preferably 20% by mole or more with respect to all repeating units in the resin A. The upper limit thereof is preferably 70% by mole or less, more preferably 65% by mole or less, and still more preferably 60% by mole or less with respect to all repeating units in the resin A.

(Repeating Unit Having Neither Acid-decomposable Group Nor Acid Group and Having Fluorine Atom, Bromine Atom, or Iodine Atom)

The resin A may have a repeating unit having neither an acid-decomposable group nor an acid group and having a fluorine atom, a bromine atom, or an iodine atom (hereinafter, also referred to as a unit X), in addition to the above-described <repeating unit having acid-decomposable group> and <repeating unit having acid group>. In addition, it is preferable that the <repeating unit having neither an acid-decomposable group nor an acid group and having a fluorine atom, a bromine atom, or an iodine atom> herein is different from other types of the repeating units belonging to the group A, such as <repeating unit having lactone group, sultone group, or carbonate group> and <repeating unit having photoacid generating group> described later.

As the unit X, a repeating unit represented by Formula (C) is preferable.

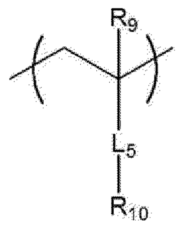

(C)

$L_5$ represents a single bond or an ester group. $R_9$ represents a hydrogen atom or an alkyl group which may have a fluorine atom or an iodine atom. $R_{10}$ represents a hydrogen atom, an alkyl group which may have a fluorine atom or an iodine atom, a cycloalkyl group which may have a fluorine atom or an iodine atom, an aryl group which may have a fluorine atom or an iodine atom, or a group formed by a combination thereof.

The repeating unit having a fluorine atom, a bromine atom, or an iodine atom is exemplified below.

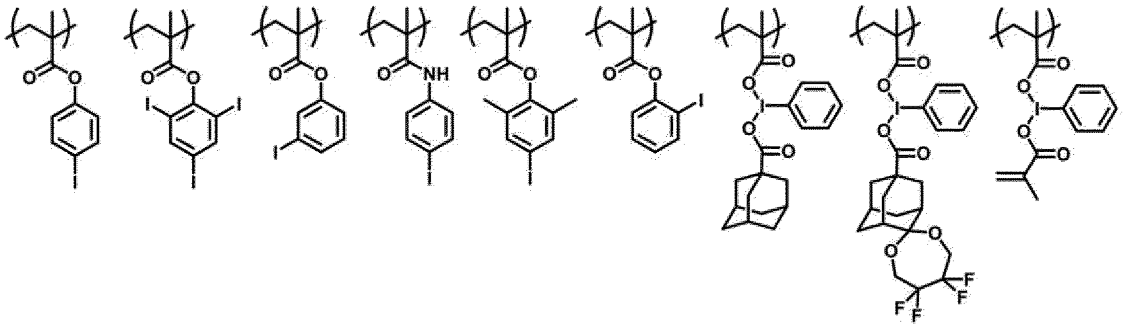

A content of the unit X a is preferably 0% by mole or more, more preferably 5% by mole or more, and still more preferably 10% by mole or more with respect to all repeating units in the resin A. The upper limit thereof is preferably 50% by mole or less, more preferably 45% by mole or less, and still more preferably 40% by mole or less with respect to all repeating units in the resin A.

The total content of the repeating unit including at least any one of a fluorine atom, a bromine atom, or an iodine atom in the repeating units of the resin A is preferably 10% by mole or more, more preferably 20% by mole or more, still more preferably 30% by mole or more, and particularly preferably 40% by mole or more with respect to all repeating units of the resin A. The upper limit thereof is, for example, 100% by mole or less with repeating unit to all repeating units in the resin A.

Examples of the repeating unit including at least any one of a fluorine atom, a bromine atom, or an iodine atom include a repeating unit having a fluorine atom, a bromine atom, or an iodine atom and having an acid-decomposable group, a repeating unit having a fluorine atom, a bromine atom, or an iodine atom and having an acid group, and a repeating unit having a fluorine atom, a bromine atom, or an iodine atom.

(Repeating Unit Having Lactone Group, Sultone Group, or Carbonate Group)

The resin A may have a repeating unit having at least one selected from the group consisting of a lactone group, a sultone group, and a carbonate group (hereinafter, also referred to as "unit Y").

It is also preferable that the unit Y has no hydroxyl group and acid group such as a hexafluoropropanol group.

The lactone group or the sultone group may have a lactone structure or a sultone structure. The lactone structure or the sultone structure is preferably a 5- to 7-membered ring lactone structure or a 5- to 7-membered ring sultone structure. Among these, the structure is more preferably a 5- to 7-membered ring lactone structure with which another ring structure is fused so as to form a bicyclo structure or a spiro structure or a 5- to 7-membered ring sultone structure with which another ring structure is fused so as to form a bicyclo structure or a spiro structure.

The resin A preferably has a repeating unit having a lactone group or a sultone group, formed by extracting one or more hydrogen atoms from a ring member atom of a lactone structure represented by any of Formulae (LC1-1) to (LC1-21) or a sultone structure represented by any of Formulae (SL1-1) to (SL1-3).

In addition, the lactone group or the sultone group may be bonded directly to the main chain. For example, a ring member atom of the lactone group or the sultone group may constitute the main chain of the resin A.

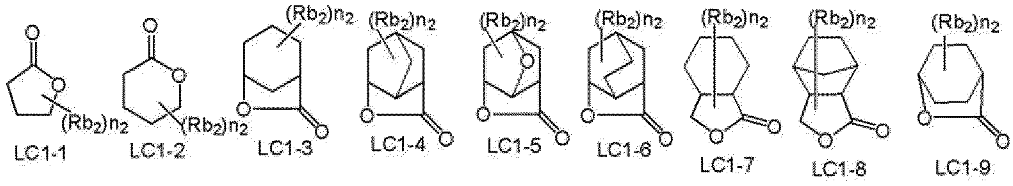

LC1-1 LC1-2 LC1-3 LC1-4 LC1-5 LC1-6 LC1-7 LC1-8 LC1-9

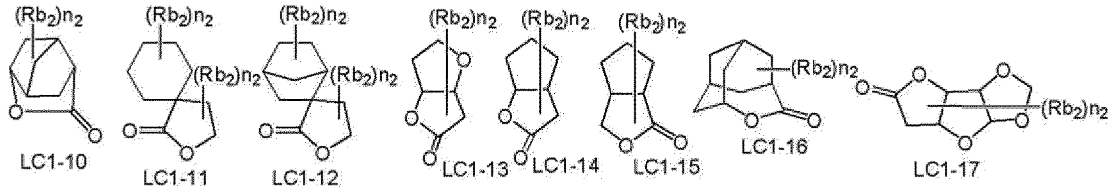

LC1-10 LC1-11 LC1-12 LC1-13 LC1-14 LC1-15 LC1-16 LC1-17

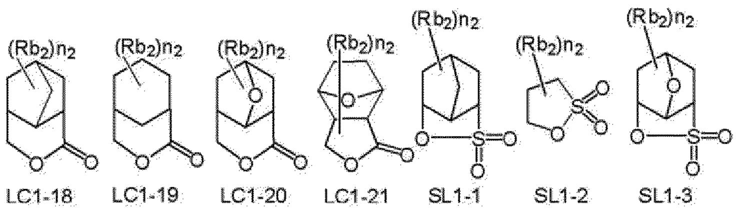

LC1-18 LC1-19 LC1-20 LC1-21 SL1-1 SL1-2 SL1-3

The above-described lactone structure or sultone structure may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxy group, a halogen atom, a cyano group, and an acid-decomposable group. n2 represents an integer of 0 to 4. In a case where n2 is 2 or more, a plurality of $Rb_2$'s may be different from each other, and the plurality of $Rb_2$'s may be bonded to each other to form a ring.

Examples of the repeating unit having a group including the lactone structure represented by any of Formulae (LC1-1) to (LC1-21) or the sultone structure represented by any of Formulae (SL1-1) to (SL1-3) include a repeating unit represented by Formula (AI).

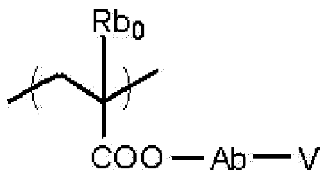

(AI)

In Formula (AI), $Rb_0$ represents a hydrogen atom, a halogen atom, or an alkyl group having 1 to 4 carbon atoms. Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxy group, or a divalent group formed by a combination thereof. Among these, as Ab, a single bond or a linking group represented by $-Ab_1-CO_2-$ is preferable. $Ab_1$ is a linear or branched alkylene group, or a monocyclic or polycyclic cycloalkylene group, and is preferably a methylene group, an ethylene group, a cyclohexylene group, an adamantylene group, or a norbornylene group.

V represents a group formed by extracting one hydrogen atom from a ring member atom of the lactone structure represented by any of Formulae (LC1-1) to (LC1-21) or a group formed by extracting one hydrogen atom from a ring member atom of the sultone structure represented by any of Formulae (SL1-1) to (SL1-3).

In a case where an optical isomer is present in the repeating unit having a lactone group or a sultone group, any of optical isomers may be used. In addition, one optical isomer may be used alone or a mixture of a plurality of the optical isomers may be used. In a case where one kind of optical isomers is mainly used, an optical purity (ee) thereof is preferably 90 or more, and more preferably 95 or more.

As the carbonate group, a cyclic carbonate ester group is preferable.

As the repeating unit having a cyclic carbonate ester group, a repeating unit represented by Formula (A-1) is preferable.

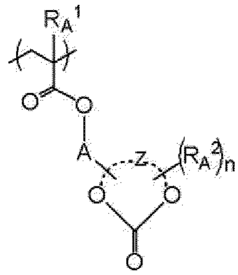

(A-1)

In Formula (A-1), $R_A{}^1$ represents a hydrogen atom, a halogen atom, or a monovalent organic group (preferably a methyl group). n represents an integer of 0 or more. $R_A{}^2$ represents a substituent. In a case where n is 2 or more, a plurality of $R_A{}^2$'s may be the same or different from each other. A represents a single bond or a divalent linking group. As the above-described divalent linking group, an alkylene group, a divalent linking group having a monocyclic or polycyclic alicyclic hydrocarbon structure, an ether group, an ester group, a carbonyl group, a carboxy group, or a divalent group formed by a combination thereof is preferable. Z represents an atomic group which forms a monocycle or polycycle with a group represented by -O-CO-O- in the formula.

The unit Y is exemplified below.

(in the formulae, Rx is H, $CH_3$, $CH_2OH$, or $CF_3$)

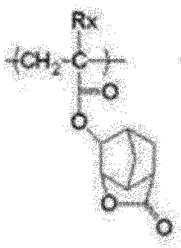 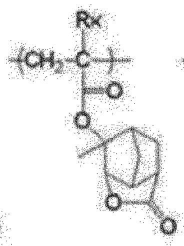 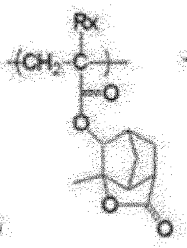 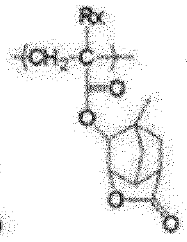 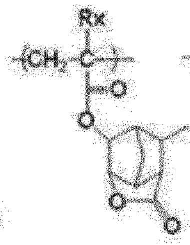 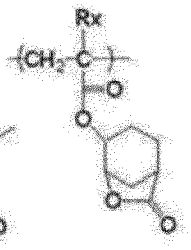

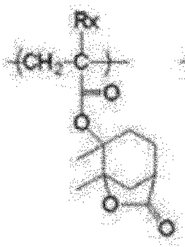 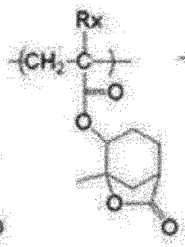 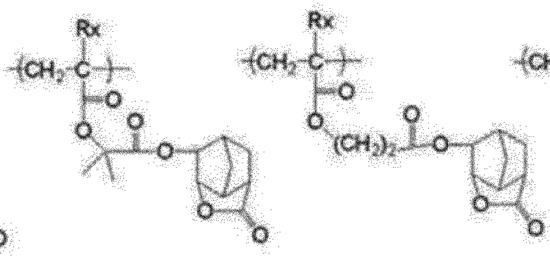 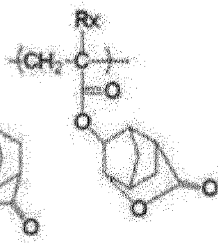

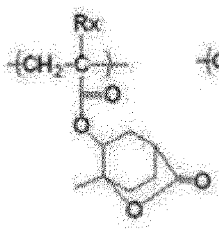 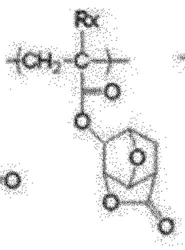 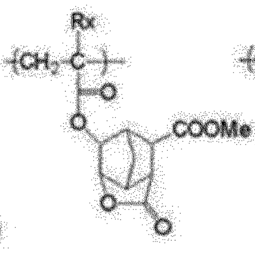 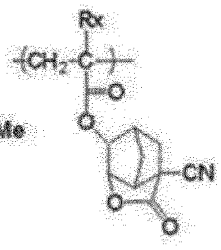 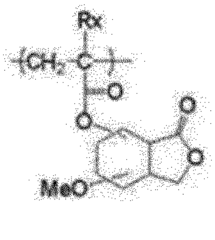

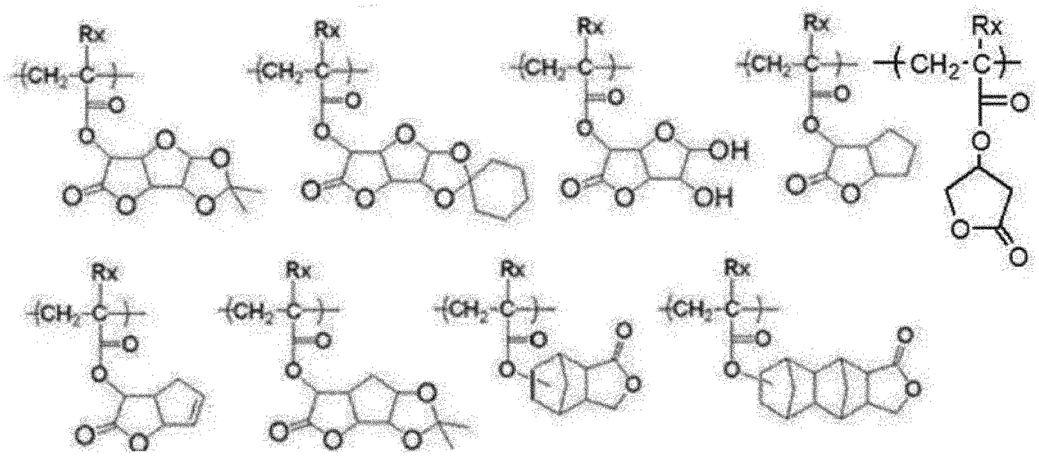

(in the formulae, Rx is H, $CH_3$, $CH_2OH$, or $CF_3$)

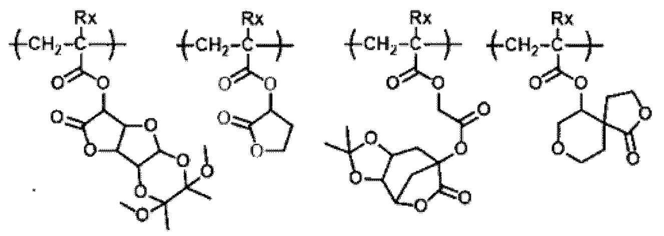

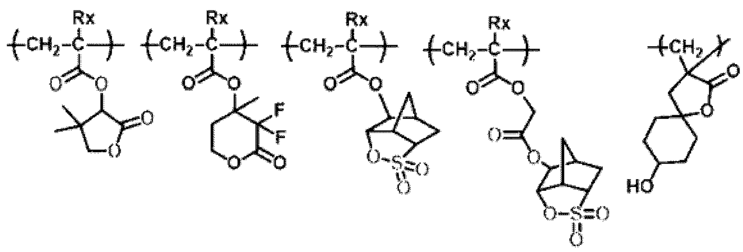

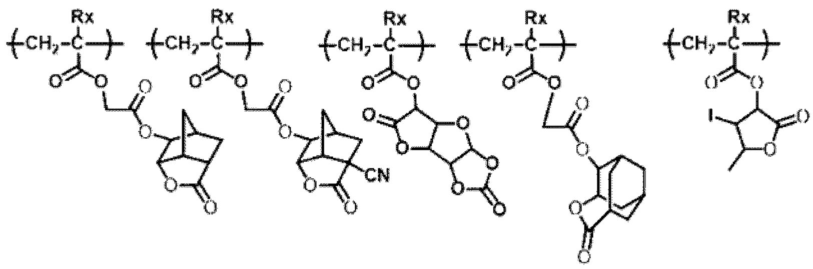

(in the formulae, Rx is H, $CH_3$, $CH_2OH$, or $CF_3$)

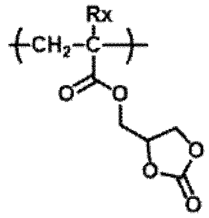
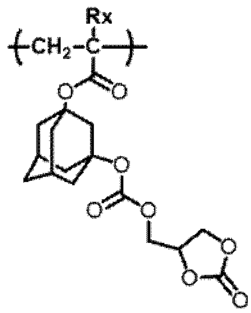

A content of the unit Y is preferably 1% by mole or more, and more preferably 10% by mole or more with respect to all repeating units in the resin A. In addition, the upper limit thereof is preferably 85% by mole or less, more preferably 80% by mole or less, still more preferably 70% by mole or less, and particularly preferably 60% by mole or less with respect to all repeating units in the resin A.

(Repeating Unit represented by Formula (V-1) or Formula (V-2))

The resin A may have a repeating unit represented by Formula (V-1) or a repeating unit represented by Formula (V-2).
The repeating unit represented by Formula (V-1) and the repeating unit represented by Formula (V-2) are preferably a repeating unit different from the above-described repeating units.

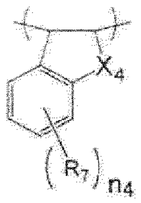
(V-1)

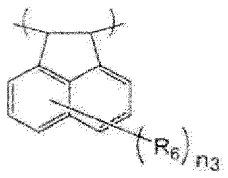
(V-2)

In Formulae (V-1) and (V-2),

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR; R is an alkyl group or fluorinated alkyl group having 1 to 6 carbon atoms), or a carboxy group. As the alkyl group, a linear, branched, or cyclic alkyl group having 1 to 10 carbon atoms is preferable.

$n_3$ represents an integer of 0 to 6.
$n_4$ represents an integer of 0 to 4.
$X^4$ is a methylene group, an oxygen atom, or a sulfur atom.

The repeating unit represented by Formula (V-1) or the repeating unit represented by (V-2) is exemplified below.
Examples of the repeating unit represented by Formula (V-1) and the repeating unit represented by (V-2) include repeating units described in paragraph [0100] of WO2018/193954A.

(Repeating Unit for Reducing Mobility of Main Chain)

From the viewpoint that excessive diffusion of a generated acid or pattern collapse during development can be suppressed, the resin A preferably has a high glass transition temperature (Tg). The Tg is preferably higher than 90°C, more preferably higher than 100°C, still more preferably higher than 110°C, and particularly preferably higher than 125°C. From the viewpoint that a dissolution rate in the developer is excellent, the Tg is preferably 400°C or lower and more preferably 350°C or lower.
In the present specification, the glass transition temperature (Tg) of a polymer such as the resin A (hereinafter, also referred to as "Tg of the repeating unit") is calculated by the following method. First, each Tg of homopolymers

consisting of only the respective repeating units included in the polymer is calculated by the Bicerano method. Next, the mass proportion (%) of each repeating unit to all repeating units in the polymer is calculated. Next, the Tg at each mass proportion is calculated using a Fox's equation (described in Materials Letters 62 (2008) 3152, and the like), and these are summed to obtain the Tg (°C) of the polymer.

The Bicerano method is described in Prediction of polymer properties, Marcel Dekker Inc., New York (1993). In addition, the calculation of a Tg by the Bicerano method can be carried out using MDL Polymer (MDL Information Systems, Inc.), which is software for estimating physical properties of a polymer.

In order to raise the Tg of the resin A (preferably to raise the Tg to higher than 90°C), it is preferable to reduce the mobility of the main chain of the resin A. Examples of a method for lowering the mobility of the main chain of the resin A include the following (a) to (e) methods.

(a) introduction of a bulky substituent into the main chain
(b) introduction of a plurality of substituents into the main chain
(c) introduction of a substituent causing an interaction between the resins A into the vicinity of the main chain
(d) formation of the main chain in a cyclic structure
(e) linking of a cyclic structure to the main chain

The resin A preferably has a repeating unit in which the homopolymer exhibits a Tg of 130°C or higher.

The type of the repeating unit in which the homopolymer exhibits a Tg of 130°C or higher may be any of repeating units in which the homopolymer exhibits a Tg of 130°C or higher, as calculated by a Bicerano method. It corresponds to a repeating unit having a Tg of a homopolymer exhibiting 130°C or higher, depending on the type of a functional group in the repeating units represented by Formulae (A) to (E), which will be described later.

As an example of a specific unit for accomplishing (a) above, a method of introducing a repeating unit represented by Formula (A) into the resin A may be mentioned.

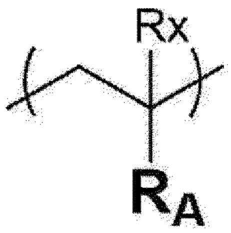

(A)

In Formula (A), $R_A$ represents a group including a polycyclic structure. $R_x$ represents a hydrogen atom, a methyl group, or an ethyl group. The group including a polycyclic structure is a group including a plurality of ring structures, and the plurality of ring structures may or may not be fused.

Examples of the repeating unit represented by Formula (A) include repeating units described in paragraphs [0107] to [0119] of WO2018/193954A.

As an example of a specific unit for accomplishing (b) above, a method of introducing a repeating unit represented by Formula (B) into the resin A may be mentioned.

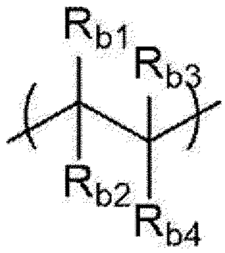

(B)

In Formula (B), $R_{b1}$ to $R_{b4}$ each independently represent a hydrogen atom or an organic group, and at least two or more of $R_{b1}$, ..., or $R_{b4}$ represent an organic group.

In addition, in a case where at least one of the organic groups is a group in which a ring structure is directly linked to the main chain in the repeating unit, the types of the other organic groups are not particularly limited.

In addition, in a case where none of the organic groups is a group in which a ring structure is directly linked to the main chain in the repeating unit, at least two or more of the organic groups are substituents having three or more

constituent atoms excluding hydrogen atoms.

Examples of the repeating unit represented by Formula (B) include repeating units described in paragraphs [0113] to [0115] of WO2018/193954A.

As an example of a specific unit for accomplishing (c) above, a method of introducing a repeating unit represented by Formula (C) into the resin A may be mentioned.

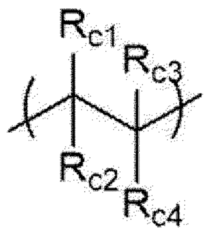

(C)

In Formula (C), $R_{c1}$ to $R_{c4}$ each independently represent a hydrogen atom or an organic group, and at least one of $R_{c1}$, ..., or $R_{c4}$ is a group including a hydrogen-bonding hydrogen atom with the number of atoms of 3 or less from the main chain carbon. Among these, it is preferable that the group has hydrogen-bonding hydrogen atoms with the number of atoms of 2 or less (on a side closer to the vicinity of the main chain) to cause an interaction between the main chains of the resin A.

Examples of the repeating unit represented by Formula (C) include repeating units described in paragraphs [0119] to [0121] of WO2018/193954A.

As an example of a specific unit for accomplishing (d) above, a method of introducing a repeating unit represented by Formula (D) into the resin A may be mentioned.

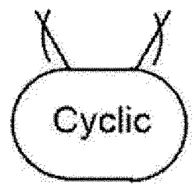

(D)

In Formula (D), "cylic" is a group which forms a main chain as a cyclic structure. The number of ring-constituting atoms is not particularly limited.

Examples of the repeating unit represented by Formula (D) include repeating units described in paragraphs [0126] to [0127] of WO2018/193954A.

As an example of a specific unit for accomplishing (e) above, a method of introducing a repeating unit represented by Formula (E) into the resin A may be mentioned.

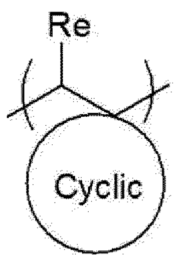

(E)

In Formula (E), Re's each independently represent a hydrogen atom or an organic group. Examples of the organic group include an alkyl group, a cycloalkyl group, an aryl group, an aralkyl group, and an alkenyl group, which may have a substituent.

"cylic" is a cyclic group including a carbon atom of a main chain. The number of atoms included in the cyclic group is not particularly limited.

Examples of the repeating unit represented by Formula (E) include repeating units described in paragraphs [0131] to [0133] of WO2018/193954A.

(Repeating Unit Having At Least One Group selected from Lactone Group, Sultone Group, Carbonate Group, Hydroxyl Group, Cyano Group, or Alkali-soluble Group)

The resin A may have a repeating unit having at least one group selected from a lactone group, a sultone group, a carbonate group, a hydroxyl group, a cyano group, or an alkali-soluble group.
Examples of the repeating unit having a lactone group, a sultone group, or a carbonate group included in the resin A include the repeating units described in <repeating unit having lactone group, sultone group, or carbonate group> described above. A preferred content thereof is also the same as described in <repeating unit having lactone Group, sultone Group, or carbonate group> mentioned above.
The resin A may have a repeating unit having a hydroxyl group or a cyano group. As a result, adhesiveness to the substrate and affinity for a developer are improved.
The repeating unit having a hydroxyl group or a cyano group is preferably a repeating unit having an alicyclic hydrocarbon structure substituted with a hydroxyl group or a cyano group.
It is preferable that the repeating unit having a hydroxyl group or a cyano group does not have the acid-decomposable group.
Examples of the repeating unit having a hydroxyl group or a cyano group include repeating units described in paragraphs [0081] to [0084] of JP2014-098921A.
The resin A may have a repeating unit having an alkali-soluble group.
Examples of the alkali-soluble group include a carboxy group, a sulfonamide group, a sulfonylimide group, a bissulfonylimide group, and an aliphatic alcohol (for example, a hexafluoroisopropanol group) in which the $\alpha$-position is substituted with an electron withdrawing group, and a carboxy group is preferable. In a case where the resin A includes the repeating unit having an alkali-soluble group, resolution for use in contact holes is increased. Examples of the repeating unit having an alkali-soluble group include repeating units described in paragraphs [0085] and [0086] of JP2014-098921A.

(Repeating Unit Having Alicyclic Hydrocarbon Structure and Not Exhibiting Acid Decomposability)

The resin A may have a repeating unit having an alicyclic hydrocarbon structure and not exhibiting acid decomposability. As a result, it is possible to reduce elution of low-molecular-weight components from the resist film into the immersion liquid during liquid immersion exposure. Examples of such a repeating unit include a repeating unit derived from 1-adamantyl (meth)acrylate, diamantyl (meth)acrylate, tricyclodecanyl (meth)acrylate, or cyclohexyl (meth)acrylate.

(Repeating Unit Represented by Formula (III) Having Neither Hydroxyl Group Nor Cyano Group)

The resin A may have a repeating unit represented by Formula (III), which has neither a hydroxyl group nor a cyano group.

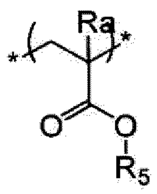

(III)

In Formula (III), $R_5$ represents a hydrocarbon group having at least one cyclic structure and having neither a hydroxyl group nor a cyano group.
Ra represents a hydrogen atom, an alkyl group, or a $-CH_2-O-Ra_2$ group. In the formula, $Ra_2$ represents a hydrogen atom, an alkyl group, or an acyl group.
Examples of the repeating unit represented by Formula (III), which has neither a hydroxyl group nor a cyano group, include repeating units described in paragraphs [0087] to [0094] of JP2014-098921A.

(Other Repeating Units)

Furthermore, the resin A may have a repeating unit other than the above-described repeating units.
For example, the resin A may have a repeating unit selected from the group consisting of a repeating unit having an oxathiane ring group, a repeating unit having an oxazolone ring group, a repeating unit having a dioxane ring group, and a repeating unit having a hydantoin ring group.

Such repeating units are exemplified below.

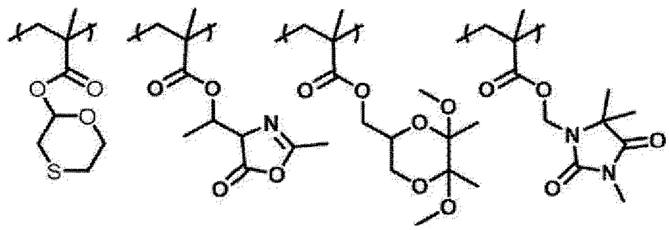

For the purpose of controlling dry etching resistance, suitability for a standard developer, substrate adhesiveness, resist profile, resolution, heat resistance, sensitivity, and the like, the resin A may have various repeating structural units in addition to the repeating structural units described above.

As the resin A, (in particular, in a case where the composition is used as an actinic ray-sensitive or radiation-sensitive resin composition with ArF), it is preferable that all repeating units are composed of repeating units derived from a compound having an ethylenically unsaturated bond. In particular, it is also preferable that all repeating units are composed of (meth)acrylate-based repeating units. In this case, any resin of a resin in which all repeating units are methacrylate-based repeating units, a resin in which all repeating units are acrylate-based repeating units, or a resin with all repeating units consisting of a methacrylate-based repeating unit and an acrylate-based repeating unit can be used. In addition, the acrylate-based repeating unit is preferably 50% by mole or less of all repeating units.

The resin A can be synthesized in accordance with an ordinary method (for example, a radical polymerization).

A weight-average molecular weight of the resin A as a value expressed in terms of polystyrene by a GPC method is preferably 30,000 or less, more preferably 1,000 to 30,000, still more preferably 3,000 to 30,000, and particularly preferably 5,000 to 15,000.

A dispersity (molecular weight distribution) of the resin A is preferably 1 to 5, more preferably 1 to 3, still more preferably 1.2 to 3.0, and particularly preferably 1.2 to 2.0. As the dispersity is smaller, resolution and resist shape are more excellent, and a side wall of a resist pattern is smoother and roughness is also more excellent.

The resin A may be used alone or in combination of two or more kinds thereof.

A content of the resin A is preferably 40.0% to 99.9% by mass, and more preferably 60.0% to 98.0% by mass with respect to the total solid content of the resist composition.

<Other Photoacid Generator (B)>

The resist composition may contain other photoacid generator (B).

The other photoacid generator (B) is a component other than the above-described resin A and the specific acid diffusion control agent described later, and is a compound which generates an acid by irradiation with actinic ray or radiation.

The other photoacid generator (B) may have a fluorine atom.

A molecular weight of the other photoacid generator (B) is preferably 3,000 or less, more preferably 2,000 or less, and still more preferably 1,000 or less. The lower limit thereof is preferably 100 or more.

Examples of the other photoacid generator (B) include a compound represented by "$M^+ X^-$" (onium salt), and a compound which generates an organic acid by exposure is preferable.

Examples of the above-described organic acid include sulfonic acids (an aliphatic sulfonic acid, an aromatic sulfonic acid, a camphor sulfonic acid, and the like), carboxylic acids (an aliphatic carboxylic acid, an aromatic carboxylic acid, an aralkylcarboxylic acid, and the like), a carbonylsulfonylimide acid, a bis(alkylsulfonyl)imide acid, and a tris(alkylsulfonyl)methide acid.

$M^+$ represents an organic cation.

As the above-described organic cation, a cation represented by Formula (ZaI) (hereinafter, also referred to as "cation (ZaI)") or a cation represented by Formula (ZaII) (hereinafter, also referred to as "cation (ZaII)") is preferable.

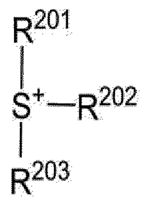

(ZaI)

$$R^{204}—I^{+}—R^{205} \quad (ZaII)$$

In Formula (ZaI),
$R^{201}$, $R^{202}$, and $R^{203}$ each independently represent an organic group.

The number of carbon atoms in the organic group of $R^{201}$, $R^{202}$, and $R^{203}$ is preferably 1 to 30 and more preferably 1 to 20. In addition, two of $R^{201}$ to $R^{203}$ may be bonded to each other to form a ring structure, and the ring structure may include an oxygen atom, a sulfur atom, an ester group, an amide group, or a carbonyl group in the ring. Examples of the group formed by the bonding of two of $R^{201}$ to $R^{203}$ include an alkylene group (for example, a butylene group and a pentylene group) and $-CH_2-CH_2-O-CH_2-CH_2-$.

Examples of suitable aspects of the organic cation in Formula (ZaI) include a cation (ZaI-1), a cation (ZaI-2), an organic cation (cation (ZaI-3b)) represented by Formula (ZaI-3b), and an organic cation (cation (ZaI-4b)) represented by Formula (ZaI-4b), each of which will be described later.

First, the cation (ZaI-1) will be described.

The cation (ZaI-1) is an arylsulfonium cation in which at least one of $R^{201}$, $R^{202}$, or $R^{203}$ of Formula (ZaI) described above is an aryl group.

In the arylsulfonium cation, all of $R_{201}$ to $R_{203}$ may be aryl groups, or some of $R_{201}$ to $R_{203}$ may be an aryl group and the rest may be an alkyl group or a cycloalkyl group.

In addition, one of $R_{201}$ to $R_{203}$ may be an aryl group, the remaining two of $R^{201}$ to $R^{203}$ may be bonded to each other to form a ring structure, and an oxygen atom, a sulfur atom, an ester group, an amide group, or a carbonyl group may be included in the ring. Examples of the group formed by the bonding of two of $R^{201}$ to $R^{203}$ include an alkylene group (for example, a butylene group, a pentylene group, and $-CH_2-CH_2-O-CH_2-CH_2-$) in which one or more methylene groups may be substituted with an oxygen atom, a sulfur atom, an ester group, an amide group, and/or a carbonyl group.

Examples of the arylsulfonium cation include a triarylsulfonium cation, a diarylalkylsulfonium cation, an aryldialkylsulfonium cation, a diarylcycloalkylsulfonium cation, and an aryldicycloalkylsulfonium cation.

The aryl group included in the arylsulfonium cation is preferably a phenyl group or a naphthyl group, and more preferably a phenyl group. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. In a case where the arylsulfonium cation has two or more aryl groups, the two or more aryl groups may be the same or different from each other.

The alkyl group or the cycloalkyl group included in the arylsulfonium cation as necessary is preferably a linear alkyl group having 1 to 15 carbon atoms, a branched alkyl group having 3 to 15 carbon atoms, or a cycloalkyl group having 3 to 15 carbon atoms, and more preferably a methyl group, an ethyl group, a propyl group, an n-butyl group, a sec-butyl group, a t-butyl group, a cyclopropyl group, a cyclobutyl group, or a cyclohexyl group.

The substituent which may be contained in the aryl group, alkyl group, and cycloalkyl group of $R^{201}$ to $R^{203}$ is preferably an alkyl group (for example, having 1 to 15 carbon atoms), a cycloalkyl group (for example, having 3 to 15 carbon atoms), an aryl group (for example, having 6 to 14 carbon atoms), an alkoxy group (for example, having 1 to 15 carbon atoms), a cycloalkyl alkoxy group (for example, having 1 to 15 carbon atoms), a halogen atom (for example, fluorine and iodine), a hydroxyl group, a carboxy group, an ester group, a sulfinyl group, a sulfonyl group, an alkylthio group, or a phenylthio group.

The substituent may further have a substituent if possible, and it is also preferable that the above-described alkyl group has a halogen atom as the substituent to form an alkyl halide group such as a trifluoromethyl group.

In addition, it is also preferable to form an acid-decomposable group by any combination of the above-described substituents.

The acid-decomposable group is intended to a group which is decomposed by action of acid to generate a polar group, and preferably has a structure in which a polar group is protected by a leaving group which is eliminated by action of acid. The above-described polar group and leaving group are as described above.

Next, the cation (ZaI-2) will be described.

The cation (ZaI-2) is a cation in which $R^{201}$ to $R^{203}$ in Formula (ZaI) are each independently a cation representing an organic group having no aromatic ring. The aromatic ring also includes an aromatic ring including a heteroatom.

The number of carbon atoms in the organic group as $R^{201}$ to $R^{203}$, which has no aromatic ring, is preferably 1 to 30, and more preferably 1 to 20.

$R^{201}$ to $R^{203}$ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably a linear or branched 2-oxoalkyl group.

Examples of the alkyl group and cycloalkyl group of $R^{201}$ to $R^{203}$ include a linear alkyl group having 1 to 10

carbon atoms or a branched alkyl group having 3 to 10 carbon atoms (for example, a methyl group, an ethyl group, a propyl group, a butyl group, and a pentyl group), and a cycloalkyl group having 3 to 10 carbon atoms (for example, a cyclopentyl group, a cyclohexyl group, and a norbornyl group).

$R^{201}$ to $R^{203}$ may further be substituted with a halogen atom, an alkoxy group (for example, having 1 to 5 carbon atoms), a hydroxyl group, a cyano group, or a nitro group.

In addition, it is also preferable that the substituents of $R^{201}$ to $R^{203}$ each independently form an acid-decomposable group by any combination of the substituents.

Next, the cation (ZaI-3b) will be described.

The cation (ZaI-3b) is a cation represented by Formula (ZaI-3b).

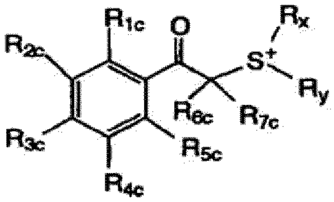

(ZaI-3b)

In General Formula (ZaI-3b),

$R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxyl group, a nitro group, an alkylthio group, or an arylthio group,

$R_{6c}$ and $R_{7c}$ each independently represent a hydrogen atom, an alkyl group (for example, a t-butyl group and the like), a cycloalkyl group, a halogen atom, a cyano group, or an aryl group, and

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

In addition, it is also preferable that the substituents of $R_{1c}$ to $R_{7c}$, $R_x$, and $R_y$ each independently form an acid-decomposable group by any combination of the substituents.

Any two or more of $R_{1c}$, ... , or $R_{5c}$, $R_{5c}$ and $R_{6c}$, $R_{6c}$ and $R_{7c}$, $R_{5c}$ and $R_x$, and $R_x$ and $R_y$ may each be bonded to each other to form a ring, and the rings may each independently include an oxygen atom, a sulfur atom, a ketone group, an ester bond, or an amide bond.

Examples of the above-described ring include an aromatic or non-aromatic hydrocarbon ring, an aromatic or non-aromatic heterocyclic ring, and a polycyclic fused ring formed by a combination of two or more of these rings. Examples of the ring include a 3- to 10-membered ring, and the ring is preferably a 4- to 8-membered ring and more preferably a 5- or 6-membered ring.

Examples of the group formed by the bonding of any two or more of $R_{1c}$, ... , or $R_{5c}$, $R_{6c}$ and $R_{7c}$, and $R_x$ and $R_y$ include an alkylene group such as a butylene group and a pentylene group. A methylene group in this alkylene group may be substituted with a heteroatom such as an oxygen atom.

As the group formed by the bonding of $R_{5c}$ and $R_{6c}$, and $R_{5c}$ and $R_x$, a single bond or an alkylene group is preferable. Examples of the alkylene group include a methylene group and an ethylene group.

The ring formed by bonding $R_{1c}$ to $R_{5c}$, $R_{6c}$, $R_{7c}$, $R_x$, $R_y$, any two or more of $R_{1c}$, ... , or $R_{5c}$, $R_{5c}$ and $R_{6c}$, $R_{6c}$ and $R_{7c}$, $R_{5c}$ and $R_x$, and $R_x$ and $R_y$ to each other may have a substituent.

Next, the cation (ZaI-4b) will be described.

The cation (ZaI-4b) is a cation represented by Formula (ZaI-4b).

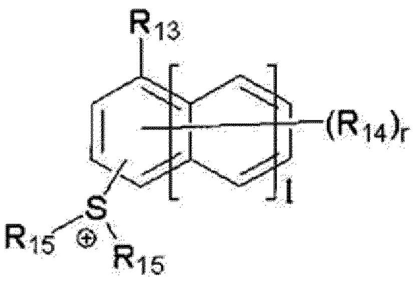

(ZaI-4b)

In Formula (ZaI-4b),

l represents an integer of 0 to 2.

r represents an integer of 0 to 8.

$R_{13}$ represents a hydrogen atom, a halogen atom (for example, a fluorine atom, an iodine atom, or the like), a hydroxyl group, an alkyl group, an alkyl halide group, an alkoxy group, a carboxy group, an alkoxycarbonyl group, or a group having a cycloalkyl group (which may be the cycloalkyl group itself or a group including the cycloalkyl group in a part thereof). These groups may have a substituent.

$R_{14}$ represents a hydroxyl group, a halogen atom (for example, a fluorine atom, an iodine atom, or the like), an alkyl group, an alkyl halide group, an alkoxy group, an alkoxycarbonyl group, an alkylcarbonyl group, an alkylsulfonyl group, a cycloalkylsulfonyl group, or a group including a cycloalkyl group (which may be the cycloalkyl group itself or a group including the cycloalkyl group in a part thereof). These groups may have a substituent. In a case of a plurality of $R_{14}$'s, $R_{14}$'s each independently represent the above-described group such as a hydroxyl group.

$R_{15}$'s each independently represent an alkyl group, a cycloalkyl group, or a naphthyl group. Two $R_{15}$'s may be bonded to each other to form a ring. In a case where two $R_{15}$'s are bonded to each other to form a ring, the ring skeleton may include a heteroatom such as an oxygen atom and a nitrogen atom.

In one aspect, it is preferable that two $R_{15}$'s are alkylene groups and are bonded to each other to form a ring structure. The above-described alkyl group, the above-described cycloalkyl group, the above-descried naphthyl group, and the ring formed by bonding two $R_{15}$'s to each other may have a substituent.

In Formula (ZaI-4b), the alkyl group of $R_{13}$, $R_{14}$, and $R_{15}$ may be linear or branched. The number of carbon atoms in the alkyl group is preferably 1 to 10. The alkyl group is preferably a methyl group, an ethyl group, an n-butyl group, a t-butyl group, or the like.

In addition, it is also preferable that the substituents of $R_{13}$ to $R_{15}$, $R_x$, and $R_y$ each independently form an acid-decomposable group by any combination of the substituents.

Next, Formula (ZaII) will be described.

In Formula (ZaII), $R^{204}$ and $R^{205}$ each independently represent an aryl group, an alkyl group, or a cycloalkyl group.

The aryl group of $R^{204}$ and $R^{205}$ is preferably a phenyl group or a naphthyl group, and more preferably a phenyl group. The aryl group of $R^{204}$ and $R^{205}$ may be an aryl group which has a heterocyclic ring having an oxygen atom, a nitrogen atom, a sulfur atom, or the like. Examples of a skeleton of the aryl group having a heterocyclic ring include pyrrole, furan, thiophene, indole, benzofuran, and benzothiophene.

The alkyl group and cycloalkyl group of $R^{204}$ and $R^{205}$ are preferably a linear alkyl group having 1 to 10 carbon atoms or a branched alkyl group having 3 to 10 carbon atoms (for example, a methyl group, an ethyl group, a propyl group, a butyl group, a pentyl group, and the like), or a cycloalkyl group having 3 to 10 carbon atoms (for example, a cyclopentyl group, a cyclohexyl group, a norbornyl group, and the like).

The aryl group, the alkyl group, and the cycloalkyl group of $R^{204}$ and $R^{205}$ may each independently have a substituent. Examples of the substituent which may be included in each of the aryl group, the alkyl group, and the cycloalkyl group of $R^{204}$ and $R^{205}$ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group. In addition, it is also preferable that the substituents of $R^{204}$ and $R^{205}$ each independently form an acid-decomposable group by any combination of the substituents.

Specific examples of the organic cation are shown below, but the present invention is not limited thereto.

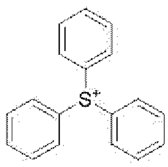
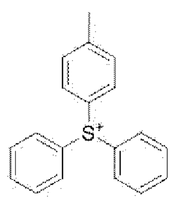
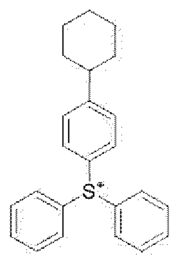
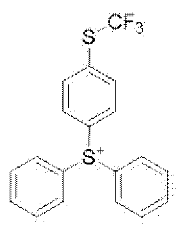

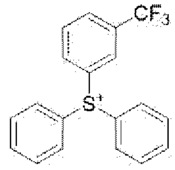 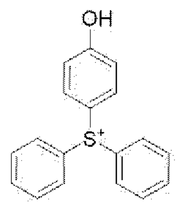 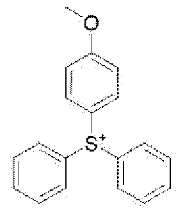 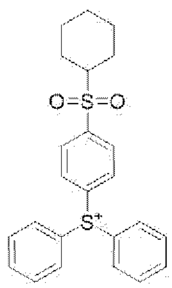

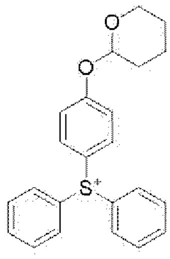 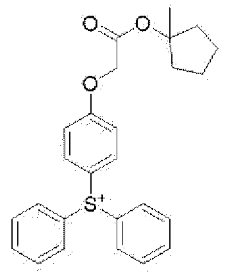 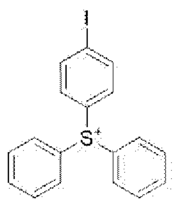 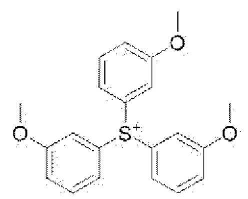

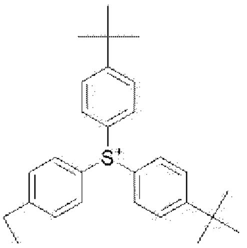 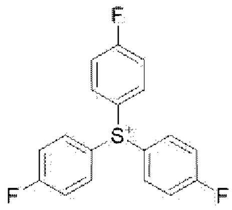 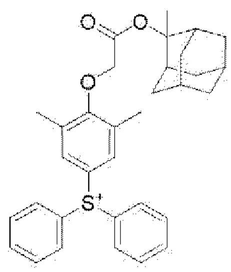 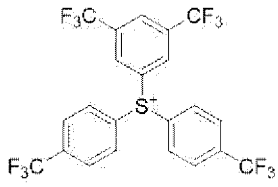

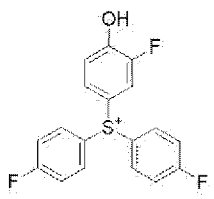 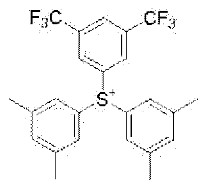 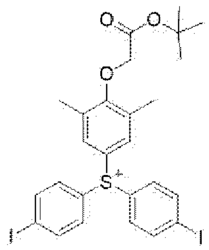 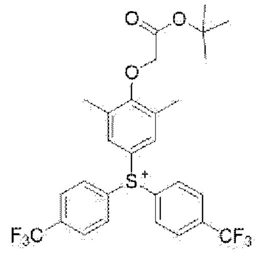

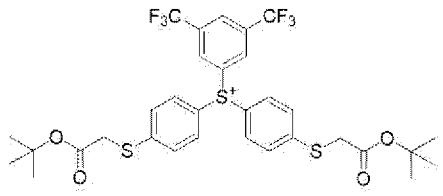 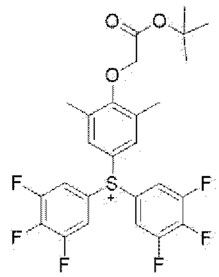 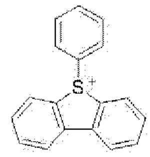

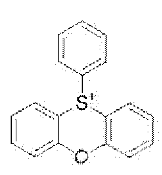 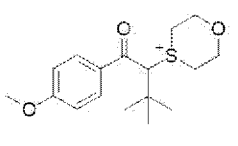 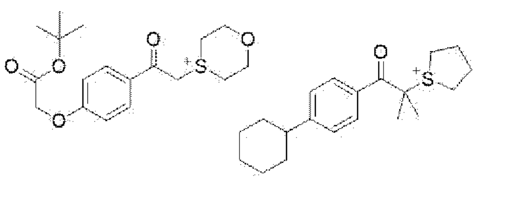

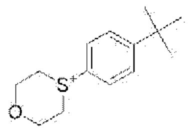
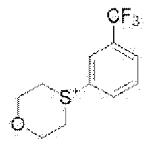
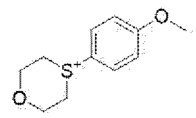
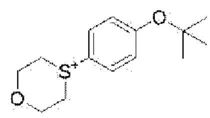

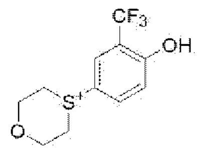
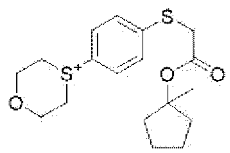
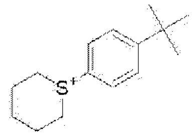
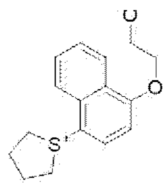

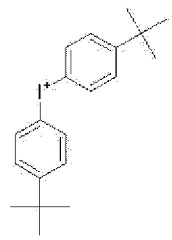
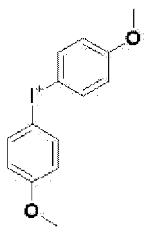
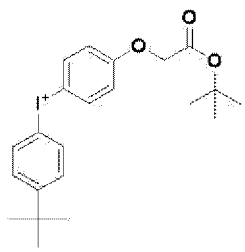

$X^-$ represents an organic anion.

The organic anion is preferably an anion with significantly lower ability to undergo nucleophilic reaction, and more preferably a non-nucleophilic anion.

Examples of the non-nucleophilic anion include a sulfonate anion (an aliphatic sulfonate anion, an aromatic sulfonate anion, a camphor sulfonate anion, and the like), a carboxylate anion (an aliphatic carboxylate anion, an aromatic carboxylate anion, an aralkyl carboxylate anion, and the like), a sulfonylimide anion, a bis(alkylsulfonyl)imide anion, and a tris(alkylsulfonyl)methide anion.

An aliphatic moiety in the aliphatic sulfonate anion and the aliphatic carboxylate anion may be a linear or branched alkyl group or a cycloalkyl group, and a linear or branched alkyl group having 1 to 30 carbon atoms or a cycloalkyl group having 3 to 30 carbon atoms is preferable.

The above-described alkyl group may be, for example, a fluoroalkyl group (which may have a substituent other than a fluorine atom and may be a perfluoroalkyl group).

An aryl group in the aromatic sulfonate anion and the aromatic carboxylate anion is preferably an aryl group having 6 to 14 carbon atoms, and examples thereof include a phenyl group, a tolyl group, and a naphthyl group.

The alkyl group, cycloalkyl group, and aryl group mentioned above may have a substituent. Examples of the substituent include a nitro group, a halogen atom such as a fluorine atom and a chlorine atom, a carboxy group, a hydroxyl group, an amino group, a cyano group, an alkoxy group (preferably having 1 to 15 carbon atoms), an alkyl group (preferably having 1 to 10 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), and an aryloxysulfonyl group (preferably having 6 to 20 carbon atoms).

As the aralkyl group in the aralkyl carboxylate anion, an aralkyl group having 7 to 14 carbon atoms is preferable.

Examples of the aralkyl group having 7 to 14 carbon atoms include a benzyl group, a phenethyl group, a naphthylmethyl group, a naphthylethyl group, and a naphthylbutyl group.

Examples of the sulfonylimide anion include a saccharin anion.

As the alkyl group in the bis(alkylsulfonyl)imide anion and the tris(alkylsulfonyl)methide anion, an alkyl group having 1 to 5 carbon atoms is preferable. Examples of a substituent of these alkyl group include a halogen atom, an alkyl group substituted with a halogen atom, an alkoxy group, an alkylthio group, an alkyloxysulfonyl group, an aryloxysulfonyl group, and a cycloalkylaryloxysulfonyl group, and a fluorine atom or an alkyl group substituted with a fluorine atom is preferable.

In addition, the alkyl groups in the bis(alkylsulfonyl)imide anion may be bonded to each other to form a ring structure. As a result, acid strength is increased.

Examples of other non-nucleophilic anions include fluorinated phosphorus (for example, $PF_6^-$), fluorinated boron

(for example, $BF_4^-$), and fluorinated antimony (for example, $SbF_6^-$).

As the non-nucleophilic anion, an aliphatic sulfonate anion in which at least an α-position of the sulfonic acid is substituted with a fluorine atom, an aromatic sulfonate anion substituted with a fluorine atom or a group having a fluorine atom, a bis(alkylsulfonyl)imide anion in which an alkyl group is substituted with a fluorine atom, or a tris(alkylsulfonyl)methide anion in which an alkyl group is substituted with a fluorine atom is preferable. Among these, a perfluoroaliphatic sulfonate anion (preferably having 4 to 8 carbon atoms) or benzenesulfonate anion having a fluorine atom is more preferable, and a nonafluorobutanesulfonate anion, a perfluorooctanesulfonate anion, a pentafluorobenzenesulfonate anion, or a 3,5-bis(trifluoromethyl)benzenesulfonate anion is still more preferable.

As the non-nucleophilic anion, an anion represented by Formula (AN1) is also preferable.

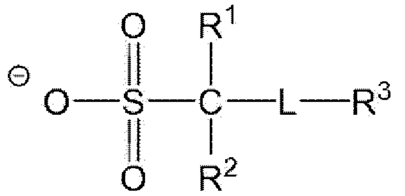

(AN1)

In Formula (AN1), $R^1$ and $R^2$ each independently represent a hydrogen atom or a substituent.

The substituent is preferably a group which is not an electron withdrawing group. Examples of the group which is not an electron withdrawing group include a hydrocarbon group, a hydroxyl group, an oxyhydrocarbon group, an oxycarbonyl hydrocarbon group, an amino group, a hydrocarbon-substituted amino group, and a hydrocarbon-substituted amide group.

In addition, the groups which are not an electron withdrawing group are each independently preferably -R', -OH, -OR', -OCOR', $-NH_2$, $-NR'_2$, -NHR', or -NHCOR'. R' is a monovalent hydrocarbon group.

Examples of the above-described monovalent hydrocarbon group represented by R' include an alkyl group such as a methyl group, an ethyl group, a propyl group, and a butyl group; an alkenyl group such as an ethenyl group, a propenyl group, and a butenyl group; a monovalent linear or branched hydrocarbon group of an alkynyl group or the like, such as an ethynyl group, a propynyl group, and a butynyl group; a cycloalkyl group such as a cyclopropyl group, a cyclobutyl group, a cyclopentyl group, a cyclohexyl group, a norbornyl group, and an adamantyl group; a monovalent alicyclic hydrocarbon group of a cycloalkenyl group or the like, such as a cyclopropenyl group, a cyclobutenyl group, a cyclopentenyl group, and a norbornenyl group; an aryl group such as a phenyl group, a tolyl group, a xylyl group, a mesityl group, a naphthyl group, a methylnaphthyl group, an anthryl group, and a methylanthryl group; and a monovalent aromatic hydrocarbon group of an aralkyl group or the like, such as a benzyl group, a phenethyl group, a phenylpropyl group, a naphthylmethyl group, and an anthrylmethyl group.

Among these, $R^1$ and $R^2$ are each independently a hydrocarbon group (preferably, a cycloalkyl group) or a hydrogen atom.

L represents a divalent linking group.

In a case of a plurality of L's, L's may be the same or different from each other.

Examples of the divalent linking group include -O-CO-O-, -COO-, -CONH-, -CO-, -O-, -S-, -SO-, $-SO_2-$, an alkylene group (preferably having 1 to 6 carbon atoms), a cycloalkylene group (preferably having 3 to 15 carbon atoms), an alkenylene group (preferably having 2 to 6 carbon atoms), and a divalent linking group formed by a combination of these groups. Among these, as the divalent linking group, -O-CO-O-, -COO-, -CONH-, -CO-, -O-, $-SO_2-$, -O-CO-O-alkylene group-, -COO-alkylene group-, or -CONH-alkylene group- is preferable, and -O-CO-O-, -O-CO-O-alkylene group-, -COO-, -CONH-, $-SO_2-$, or -COO-alkylene group- is more preferable.

For example, L is preferably a group represented by Formula (AN1-1).

$$*^{a}-(CR^{2a}2)_X-Q-(CR^{2b}_2)_Y-*^{b} \qquad \text{(AN1-1)}$$

In Formula (AN1-1), $*^a$ represents a bonding position with $R^3$ in Formula (AN1).

$*^b$ represents a bonding position $-C(R^1)(R^2)-$ in Formula (AN1).

X and Y each independently represent an integer of 0 to 10, preferably an integer of 0 to 3.

$R^{2a}$ and $R^{2b}$ each independently represent a hydrogen atom or a substituent.

In a case where $R^{2a}$'s and $R^{2b}$'s are present in a plural number, the $R^{2a}$'s and $R^{2b}$'s which are present in a plural number may be the same or different from each other.

However, in a case where Y is 1 or more, $R^{2b}$ in $CR^{2b}_2$ which is directly bonded to $-C(R^1)(R^2)-$ in Formula (AN1)

is not a fluorine atom.

Q represents $*^{A}$-O-CO-O-$*^{B}$, $*^{A}$-CO-$*^{B}$, $*^{A}$-CO-O-$*^{B}$, $*^{A}$-O-CO-$*^{B}$, $*^{A}$-O-$*^{B}$, $*^{A}$-S-$*^{B}$, or $*^{A}$-$SO_2$-$*^{B}$.

However, in a case where X + Y in Formula (AN1-1) is 1 or more and $R^{2a}$ and $R^{2b}$ in Formula (AN1-1) are all hydrogen atoms, Q represents $*^{A}$-O-CO-O-$*^{B}$, $*^{A}$-CO-$*^{B}$, $*^{A}$-O-CO-$*^{B}$, $*^{A}$-O-$*^{B}$, $*^{A}$-S-$*^{B}$, or $*^{A}$-$SO_2$-$*^{B}$.

$*^{A}$ represents a bonding position on the $R^3$ side in Formula (AN1), and $*^{B}$ represents a bonding position on the -$SO_3^-$ side in Formula (AN1).

In Formula (AN1), $R^3$ represents an organic group.

The above-described organic group is not particularly limited as long as it has one or more carbon atoms, and may be a linear group (for example, a linear alkyl group) or a branched group (for example, a branched alkyl group such as a t-butyl group), and may be a cyclic group. The above-described organic group may or may not have a substituent. The above-described organic group may or may not have a heteroatom (oxygen atom, sulfur atom, nitrogen atom, and/or the like).

Among these, $R^3$ is preferably an organic group having a cyclic structure. The above-described cyclic structure may be monocyclic or polycyclic, and may have a substituent. The ring of the organic group including a cyclic structure is preferably directly bonded to L in Formula (AN1).

For example, the above-described organic group having a cyclic structure may or may not have a heteroatom (oxygen atom, sulfur atom, nitrogen atom, and/or the like). The heteroatom may be substituted on one or more carbon atoms forming the cyclic structure.

As the above-described organic group having a cyclic structure, for example, a hydrocarbon group having a cyclic structure, a lactone ring group, or a sultone ring group is preferable. Among these, the above-described organic group having a cyclic structure is preferably a hydrocarbon group having a cyclic structure.

The above-described hydrocarbon group having a cyclic structure is preferably a monocyclic or polycyclic cycloalkyl group. These groups may have a substituent.

The above-described cycloalkyl group may be a monocycle (cyclohexyl group or the like) or a polycycle (adamantyl group or the like), and the number of carbon atoms is preferably 5 to 12.

As the above-described lactone group and sultone group, for example, a group obtained by removing one hydrogen atom from ring member atoms constituting the lactone structure or the sultone structure in any of the structures represented by Formulae (LC1-1) to (LC1-21) described above and the structures represented by Formulae (SL1-1) to (SL1-3) described above is preferable.

The non-nucleophilic anion may be a benzenesulfonate anion, and is preferably a benzenesulfonate anion substituted with a branched alkyl group or a cycloalkyl group.

As the non-nucleophilic anion, an anion represented by Formula (AN2) is also preferable.

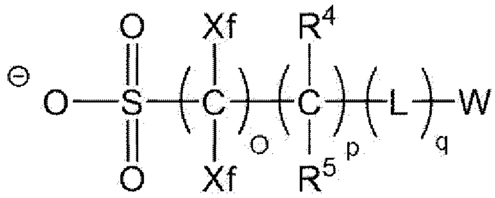

(AN2)

In Formula (AN2), o represents an integer of 1 to 3. p represents an integer of 0 to 10. q represents an integer of 0 to 10.

Xf represents a hydrogen atom, a fluorine atom, an alkyl group substituted with at least one fluorine atom, or an organic group not having a fluorine atom. The number of carbon atoms in the alkyl group is preferably 1 to 10 and more preferably 1 to 4. In addition, the alkyl group substituted with at least one fluorine atom is preferably a perfluoroalkyl group.

Xf is preferably a fluorine atom or a perfluoroalkyl group having 1 to 4 carbon atoms and more preferably a fluorine atom or $CF_3$, and it is still more preferable that both Xf's are fluorine atoms.

$R^4$ and $R^5$ each independently represent a hydrogen atom, a fluorine atom, an alkyl group, or an alkyl group substituted with at least one fluorine atom. In a case of a plurality of $R^4$'s and $R^5$'s, $R^4$'s and $R^5$'s may be the same or different from each other.

The alkyl group represented by $R^4$ and $R^5$ preferably has 1 to 4 carbon atoms. The above-described alkyl group may further have a substituent. $R_4$ and $R_5$ are preferably a hydrogen atom.

L represents a divalent linking group. The definition of L is synonymous with L in Formula (AN1).

W represents an organic group including a cyclic structure. Among these, a cyclic organic group is preferable.

Examples of the cyclic organic group include an alicyclic group, an aryl group, and a heterocyclic group.

The alicyclic group may be monocyclic or polycyclic. Examples of the monocyclic alicyclic group include a

monocyclic cycloalkyl group such as a cyclopentyl group, a cyclohexyl group, and a cyclooctyl group. Examples of the polycyclic alicyclic group include a polycyclic cycloalkyl group such as a norbornyl group, a tricyclodecanyl group, a tetracyclodecanyl group, a tetracyclododecanyl group, and an adamantyl group. Among these, an alicyclic group having a bulky structure with 7 or more carbon atoms, such as a norbornyl group, a tricyclodecanyl group, a tetracyclodecanyl group, a tetracyclododecanyl group, and an adamantyl group, is preferable.

The aryl group may be monocyclic or polycyclic. Examples of the above-described aryl group include a phenyl group, a naphthyl group, a phenanthryl group, and an anthryl group.

The heterocyclic group may be monocyclic or polycyclic. Among these, in a case of a polycyclic heterocyclic group, the diffusion of the acid can be further suppressed. In addition, the heterocyclic group may or may not have aromaticity. Examples of a heterocycle having aromaticity include a furan ring, a thiophene ring, a benzofuran ring, a benzothiophene ring, a dibenzofuran ring, a dibenzothiophene ring, and a pyridine ring. Examples of a heterocycle not having aromaticity include a tetrahydropyran ring, a lactone ring, a sultone ring, and a decahydroisoquinoline ring. As the heterocycle in the heterocyclic group, a furan ring, a thiophene ring, a pyridine ring, or a decahydroisoquinoline ring is preferable.

The above-described cyclic organic group may have a substituent. Examples of the above-described substituent include an alkyl group (may be linear or branched; preferably having 1 to 12 carbon atoms), a cycloalkyl group (may be monocyclic, polycyclic, or spirocyclic; preferably having 3 to 20 carbon atoms), an aryl group (preferably having 6 to 14 carbon atoms), a hydroxyl group, an alkoxy group, an ester group, an amide group, a urethane group, a ureido group, a thioether group, a sulfonamide group, and a sulfonic acid ester group. A carbon constituting the cyclic organic group (carbon contributing to ring formation) may be a carbonyl carbon.

As the anion represented by Formula (AN2), $SO_3^--CF_2-CH_2-OCO-(L)_{q'}-W$, $SO_3^--CF_2-CHF-CH_2-OCO-(L)_{q'}-W$, $SO_3^--CF_2-COO-(L)_{q'}-W$, $SO_3^--CF_2-CF_2-CH_2-CH_2-(L)_q-W$, or $SO_3^--CF_2-CH(CF_3)-OCO-(L)_{q'}-W$ is preferable. Here, L, q, and W are the same as in Formula (AN2). q' represents an integer of 0 to 10.

As the non-nucleophilic anion, an aromatic sulfonate anion represented by Formula (AN3) is also preferable.

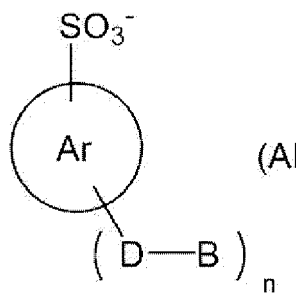

(AN3)

In Formula (AN3), Ar represents an aryl group (phenyl group or the like), and may further have a substituent other than a sulfonate anion and a -(D-B) group. Examples of the substituent which may be further included include a fluorine atom and a hydroxyl group.

n represents an integer of 0 or more. n is preferably 1 to 4, more preferably 2 or 3, and still more preferably 3.

D represents a single bond or a divalent linking group. Examples of the divalent linking group include an ether group, a thioether group, a carbonyl group, a sulfoxide group, a sulfone group, a sulfonic acid ester group, an ester group, and a group consisting of a combination of two or more of these groups.

B represents a hydrocarbon group.

B is preferably an aliphatic hydrocarbon group, and more preferably an isopropyl group, a cyclohexyl group, or an aryl group which may further have a substituent (such as a tricyclohexylphenyl group).

As the non-nucleophilic anion, a disulfonamide anion is also preferable.

The disulfonamide anion is, for example, an anion represented by $N^-(SO_2-R^q)_2$.

$R^q$ represents an alkyl group which may have a substituent, and is preferably a fluoroalkyl group and more preferably a perfluoroalkyl group. Two $R^q$'s may be bonded to each other to form a ring. The group formed by bonding two $R^q$'s to each other is preferably an alkylene group which may have a substituent, preferably a fluoroalkylene group, and still more preferably a perfluoroalkylene group. The number of carbon atoms in the above-described alkylene group is preferably 2 to 4.

In addition, examples of the non-nucleophilic anion include anions represented by Formulae (d1-1) to (d1-4).

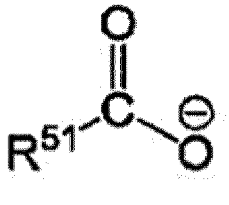

(d 1 − 1)

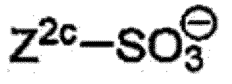

(d 1 − 2)

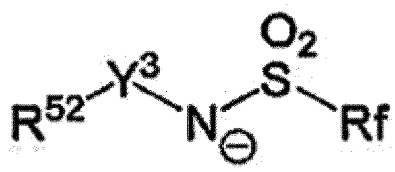

(d 1 − 3)

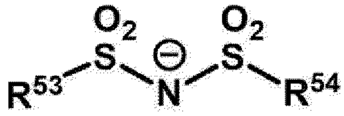

(d1-4)

In Formula (d1-1), $R^{51}$ represents a hydrocarbon group (for example, an aryl group such as a phenyl group) which may have a substituent (for example, a hydroxyl group).

In Formula (d1-2), $Z^{2c}$ represents a hydrocarbon group having 1 to 30 carbon atoms, which may have a substituent (provided that a carbon atom adjacent to S is not substituted with a fluorine atom).

The above-described hydrocarbon group in $Z^{2c}$ may be linear or branched, may have a cyclic structure. In addition, carbon atoms in the above-described hydrocarbon group (preferably, carbon atoms which are ring member atoms in a case where the above-described hydrocarbon group has a cyclic structure) may be a carbonyl carbon (-CO-). Examples of the hydrocarbon group include a group having a norbornyl group which may have a substituent. Carbon atoms forming the above-described norbornyl group may be a carbonyl carbon.

In addition, it is preferable that "$Z^{2c}$-$SO_3^-$" in Formula (d1-2) is different from the above-described anions represented by Formulae (AN1) to (AN3). For example, $Z^{2c}$ is preferably a group other than an aryl group. In addition, for example, in $Z^{2c}$, atoms at $\alpha$-position and $\beta$-position with respect to -$SO_3^-$ are preferably atoms other than carbon atoms having a fluorine atom as a substituent. For example, in $Z^{2c}$, it is preferable that the atom at $\alpha$-position and/or the atom at $\beta$-position with respect to -$SO_3^-$ is a ring member atom in a cyclic group.

In Formula (d1-3), $R^{52}$ represents an organic group (preferably, a hydrocarbon group having a fluorine atom), $Y^3$ represents a linear, branched, or cyclic alkylene group, an arylene group, or a carbonyl group, and Rf represents a hydrocarbon group.

In Formula (d1-4), $R^{53}$ and $R^{54}$ each independently represent an organic group (preferably, a hydrocarbon group having a fluorine atom). $R^{53}$ and $R^{54}$ may be bonded to each other to form a ring.

The other photoacid generator may be a compound having two or more anionic moieties and one or more cationic moieties in the molecule. Examples of the above-described other photoacid generator include paragraphs [0055] to [0124] of WO2020/262134A, the contents of which are incorporated herein by reference.

The other photoacid generator (B) may be used alone or in combination of two or more kinds thereof.

In a case where the resist composition contains the other photoacid generator (B), from the viewpoint of making the cross-sectional shape of the formed pattern more rectangular, a content of the other photoacid generator (B) is preferably 0.5% by mass or more, and more preferably 1.0% by mass or more with respect to the total solid content of the resist composition. The upper limit thereof is preferably 50.0% by mass or less, more preferably 30.0% by mass or less, and still more preferably 10.0% by mass or less with respect to the total solid content of the resist composition.

<Specific Acid Diffusion Control Agent (C)>

The resist composition contains the specific acid diffusion control agent.

The specific acid diffusion control agent is a compound which is decomposed by irradiation with actinic ray or radiation to generate an acid having a pKa higher than the pKa of the acid generated from the photoacid generating group represented by Formula (c) described above by 0.50 or more.

The specific acid diffusion control agent acts as a quencher which suppresses a reaction of an acid-decomposable resin in a non-exposed portion by excessive generated acids by trapping the acids generated from the photoacid generator and the like during exposure.

The specific acid diffusion control agent is the compound which generates an acid having a pKa higher than the pKa of the acid generated from the photoacid generating group represented by Formula (c) described above by 0.50 or more, and from the viewpoint that the effect of the present invention is more excellent, it is preferably a compound which generates an acid having a pKa higher than the pKa of the acid generated from the photoacid generating group

represented by Formula (c) described above by 1.00 or more, more preferably a compound which generates an acid having a pKa higher than the pKa of the acid generated from the photoacid generating group represented by Formula (c) described above by 1.20 or more, still more preferably a compound which generates an acid having a pKa higher than the pKa of the acid generated from the photoacid generating group represented by Formula (c) described above by 5.00 or more, and particularly preferably a compound which generates an acid having a pKa higher than the pKa of the acid generated from the photoacid generating group represented by Formula (c) described above by 7.00 or more. The upper limit thereof is preferably 10.00 or less, and more preferably 8.00 or less.

The pKa of the specific acid diffusion control agent is preferably 0.01 or more, more preferably 1.00 or more, and still more preferably 3.00 or more. The upper limit thereof is preferably 10.0 or less, and more preferably 8.00 or less.

Examples of a method for measuring the pKa of the above-described specific acid diffusion control agent include the above-described pKa calculation method (for example, software package 1 or the like) using a corresponding compound.

The specific acid diffusion control agent is not particularly limited as long as it is a compound which generates an acid having a pKa higher than the pKa of the acid generated from the above-described photoacid generating group by 0.50 or more.

Description of CL8

It is preferable that the specific acid diffusion control agent includes at least one selected from the group consisting of a compound represented by Formula (C1) and a compound represented by Formula (C2).

$$R^{C1a}\text{-}A_{C1}^{-}\ M_{C1}^{+} \qquad (C1)$$

In Formula (C1), $A_{C1}^-$ represents $-COO^-$, $-O^-$, or $-N^--SO_2-R^{C1b}$, $R^{C1a}$ and $R^{C1b}$ each independently represent an organic group, $R^{C1a}$ and $R^{C1b}$ may be bonded to each other to form a ring, and $M_{C1}^+$ represents a sulfonium cation or an iodonium cation.

$R^{C1a}$ and $R^{C1b}$ each independently represent an organic group. $R^{C1a}$ and $R^{C1b}$ may be bonded to each other to form a ring.

Examples of the above-described organic group include an alkyl group, a cycloalkyl group, an aryl group, an alkyloxycarbonyl group, a cycloalkyloxycarbonyl group, an aryloxycarbonyl group, an alkylaminocarbonyl group, a cycloalkylaminocarbonyl group, an aldehyde group, and an arylaminocarbonyl group, which may have a substituent. Among these, an aldehyde group, an alkyl group which may have a substituent, or an aryl group which may have a substituent is preferable.

The number of carbon atoms in the organic group is preferably 1 to 30, more preferably 1 to 20, and still more preferably 6 to 12.

Examples of the substituent include a halogen atom (preferably, a fluorine atom) and a hydroxyl group.

The ring formed by bonding $R^{C1a}$ and $R^{C1b}$ to each other may be monocyclic or polycyclic.

$M_{C1}^+$ represents a sulfonium cation or an iodonium cation.

$M_{C1}^+$ is preferably the above-described cation represented by Formula (ZaI) or the above-described cation represented by Formula (ZaII).

$$A_{C2}^{-}\text{-}L^{C2}\text{-}M_{C2}^{+} \qquad (C2)$$

In Formula (C2), $A_{C2}^-$ represents $-COO^-$, $-O^-$, or $-N^--SO_2-R^{C2}$, $L^{C2}$ represents a single bond or a divalent linking group, $M_{C2}^+$ represents $-S^+R^{C3}R^{C4}$ or $-I^+R^{C5}$, and $R^{C2}$ to $R^{C5}$ each independently represent an organic group.

$R^{C2}$ to $R^{C5}$ each independently represent an organic group. Examples of $R^{C2}$ to $R^{C5}$ include the organic group represented by $R^{C1a}$ and $R^{C1b}$ in Formula (C1) described above.

$L^{C2}$ represents a single bond or a divalent linking group.

Examples of the divalent linking group include a linear or branched alkylene group, a cycloalkylene group, an arylene group (preferably having 6 to 15 carbon atoms), a carbonyl group, an ether bond, an ester bond, an amide bond, a urethane bond, a urea bond, and a group formed by a combination thereof. Among these, an alkylene group, an arylene group, an ether bond, an ester bond, or a group formed by combining two or more thereof is preferable, an arylene group is more preferable, and a phenyl group is still more preferable.

As the specific acid diffusion control agent, a basic compound (CA) (hereinafter, also referred to as "compound (CA)"), a basic compound (CB) (hereinafter, also referred to as "compound (CB)") in which basicity decreases or disappears by irradiation with actinic ray or radiation, a low-molecular-weight compound (CD) (hereinafter, also referred to as "compound (CD)") which has a nitrogen atom and has a group eliminated by action of acid, or the like can be used as the acid diffusion control agent.

Among these, it is preferable that the composition contains a basic compound (CB) in which basicity decreases or disappears by irradiation with actinic ray or radiation.

(Compound (CA))

As the compound (CA), a compound having a structure represented by Formulae (A) to (E) is preferable.

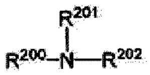
(A)
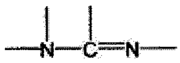
(B)
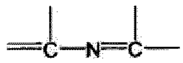
(C)
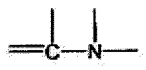
(D)
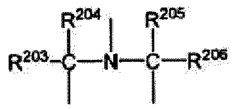
(E)

In Formulae (A) and (E),
$R^{200}$, $R^{201}$, and $R^{202}$ may be the same or different from each other, and each independently represent a hydrogen atom, an alkyl group (preferably having 1 to 20 carbon atoms), a cycloalkyl group (preferably having 3 to 20 carbon atoms), or an aryl group (preferably having 6 to 20 carbon atoms). $R^{201}$ and $R^{202}$ may be bonded to each other to form a ring.
$R^{203}$, $R^{204}$, $R^{205}$, and $R^{206}$ may be the same or different from each other, and each independently represent an alkyl group having 1 to 20 carbon atoms.
The alkyl groups in Formulae (A) and (E) may have a substituent or may be unsubstituted.
With regard to the above-described alkyl group, an alkyl group having a substituent is preferably an aminoalkyl group having 1 to 20 carbon atoms, a hydroxyalkyl group having 1 to 20 carbon atoms, or a cyanoalkyl group having 1 to 20 carbon atoms.
The alkyl groups in Formulae (A) and (E) are more preferably unsubstituted.
As the compound (CA), guanidine, aminopyrrolidine, pyrazole, pyrazoline, piperazine, aminomorpholine, aminoalkylmorpholine, or piperidine is preferable; and a compound having an imidazole structure, a diazabicyclo structure, an onium hydroxide structure, an onium carboxylate structure, a trialkylamine structure, an aniline structure, or a pyridine structure, an alkylamine derivative having a hydroxyl group and/or an ether group, or an aniline derivative having a hydroxyl group and/or an ether group is more preferable.

(Compound (CB))

The compound (CB) is a compound which is decomposed by irradiation (exposure) with actinic ray or radiation to generate a compound (acid) with reduced basicity. The compound with reduced basicity is, for example, a conjugate acid of the compound (CB).
The pka of the acid generated from the compound (CB) is, for example, preferably more than 0.5, more preferably more than 1.0, and still more preferably more than 1.5.
In addition, in a case where the compound (DB) has an anion represented by Formula (c-1) described later, the pka of the acid generated from the compound (CB) is also preferably, for example, more than -11.0.
The compound (CB) also preferably has, for example, a proton-accepting functional group.
The proton-accepting functional group refers to a functional group having a group or electron capable of electrostatically interacting with a proton, and for example, means a functional group with a macrocyclic structure, such as a cyclic polyether, and a functional group having a nitrogen atom having an unshared electron pair not contributing to $\pi$-conjugation. For example, the nitrogen atom having the unshared electron pair, which does not contribute to the $\pi$-conjugation, is a nitrogen atom having a partial structure represented by the following formula.

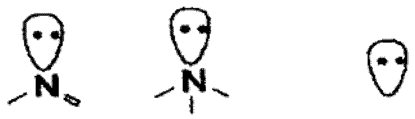

unshared electron pair
As the partial structure of the proton-accepting functional group, a crown ether structure, an azacrown ether structure, primary to tertiary amine structures, a pyridine structure, an imidazole structure, or a pyrazine structure is preferable.
It is also preferable that the compound (CB) is decomposed by irradiation with actinic ray or radiation to generate a compound exhibiting deterioration or disappearance in proton-accepting properties, no proton-accepting properties, or a change from the proton-accepting properties to acidic properties. Here, the decrease or disappearance of proton-accepting properties, or the change from proton-accepting properties to acidic properties is a change in proton-accepting properties due to the proton being added to the proton-accepting functional group, and specifically means that, in a case where a proton adduct is generated from the compound (CB) having the proton-accepting functional group and the proton, the equilibrium constant in chemical equilibrium thereof decreases.

The proton-accepting properties can be confirmed by performing a pH measurement.

The compound (CB) is preferably an onium salt compound consisting of an anion and a cation. Examples of such an onium salt compound include a compound consisting of a combination of an anion and a cation described below.

· Anion

Examples of the anion include the anion included in the other photoacid generator described above, and the anion represented by Formulae (d1-1) to (d1-4) described above is preferable. In addition, an anion represented by Formula (d1-5) is also preferable.

$$Ar^{d5}\text{-}O^{-} \qquad (d1\text{-}5)$$

In Formula (d1-5), $Ar^{d5}$ represents an aryl group which may have a substituent.

The above-described aryl group may be monocyclic or polycyclic.

As the above-described substituent, a halogen atom or an alkyl group is preferable, a halogen atom is more preferable, and a fluorine atom is still more preferable.

The number of carbon atoms in the above-described aryl group is preferably 6 to 20 and more preferably 6 to 12.

The above-described aryl group is preferably a phenyl group or a naphthyl group, and more preferably a phenyl group.

The anion included in the compound (CB), which is the onium salt compound consisting of an anion and a cation, is also preferably an anion represented by Formula (c-1).

That is, the compound (CB) is also preferably a compound having an anion represented by Formula (c-1).

$$Q\text{-}A\text{-}X\text{-}B\text{-}R \qquad (c\text{-}1)$$

In Formula (c-1),
Q represents $-SO_3^-$, $-CO_2^-$, or $-W_1-N^--W_2R_f$. $W_1$ and $W_2$ each independently represent $-SO_2-$ or -CO-. $R_f$ represents an alkyl group which may have a substituent, a cycloalkyl group which may have a substituent, or an aryl group which may have a substituent.

A represents a single bond or a divalent linking group.

X represents a single bond, $-SO_2-$, or -CO-.

B represents a single bond, an oxygen atom, or $-N(R_x)R_y-$. $R_x$ represents a hydrogen atom or an organic group. $R_y$ represents a single bond or a divalent organic group.

R represents a monovalent organic group having a proton-accepting functional group.

$R_x$ may be bonded to $R_y$ to form a ring, or may be bonded to R to form a ring, and

It is preferable that at least one of $W_1$ or $W_2$ is $-SO_2-$, and it is preferable that both are $-SO_2-$.

Rf is preferably an alkyl group having 1 to 6 carbon atoms, which may have a fluorine atom, more preferably a perfluoroalkyl group having 1 to 6 carbon atoms, and still more preferably a perfluoroalkyl group having 1 to 3 carbon atoms.

As the divalent linking group in A, a divalent linking group having 2 to 12 carbon atoms is preferable, and examples thereof include an alkylene group and a phenylene group. Among these, an alkylene group having at least one fluorine atom is preferable, and the alkylene group preferably has 2 to 6 carbon atoms, and more preferably has 2 to 4 carbon atoms. An alkylene chain may have a linking group such as an oxygen atom and a sulfur atom. It is preferable that the alkylene group is an alkylene group in which 30% to 100% of the number of hydrogen atoms is substituted with a fluorine atom, and it is more preferable that the carbon atom bonded to the Q site has a fluorine atom. Among these, as the divalent linking group in A, a perfluoroalkylene group is preferable, and a perfluoroethylene group, a perfluoropropylene group, or a perfluorobutylene group is more preferable.

The monovalent organic group in Rx preferably has 2 to 30 carbon atoms, and examples thereof include an alkyl group, a cycloalkyl group which may have an oxygen atom in the ring, an aryl group, an aralkyl group, and an alkenyl group.

The alkyl group in Rx may have a substituent, and is preferably a linear or branched alkyl group having 1 to 20 carbon atoms, an alkyl chain may have an oxygen atom, a sulfur atom, and/or a nitrogen atom.

Examples of the alkyl group having a substituent include a group in which a linear or branched alkyl group is substituted with a cycloalkyl group (for example, an adamantylmethyl group, an adamantylethyl group, a cyclohexylethyl

group, a camphor residue, and the like).

The cycloalkyl group in Rx may have a substituent, and is preferably a cycloalkyl group having 3 to 20 carbon atoms. In addition, an oxygen atom may be included in the ring of the cycloalkyl group.

The aryl group in Rx may have a substituent, and is preferably an aryl group having 6 to 14 carbon atoms.

The aralkyl group in Rx may have a substituent, and is preferably an aralkyl group having 7 to 20 carbon atoms.

The alkenyl group in Rx may have a substituent, and examples thereof include a group having a double bond at any position of the alkyl group mentioned as Rx.

In a case where B represents -N(Rx)Ry-, the divalent organic group in Ry is preferably an alkylene group. In addition, in this case, examples of a ring structure formed by bonding Rx and Ry to each other include a 5- to 8-membered ring including a nitrogen atom, and particularly preferred examples thereof include a 6-membered ring.

In a case where B represents -N(Rx)Ry-, it is preferable that R and Rx are bonded to each other to form a ring. By forming the ring structure, stability is improved, and storage stability of a composition using this is improved. The number of carbon atoms forming the ring is preferably 4 to 20, the ring may be a monocycle or a polycycle, and the ring may include an oxygen atom, a sulfur atom, and/or a nitrogen atom.

Examples of the monocycle include a 4-membered ring, 5-membered ring, 6-membered ring, 7-membered ring, or 8-membered ring including a nitrogen atom. Examples of such a ring structure include a piperazine ring and a piperidine ring. Examples of the polycycle include a structure formed by a combination of two or three or more monocyclic structures. Each of the monocycle and the polycycle may have a substituent, and for example, a halogen atom, a hydroxyl group, a cyano group, a carboxy group, a carbonyl group, a cycloalkyl group (preferably having 3 to 10 carbon atoms), an aryl group (preferably having 6 to 14 carbon atoms), an alkoxy group (preferably having 1 to 10 carbon atoms), an acyl group (preferably having 2 to 15 carbon atoms), an acyloxy group (preferably having 2 to 15 carbon atoms), an alkoxycarbonyl group (preferably having 2 to 15 carbon atoms), an aminoacyl group (preferably having 2 to 20 carbon atoms), or the like is preferable. If possible, these substituents may further have a substituent. Examples of a case where the aryl group and the cycloalkyl group further have a substituent include an alkyl group (preferably having 1 to 15 carbon atoms). Examples of a substituent further included in the aminoacyl group include an alkyl group (preferably having 1 to 15 carbon atoms).

The proton-accepting functional group in R is as described above, and examples of a preferred partial structure thereof include crown ether, primary to tertiary amine, and a structure of a nitrogen-containing hetero ring (for example, pyridine, imidazole, pyrazine, and the like).

As the proton-accepting functional group, a functional group having a nitrogen atom is preferable, and a group having a primary to tertiary amino group or a nitrogen-containing heterocyclic group is more preferable. In these structures, it is preferable that all atoms adjacent to the nitrogen atom included in the structure are carbon atoms or hydrogen atoms. In addition, it is preferable that an electron-withdrawing functional group (a carbonyl group, a sulfonyl group, a cyano group, a halogen atom, or the like) is not directly connected to the nitrogen atom.

The monovalent organic group in such a monovalent organic group (group R) including the proton-accepting functional group preferably has 2 to 30 carbon atoms, and examples thereof include an alkyl group, a cycloalkyl group, an aryl group, an aralkyl group, and an alkenyl group, in which each group may have a substituent.

Each of the alkyl group, the cycloalkyl group, the aryl group, the aralkyl group, and the alkenyl group in the alkyl group, the cycloalkyl group, the aryl group, the aralkyl group, and the alkenyl group, which are included in the proton-accepting functional group in R, are the same groups as the alkyl group, the cycloalkyl group, the aryl group, the aralkyl group, and the alkenyl group, which are exemplified as Rx.

Examples of the substituent which may be included in each group described above include a halogen atom, a hydroxyl group, a nitro group, a cyano group, a carboxy group, a cycloalkyl group (preferably having 3 to 10 carbon atoms; which may be partially substituted with a heteroatom or a group having a heteroatom (an ester group and the like)), an aryl group (preferably having 6 to 14 carbon atoms), an alkoxy group (preferably having 1 to 10 carbon atoms), an acyl group (preferably having 2 to 20 carbon atoms), an acyloxy group (preferably having 2 to 10 carbon atoms), an alkoxycarbonyl group (preferably having 2 to 20 carbon atoms), and an aminoacyl group (preferably having 2 to 20 carbon atoms). Examples of the substituent included in the cyclic group of the aryl group, the cycloalkyl group, and the like include an alkyl group (preferably having 1 to 20 carbon atoms). Examples of a substituent included in the aminoacyl group include an alkyl group (preferably having 1 to 20 carbon atoms).

· Cation

Examples of the cation include the organic cation included in the other photoacid generator described above, and the cation (ZaI) or the cation (ZaII) is preferable.

In addition, in the compound (CB) which is the onium salt compound consisting of an anion and a cation, the cation is preferably a cation having a basic site including a nitrogen atom. That is, it is also preferable that the compound (CB) is an onium salt compound (CE) having a nitrogen atom in the cationic moiety.

The basic site is preferably an amino group and more preferably an aliphatic amino group. It is still more preferable that all of atoms adjacent to the nitrogen atom in the basic site are hydrogen atoms or carbon atoms. In addition, from the viewpoint of improving basicity, it is preferable that an electron-withdrawing functional group (a carbonyl group, a sulfonyl group, a cyano group, a halogen atom, or the like) is not directly connected to the nitrogen atom.

The compound (CB) may be a compound (hereinafter, also referred to as "compound (CCA)") having a cationic group and an anionic group in the same molecule, in which the cationic group and the anionic group are linked by a covalent bond.

As the compound (CCA), a compound represented by any one of Formulae (C-1) to (C-3) is preferable, and a compound represented by Formula (C-1) is more preferable.

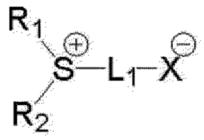
(C-1)

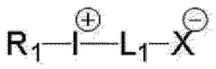
(C-2)

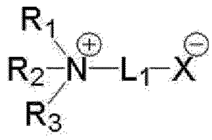
(C-3)

In Formulae (C-1) to (C-3),

$R_1$, $R_2$, and $R_3$ each independently represent an organic group.

$L_1$ represents a divalent linking group or a single bond, which links the cationic group ($S^+$, $I^+$, or $N^+$) and $-X^-$.

$-X^-$ represents $-COO^-$, $-SO_3^-$, $-SO_2^-$, or $-N^--R_4$.

$R_4$ represents a monovalent substituent having at least one selected from the group consisting of a carbonyl group (-CO-), a sulfonyl group ($-SO_2-$), and a sulfinyl group (-S(=O)-) at a linking site with an adjacent N atom.

$R_1$ to $R_4$ and $L_1$ may be bonded to each other to form a ring. However, the ring formed by bonding $R_1$ and $R_2$ in Formula (C-1) to each other does not have a heteroatom other than $S^+$.

In addition, in Formula (C-3), two of $R_1$ to $R^3$ together represent one divalent substituent, which may be bonded to an N atom by a double bond.

Examples of the organic group represented by $R_1$ to $R_3$ include an alkyl group, a cycloalkyl group, an aryl group (preferably having 6 to 15 carbon atoms), an alkyloxycarbonyl group, a cycloalkyloxycarbonyl group, an aryloxycarbonyl group, an alkylaminocarbonyl group, a cycloalkylaminocarbonyl group, and an arylaminocarbonyl group. Among these, an alkyl group, a cycloalkyl group, or an aryl group is preferable, and an aryl group is more preferable.

Examples of $L_1$ as the divalent linking group include a linear or branched alkylene group, a cycloalkylene group, an arylene group (preferably having 6 to 15 carbon atoms), a carbonyl group, an ether bond, an ester bond, an amide bond, a urethane bond, a urea bond, and a group formed by combining two or more thereof. Among these, an alkylene group, an arylene group, an ether bond, an ester bond, or a group formed by combining two or more thereof is preferable, an arylene group is more preferable, and a phenyl group is still more preferable.

(Compound (CD))

The compound (CD) is preferably an amine derivative having, on the nitrogen atom, a group which is eliminated by the action of acid.

The group which is eliminated by action of acid is preferably an acetal group, a carbonate group, a carbamate group, a tertiary ester group, a tertiary hydroxyl group, or a hemiaminal ether group, and more preferably a carbamate group or a hemiaminal ether group.

A molecular weight of the compound (CD) is preferably 100 to 1,000, more preferably 100 to 700, and still more preferably 100 to 500.

The compound (CD) may have a carbamate group having a protective group on a nitrogen atom. The protective group constituting the carbamate group is preferably a group represented by Formula (d-1).

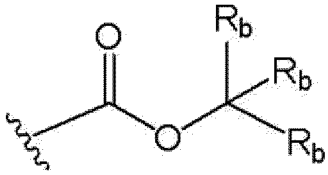
(d-1)

In Formula (d-1),

$R_b$'s each independently represent a hydrogen atom, an alkyl group (preferably having 1 to 10 carbon atoms), a cycloalkyl

group (preferably having 3 to 30 carbon atoms), an aryl group (preferably having 3 to 30 carbon atoms), an aralkyl group (preferably having 1 to 10 carbon atoms), or an alkoxyalkyl group (preferably having 1 to 10 carbon atoms). $R_b$'s may be linked to each other to form a ring.

The alkyl group, the cycloalkyl group, the aryl group, and the aralkyl group represented by $R_b$ may be each independently substituted with a functional group such as a hydroxyl group, a cyano group, an amino group, a pyrrolidino group, a piperidino group, a morpholino group, and an oxo group, an alkoxy group, or a halogen atom. The same applies to the alkoxyalkyl group represented by $R_b$.

$R_b$ is preferably a linear or branched alkyl group, a cycloalkyl group, or an aryl group, and more preferably a linear or branched alkyl group or a cycloalkyl group.

Examples of the ring formed by linking two $R_b$'s to each other include an alicyclic hydrocarbon, an aromatic hydrocarbon, a heterocyclic hydrocarbon, and a derivative thereof.

It is preferable that the compound (CD) has a structure represented by Formula (6).

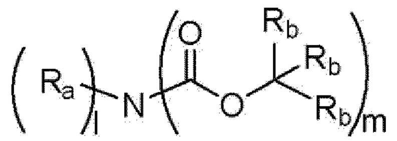

(6)

In Formula (6),
l represents an integer of 0 to 2, m represents an integer of 1 to 3, and l + m satisfies 3.

$R_a$ represents a hydrogen atom, an alkyl group, a cycloalkyl group, an aryl group, or an aralkyl group. In a case where l is 2, two $R_a$'s may be the same or different from each other, and two $R_a$'s may be linked to each other to form a hetero ring with the nitrogen atom in the formula. The hetero ring may include a heteroatom other than the nitrogen atom in the formula.

$R_b$ has the same meaning as $R_b$ in Formula (d-1) described above, and a suitable aspect thereof is also the same.

In Formula (6), the alkyl group, the cycloalkyl group, the aryl group, and the aralkyl group as $R_a$ may be each independently substituted with a group same as the above-described group which may be substituted on the alkyl group, the cycloalkyl group, the aryl group, and the aralkyl group as $R_b$.

Specific examples of the alkyl group, the cycloalkyl group, the aryl group, and the aralkyl group (these groups may be substituted with the above-described group) of $R_a$ include a group same as in the specific examples described above for $R_b$.

In addition, specific examples of the basic compound (CA) include compounds described in paragraphs [0132] to [0136] of WO2020/066824A; specific examples of the basic compound (CB) in which basicity decreases or disappears in a case of being irradiated with actinic ray or radiation include compounds described in paragraphs [0137] to [0155] of WO2020/066824A; specific examples of the low-molecular-weight compound (CD) having a nitrogen atom and a group which is eliminated by action of acid include paragraphs [0156] to [0163] of WO2020/066824A; and specific examples of the onium salt compound (CE) having a nitrogen atom in the cationic moiety include paragraph [0164] of WO2020/066824A.

In addition, examples thereof also include an onium salt compound (CC) which is a relatively weak acid with respect to the photoacid generator, and specific examples thereof include compounds described in paragraphs [0305] to [0314] of WO2020/158337A.

In addition to above, for example, as the acid diffusion control agent, known compounds described in paragraphs [0627] to [0664] of US2016/0070167A1, paragraphs [0095] to [0187] of US2015/0004544A1, paragraphs [0403] to [0423] of US2016/0237190A1, and paragraphs [0259] to [0328] of US2016/0274458A1 can be suitably used.

Examples of the specific acid diffusion control agent include the following compounds.

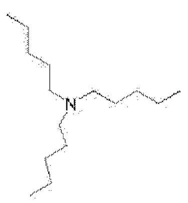

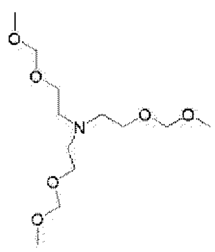

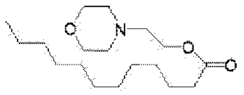
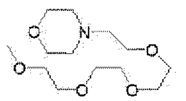

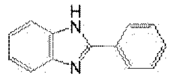
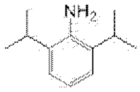
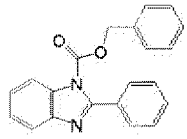

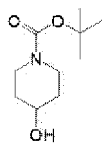
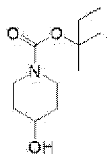
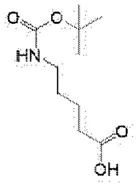
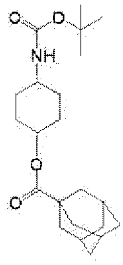

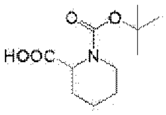
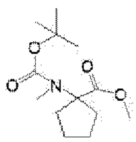

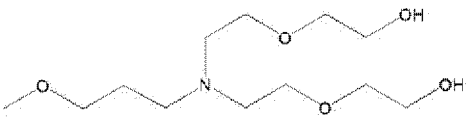

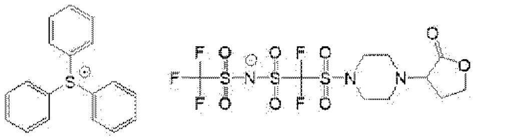

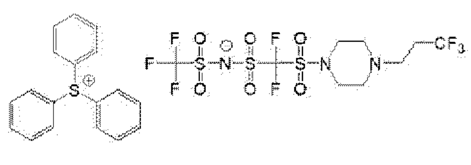

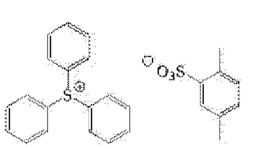
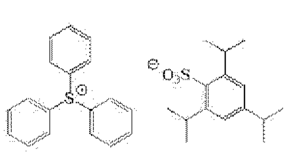
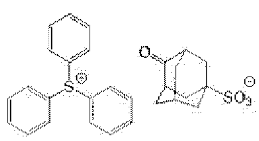

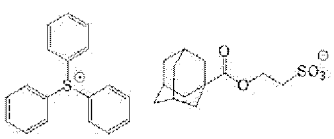
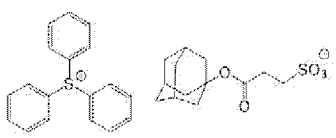
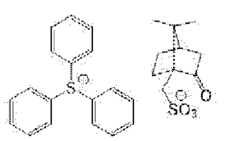

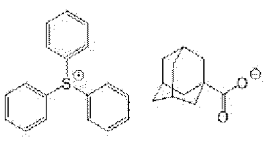
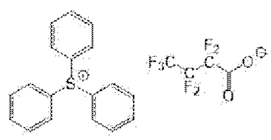
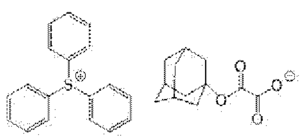

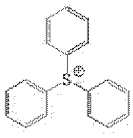
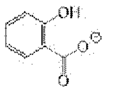
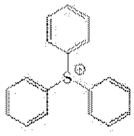
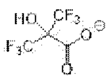
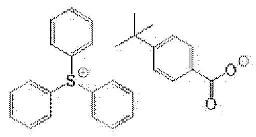

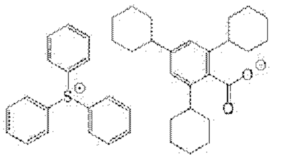
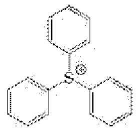
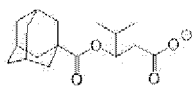

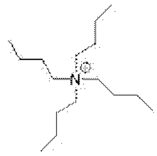
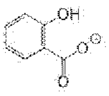
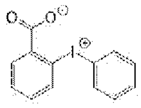

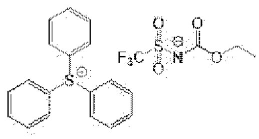
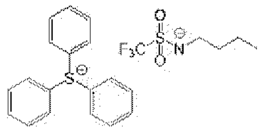
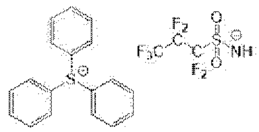

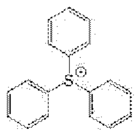
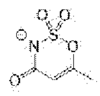

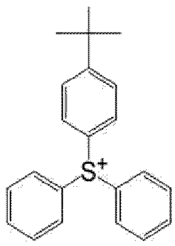
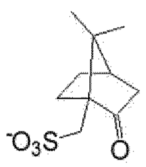
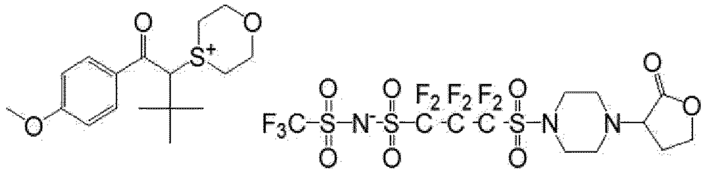

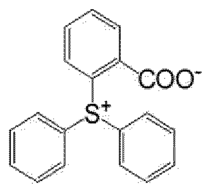
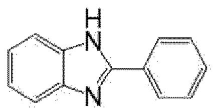
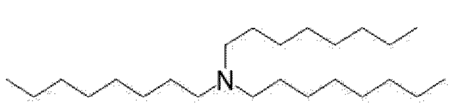

The specific acid diffusion control agent may be used alone or in combination of two or more kinds thereof.

In a case where the resist composition contains the specific acid diffusion control agent, a content of the specific acid diffusion control agent (in a case of a plurality of types, the total thereof) is preferably 0.1% to 50.0% by mass, more preferably 1.0% to 40.0% by mass, and still more preferably 5.0% to 30.0% by mass with respect to the total solid content of the resist composition.

<Hydrophobic Resin (D)>

The resist composition may further contain a hydrophobic resin different from the resin A.

Although it is preferable that the hydrophobic resin is designed to be unevenly distributed on a surface of the

resist film, it is not necessary to have a hydrophilic group in the molecule as different from a surfactant, and is not necessary to contribute to uniform mixing of polar materials and non-polar materials.

Examples of an effect caused by the addition of the hydrophobic resin include a control of static and dynamic contact angles of a surface of the resist film with respect to water and suppression of outgas.

From the viewpoint of uneven distribution on the film surface layer, the hydrophobic resin preferably has any one or more of a fluorine atom, a silicon atom, and a $CH_3$ partial structure which is included in a side chain moiety of a resin, and more preferably has two or more kinds thereof. In addition, the above-described hydrophobic resin preferably has a hydrocarbon group having 5 or more carbon atoms. These groups may be included in the main chain of the resin or may be substituted in the side chain of the resin.

Examples of the hydrophobic resin include compounds described in paragraphs [0275] to [0279] of WO2020/004306A.

The hydrophobic resin may be used alone or in combination of two or more kinds thereof.

In a case where the resist composition contains a hydrophobic resin, a content of the hydrophobic resin is preferably 0.01% to 20.0% by mass, and more preferably 0.1% to 15.0% by mass with respect to the total solid content of the resist composition.

<Surfactant (E)>

The resist composition may contain a surfactant.

In a case where the surfactant is contained, it is possible to form a pattern having more excellent adhesiveness and fewer development defects.

The surfactant is preferably a fluorine-based and/or silicon-based surfactant, and from the viewpoint of environmental regulation, more preferably a silicon-based surfactant.

Examples of the fluorine-based and/or silicon-based surfactant include the surfactants disclosed in paragraphs [0218] and [0219] of WO2018/19395A.

The surfactant may be used alone or in combination of two or more kinds thereof.

In a case where the resist composition contains a surfactant, a content of the surfactant is preferably 0.0001% to 2.0% by mass, more preferably 0.0005% to 1.0% by mass, and still more preferably 0.1% to 1.0% by mass with respect to the total solid content of the resist composition.

<Solvent (F)>

The resist composition preferably contains a solvent.

The solvent preferably includes at least one solvent of (M1) propylene glycol monoalkyl ether carboxylate or (M2) at least one selected from the group consisting of propylene glycol monoalkyl ether, lactic acid ester, acetic acid ester, alkoxypropionic acid ester, chain ketone, cyclic ketone, lactone, and alkylene carbonate. The above-described solvent may further include a component other than the components (M1) and (M2).

The present inventors have found that, by using such a solvent and the above-described resin in combination, a pattern having a small number of development defects can be formed while improving coating property of the resist composition. A reason for this is not always clear, but the present inventors have considered that, since these solvents have a good balance of solubility, boiling point, and viscosity of the above-described resin, unevenness of a film thickness of a resist film, generation of precipitates during spin coating, and the like can be suppressed.

Details of the component (M1) and the component (M2) are described in paragraphs [0218] to [0226] of WO2020/004306A, the contents of which are incorporated herein by reference.

In a case where the solvent further contains a component other than the components (M1) and (M2), a content of the component other than the components (M1) and (M2) is preferably 5% to 30% by mass with respect to the total mass of the solvent.

A content of the solvent in the resist composition is preferably set such that the concentration of solid contents is 0.5% to 30% by mass, and more preferably set such that the concentration of solid contents is 1% to 20% by mass. With this content, the coating property of the resist composition can be further improved.

<Other Additives>

The resist composition may further contain a resin other than the resin A, a dissolution inhibiting compound, a dye, a plasticizer, a photosensitizer, a light absorbing agent, and/or a compound promoting a solubility in a developer (for example, a phenol compound having a molecular weight of 1000 or less or an alicyclic or aliphatic compound including a carboxy group), or the like.

The resist composition may further contain a dissolution inhibiting compound. Here, the "dissolution inhibiting

compound" is intended to be a compound having a molecular weight of 3000 or less, in which solubility in an organic developer decreases by decomposition due to action of acid.

The resist composition according to the embodiment of the present invention is suitably used as a resist composition for EUV light or a resist composition for EB light.

In a case of the resist composition for EUV like, since the EUV light has a wavelength of 13.5 nm and has a shorter wavelength than that of ArF (wavelength: 193 nm), the number of incident photons in a case of being exposed with the same sensitivity is small. Therefore, influence of "photon shot noise" in which the number of photons varies probabilistically is large, and deterioration of LER and bridge defects are likely to occur. In order to reduce the photon shot noise, there is a method of increasing the number of incident photons by increasing an exposure amount, but there is a trade-off with the demand for higher sensitivity.

In a case where an A value obtained by Expression (1) is high, absorption efficiency of EUV light and electron beams of the resist film formed from the resist composition is high, which is effective in reducing the photon shot noise. The A value represents the absorption efficiency of EUV light and electron beams of the resist film in terms of a mass proportion.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

The A value is preferably 0.120 or more. In a case where the A value is extremely high, the transmittance of EUV light and electron beams of the resist film is lowered and the optical image profile in the resist film is deteriorated, which results in difficulty in obtaining a good pattern shape, so that the upper limit thereof is preferably 0.240 or less, and more preferably 0.220 or less.

In Expression (1), [H] represents a molar ratio of hydrogen atoms derived from a total solid content with respect to all atoms of the total solid content in the actinic ray-sensitive or radiation-sensitive resin composition, [C] represents a molar ratio of carbon atoms derived from the total solid content with respect to all atoms of the total solid content in the actinic ray-sensitive or radiation-sensitive resin composition, [N] represents a molar ratio of nitrogen atoms derived from the total solid content with respect to all atoms of the total solid content in the actinic ray-sensitive or radiation-sensitive resin composition, [O] represents a molar ratio of oxygen atoms derived from the total solid content with respect to all atoms of the total solid content in the actinic ray-sensitive or radiation-sensitive resin composition, [F] represents a molar ratio of fluorine atoms derived from the total solid content with respect to all atoms of the total solid content in the actinic ray-sensitive or radiation-sensitive resin composition, [S] represents a molar ratio of sulfur atoms derived from the total solid content with respect to all atoms of the total solid content in the actinic ray-sensitive or radiation-sensitive resin composition, and [I] represents a molar ratio of iodine atoms derived from the total solid content with respect to all atoms of the total solid content in the actinic ray-sensitive or radiation-sensitive resin composition.

For example, in a case where the resist composition contains the resin A, the other photoacid generator, the specific acid diffusion control agent, and the solvent, the resin A, the other photoacid generator, and the specific acid diffusion control agent described above correspond to the solid content. That is, all the atoms of the total solid content correspond to a sum of all the atoms derived from the above-described resin A, all the atoms derived from the above-described other photoacid generator, and all the atoms derived from the above-described specific acid diffusion control agent.

For example, [H] represents a molar ratio of hydrogen atoms derived from the total solid content with respect to all the atoms in the total solid content, and by way of description based on the example above, [H] represents a molar ratio of a sum of the hydrogen atoms derived from the above-described resin A, the hydrogen atoms derived from the above-described other photoacid generator, and the hydrogen atoms derived from the above-described specific acid diffusion control agent with respect to a sum of all the atoms derived from the above-described resin A, all the atoms derived from the above-described other photoacid generator, and all the atoms derived from the above-described specific acid diffusion control agent.

The A value can be calculated by computation of the structure of constituent components of the total solid content in the resist composition, and the ratio of the number of atoms contained in a case where the content is already known. In addition, even in a case where the constituent component is not known yet, it is possible to calculate a ratio of the number of constituent atoms by subjecting a resist film obtained after evaporating the solvent components of the resist composition to computation according to an analytic approach such as elemental analysis.

<Resist Film and Pattern Forming Method>

A procedure of the pattern forming method using the above-described resist composition preferably has the

following steps.

Step 1: step of forming a resist film on a substrate using the resist composition
Step 2: step of exposing the resist film
Step 3: step of developing the exposed resist film using a developer

Hereinafter, the procedure of each of the above-described steps will be described in detail.

(Step 1: Resist Film Forming Step)

The step 1 is a step of forming a resist film on a substrate using the resist composition.
The definition of the resist composition is as described above.
Examples of a method for forming a resist film on a substrate using the resist composition include a method in which a resist composition is applied to a substrate.
In addition, it is preferable that the resist composition before the application is filtered through a filter, as desired. A pore size of the filter is preferably 0.1 μm or less, more preferably 0.05 μm or less, and still more preferably 0.03 μm or less. The lower limit thereof is preferably 0.01 μm or more. In addition, the filter is preferably a polytetrafluoroethylene-made filter, a polyethylene-made filter, or a nylon-made filter.
The resist composition can be applied to a substrate (for example, silicon and silicon dioxide coating) as used in the manufacture of integrated circuit elements by a suitable application method such as an application using a spinner or a coater. The application method is preferably a spin coating using a spinner. A rotation speed upon the spin coating using a spinner is preferably 1000 to 3000 rpm.
After the application of the resist composition, the substrate may be dried to form a resist film. In addition, various underlying films (an inorganic film, an organic film, or an antireflection film) may be formed on an underlayer of the resist film.
Examples of the drying method include a method of heating and drying. The heating can be carried out using a unit included in an ordinary exposure machine and/or development machine, and may also be carried out using a hot plate or the like. A heating temperature is preferably 80°C to 150°C, more preferably 80°C to 140°C, and still more preferably 80°C to 130°C. A heating time is preferably 30 to 1000 seconds, more preferably 60 to 800 seconds, and still more preferably 60 to 600 seconds.
From the viewpoint that a fine pattern having higher accuracy can be formed, a film thickness of the resist film is preferably 10 to 120 nm. Among these, in a case of performing EUV exposure, the film thickness of the resist film is more preferably 10 to 65 nm and still more preferably 15 to 50 nm. In addition, in a case of performing ArF liquid immersion exposure, the film thickness of the resist film is more preferably 10 to 120 nm and still more preferably 15 to 90 nm.
A topcoat may be formed on an upper layer of the resist film using a topcoat composition.
It is preferable that the topcoat composition is not mixed with the resist film and can be uniformly applied to the upper layer of the resist film. The topcoat is not particularly limited, a topcoat known in the related art can be formed by the methods known in the related art, and for example, the topcoat can be formed based on the description in paragraphs [0072] to [0082] of JP2014-059543A.
For example, it is preferable that a topcoat including a basic compound as described in JP2013-61648A is formed on the resist film. Specific examples of the basic compound which can be included in the topcoat include a basic compound which may be included in the resist composition.
In addition, it is also preferable that the topcoat includes a compound which includes at least one group or bond selected from the group consisting of an ether bond, a thioether bond, a hydroxyl group, a thiol group, a carbonyl bond, and an ester bond.

(Step 2: Exposing Step)

The step 2 is a step of exposing the resist film.
Examples of an exposing method include a method in which the formed resist film is irradiated with actinic ray or radiation through a predetermined mask.
Examples of the actinic ray or radiation include infrared light, visible light, ultraviolet light, far ultraviolet light, extreme ultraviolet light, X-rays, and electron beams, preferably a far ultraviolet light having a wavelength of 250 nm or less, more preferably a far ultraviolet light having a wavelength of 220 nm or less, and particularly preferably a far ultraviolet light having a wavelength of 1 to 200 nm, specifically, KrF excimer laser (248 nm), ArF excimer laser (193 nm), $F_2$ excimer laser (157 nm), EUV (13 nm), X-rays, and electron beams.
Examples of the method of radiating the actinic ray or radiation include a method using an electron beam, and a method using a single electron beam or a multi-electron beam is preferable.

Among these, from the viewpoint of shortening drawing time and excellent pattern shape (resolution, roughness performance, and the like), the exposing step is preferably a step of exposing using a multi-electron beam.
Examples of a drawing apparatus using the multi-electron beam include JP2020-136289A and JP2020-145401A.
It is preferable to perform baking (heating) before performing development and after the exposure. The baking accelerates a reaction in the exposed portion, and the sensitivity and the pattern shape are improved.
A heating temperature is preferably 80°C to 150°C, more preferably 80°C to 140°C, and still more preferably 80°C to 130°C.
A heating time is preferably 10 to 1000 seconds, more preferably 10 to 180 seconds, and still more preferably 30 to 120 seconds.
The heating can be carried out using a unit included in an ordinary exposure machine and/or development machine, and may also be performed using a hot plate or the like. This step is also referred to as a post-exposure baking.

(Step 3: Developing Step)

The step 3 is a step of developing the exposed resist film using a developer to form a pattern.
The developer may be either an alkali developer or a developer including an organic solvent (hereinafter, also referred to as "organic developer").
Examples of a developing method include a method in which the substrate is immersed in a tank filled with a developer for a certain period of time (a dipping method), a method in which a development is performed by heaping a developer up onto the surface of the substrate by surface tension, and then leaving it to stand for a certain period of time (a puddle method), a method in which a developer is sprayed on the surface of the substrate (a spraying method), and a method in which a developer is continuously jetted onto the substrate rotating at a constant rate while scanning a developer jetting nozzle at a constant rate (a dynamic dispensing method).
In addition, after the step of performing the development, a step of stopping the development may be carried out while replacing the solvent with another solvent.
A developing time is not particularly limited as long as it is a period of time where the non-exposed portion of the resin is sufficiently dissolved, and is preferably 10 to 300 seconds and more preferably 20 to 120 seconds.
A temperature of the developer is preferably 0°C to 50°C and more preferably 15°C to 35°C.
As the alkali developer, it is preferable to use an aqueous alkali solution including an alkali. Examples of the type of the aqueous alkali solution include an aqueous alkali solution including a quaternary ammonium salt typified by tetramethylammonium hydroxide, an inorganic alkali, a primary amine, a secondary amine, a tertiary amine, an alcoholamine, a cyclic amine, or the like. Among these, the alkali developer is preferably aqueous solutions of the quaternary ammonium salts typified by tetramethylammonium hydroxide (TMAH). An appropriate amount of alcohols, a surfactant, or the like may be added to the alkali developer. An alkali concentration of the alkali developer is usually 0.1% to 20% by mass. In addition, a pH of the alkali developer is usually 10.0 to 15.0.
The organic developer is preferably a developer containing at least one organic solvent selected from the group consisting of a ketone-based solvent, an ester-based solvent, an alcohol-based solvent, an amide-based solvent, an ether-based solvent, and a hydrocarbon-based solvent.
A plurality of the above-described solvents may be mixed, or the solvent may be used in admixture with a solvent other than those described above or water. A moisture content in the entire developer is preferably less than 50% by mass, more preferably less than 20% by mass, and still more preferably less than 10% by mass, and it is particularly preferable that the entire developer contains substantially no water.
A content of the organic solvent with respect to the organic developer is preferably 50% to 100% by mass, more preferably 80% to 100% by mass, still more preferably 90% to 100% by mass, and particularly preferably 95% to 100% by mass with respect to the total mass of the developer.

(Other Steps)

It is preferable that the above-described pattern forming method includes a step of performing washing using a rinsing liquid after the step 3.
Examples of the rinsing liquid used in the rinsing step after the step of performing development using an alkali developer include pure water. An appropriate amount of a surfactant may be added to the pure water.
An appropriate amount of a surfactant may be added to the rinsing liquid.
The rinsing liquid used in the rinsing step after the developing step with an organic developer is not particularly limited as long as the rinsing liquid does not dissolve the pattern, and a solution including a common organic solvent can be used. As the rinsing liquid, a rinsing liquid containing at least one organic solvent selected from the group consisting of a hydrocarbon-based solvent, a ketone-based solvent, an ester-based solvent, an alcohol-based solvent,

an amide-based solvent, and an ether-based solvent is preferably used.

A method for the rinsing step is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

In addition, the pattern forming method according to the embodiment of the present invention may include a heating step (postbaking) after the rinsing step. By this step, the developer and the rinsing liquid remaining between and inside the patterns are removed by baking. In addition, this step also has an effect that a resist pattern is annealed and the surface roughness of the pattern is improved. The heating step after the rinsing step is usually performed at 40°C to 250°C (preferably 90°C to 200°C) for usually 10 seconds to 3 minutes (preferably 30 seconds to 120 seconds).

In addition, an etching treatment on the substrate may be carried out using the formed pattern as a mask.

That is, the substrate (or the underlayer film and the substrate) may be processed using the pattern formed in the step 3 as a mask to form a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern formed in the step 3 as a mask is preferable. Oxygen plasma etching is preferable as the dry etching.

It is preferable that various materials (for example, the solvent, the developer, the rinsing liquid, a composition for forming the antireflection film, a composition for forming the topcoat, and the like) used in the resist composition and the pattern forming method according to the embodiment of the present invention do not include impurities such as metals. A content of the impurities included in these materials is preferably 1 ppm by mass or less, more preferably 10 ppb by mass or less, still more preferably 100 ppt by mass or less, particularly preferably 10 ppt by mass or less, and most preferably 1 ppt by mass or less. The lower limit thereof is not particularly limited, but is preferably 0 ppt by mass or more. Here, examples of the metal impurities include Na, K, Ca, Fe, Cu, Mg, Al, Li, Cr, Ni, Sn, Ag, As, Au, Ba, Cd, Co, Pb, Ti, V, W, and Zn.

Examples of a method for removing the impurities such as metals from the various materials include filtration using a filter. Details of the filtration using a filter are described in paragraph [0321] of WO2020/004306A.

In addition, examples of a method for reducing the impurities such as metals included in the various materials include a method of selecting raw materials having a low content of metals as raw materials constituting the various materials, a method of subjecting raw materials constituting the various materials to filter filtration, and a method of performing distillation under the condition for suppressing the contamination as much as possible by, for example, lining the inside of a device with TEFLON (registered trademark).

In addition to the filter filtration, removal of the impurities by an adsorbing material may be performed, or a combination of filter filtration and an adsorbing material may be used. As the adsorbing material, known adsorbing materials can be used, and for example, inorganic adsorbing materials such as silica gel and zeolite and organic adsorbing materials such as activated carbon can be used. It is necessary to prevent the incorporation of impurities such as metals in the production process in order to reduce the metal impurities included in the above-described various materials. Sufficient removal of the metal impurities from a production device can be confirmed by measuring the content of metal components included in a washing solution used to wash the production device. A content of the metal components included in the washing solution after the use is preferably 100 parts per trillion (ppt) by mass or less, more preferably 10 ppt by mass or less, and still more preferably 1 ppt by mass or less. The lower limit thereof is not particularly limited, but is preferably 0 ppt by mass or more.

A conductive compound may be added to an organic treatment liquid such as the rinsing liquid in order to prevent breakdown of chemical liquid pipes and various parts (a filter, an O-ring, a tube, and the like) due to electrostatic charging, and subsequently generated electrostatic discharging. Examples of the conductive compound include methanol. From the viewpoint that preferred development characteristics or rinsing characteristics are maintained, an addition amount thereof is preferably 10% by mass or less and more preferably 5% by mass or less. The lower limit thereof is not particularly limited, but is preferably 0.01% by mass or more.

For members of the chemical liquid pipe, for example, various pipes coated with stainless steel (SUS), or a polyethylene, polypropylene, or a fluororesin (a polytetrafluoroethylene resin, a perfluoroalkoxy resin, or the like) that has been subjected to an antistatic treatment can be used. In the same manner, for the filter or the O-ring, polyethylene, polypropylene, or a fluororesin (a polytetrafluoroethylene resin, a perfluoroalkoxy resin, or the like) that has been subjected to an antistatic treatment can be used.

<Method for Manufacturing Electronic Device>

In addition, the present invention further relates to a method for manufacturing an electronic device, including the above-described pattern forming method, and an electronic device manufactured by this manufacturing method.

Examples of a suitable aspect of the electronic device according to the embodiment of the present invention include an aspect of being mounted on electric and electronic apparatus (for example, home appliances, office automation (OA)-related equipment, media-related equipment, optical equipment, telecommunication equipment, and the like).

## Examples

Hereinbelow, the present invention will be described in more detail with reference to Examples.

The materials, the amounts of materials used, the proportions, the treatment details, the treatment procedure, and the like shown in Examples below may be appropriately modified as long as the modifications do not depart from the spirit of the present invention. Therefore, the scope of the present invention should not be construed as being limited to Examples shown below.

[Each Component of Resist Composition]

Each component contained in the resist composition used in Examples and Comparative Examples is shown below.

[Resin]

A resin A-1 was synthesized by the following synthesis method. Other resins were synthesized with reference to the synthesis method of the resin A-1. In addition, monomers used for each resin are shown below.

<Synthesis Example 1: Synthesis of Resin A-1>

Cyclohexanone (70 g) was heated to 85°C under a nitrogen stream. While stirring this liquid, a mixed solution of a monomer (60.1 g) represented by Formula M-1, a monomer (92.8 g) represented by Formula M-2, a monomer (23.0g) represented by Formula M-3, cyclohexanone (130 g), and dimethyl 2,2'-azobisisobutyrate [V-601, manufactured by FUJIFILM Wako Pure Chemical Corporation] (6.0 g) was added dropwise thereto over 3 hours to obtain a reaction solution. After completion of dropwise addition, the reaction solution was further stirred at 85°C for 3 hours. The obtained reaction solution was cooled, then reprecipitated with 5000 g of ethyl acetate/heptane (mass ratio: 1:9), and filtered, and the obtained solid was vacuum-dried to obtain the resin A-1 (110 g). However, all the above-described operations were carried out under a yellow light.

In the following, the content of the repeating unit is a molar ratio.

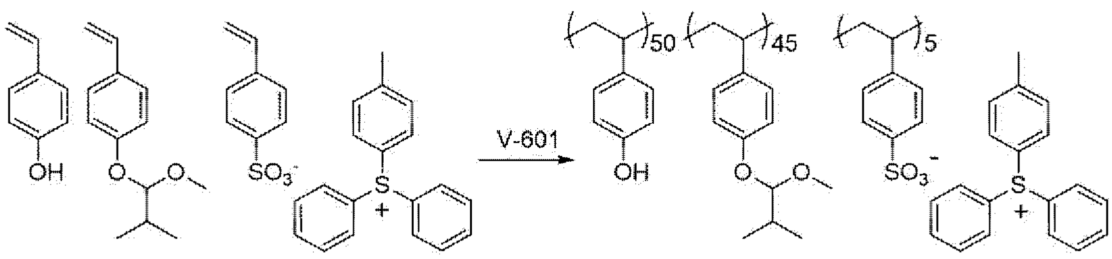


(M-1) (M-2) (M-3)

(A-1)

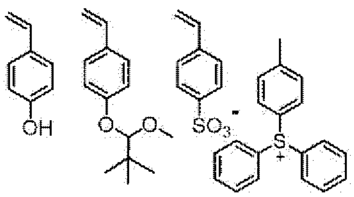

A-1

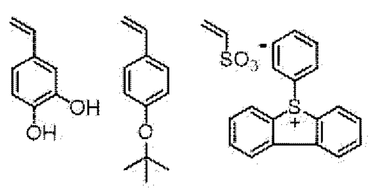

A-2

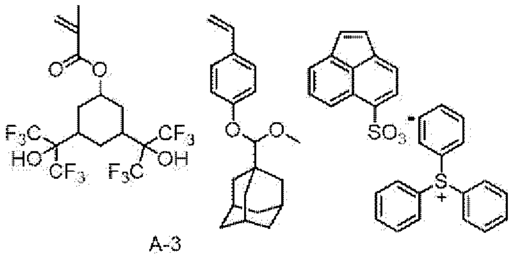

A-3

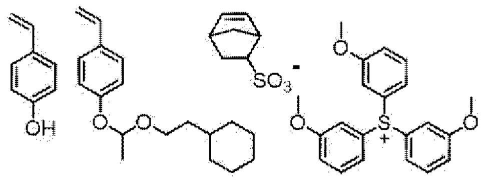

A-4

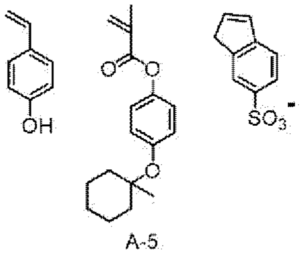

A-5

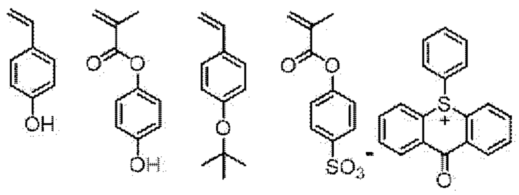

A-6

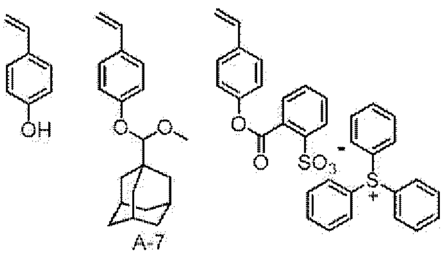

A-7

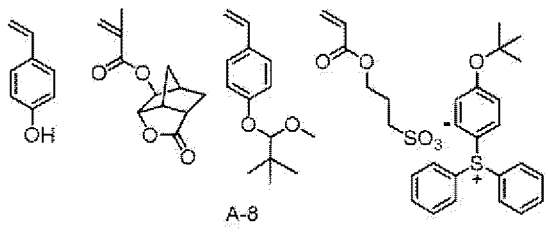

A-8

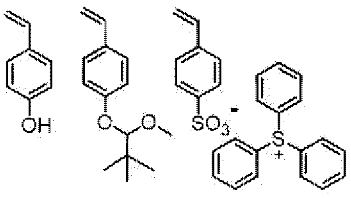

A-9

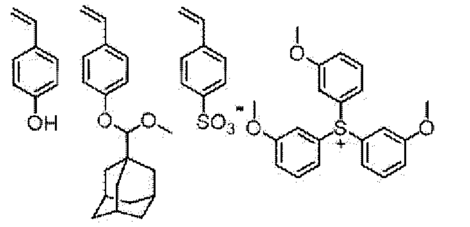

A-10

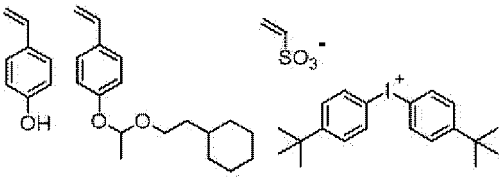

A-11

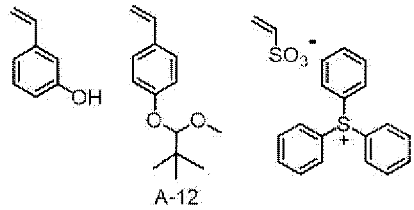

A-12

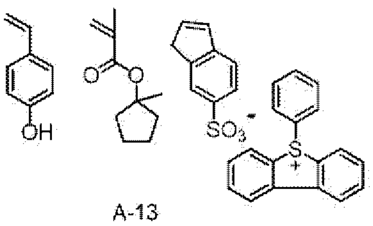

A-13

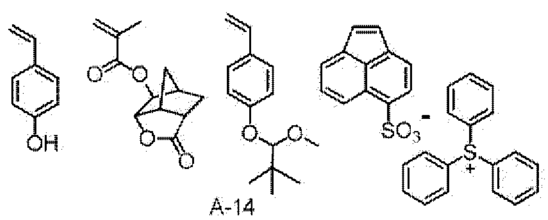

A-14

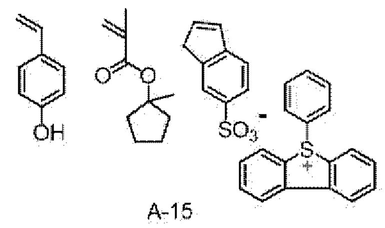

A-15

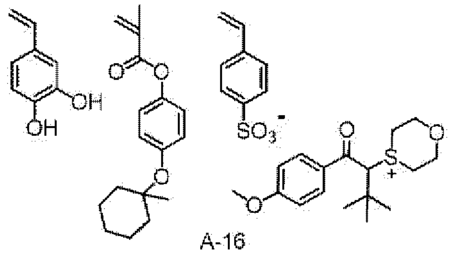

A-16

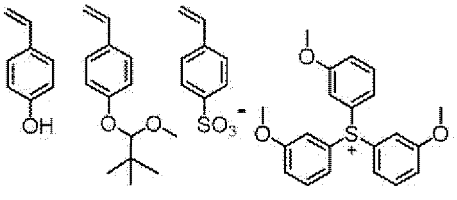

A-17

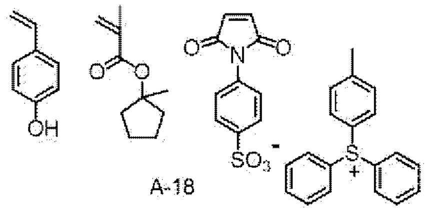

A-18

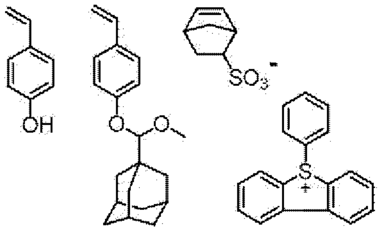

A-19

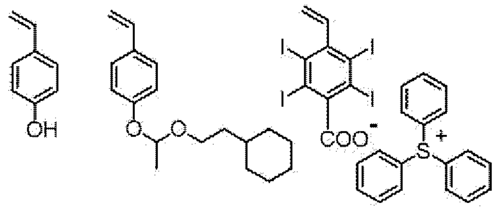

A-20

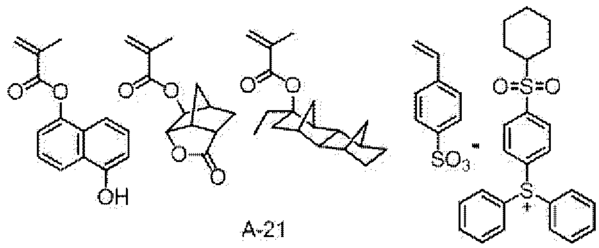

A-21

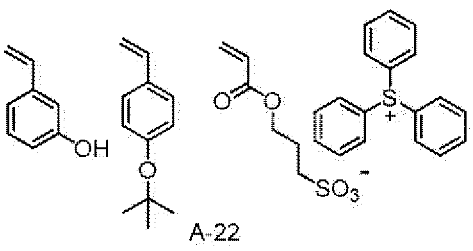

A-22

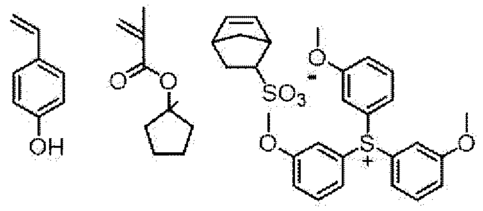

A-23

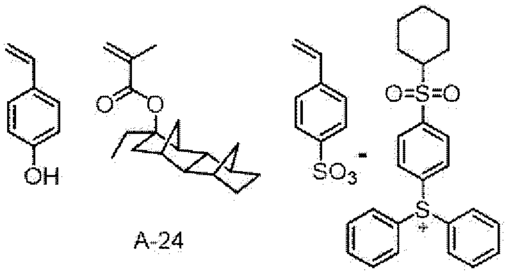

A-24

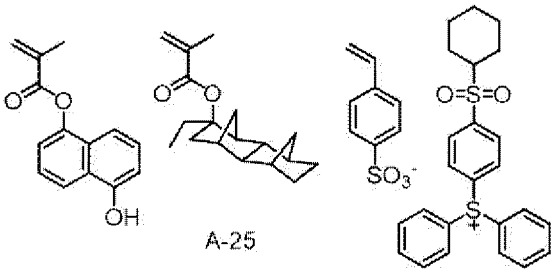

A-25

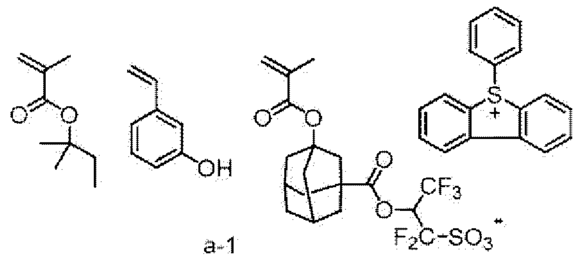

a-1

In the table, the compositional ratio of each repeating unit corresponds to the repeating unit 1, the repeating unit 2, the repeating unit 3, and the repeating unit 4 in order from the left of the monomer used in each of the resins shown above.

[Table 1]

| Resin | Compositional ratio mol% | | | | Weight-average molecular weight | Dispersity |
|---|---|---|---|---|---|---|
| | Repeating unit 1 | Repeating unit 2 | Repeating unit 3 | Repeating unit 4 | | |
| A-1 | 50.0 | 45.0 | 5.0 | - | 11000 | 1.59 |
| A-2 | 50.0 | 45.0 | 5.0 | - | 13500 | 1.77 |
| A-3 | 50.0 | 45.0 | 5.0 | - | 13700 | 1.72 |
| A-4 | 50.0 | 45.0 | 5.0 | - | 12000 | 1.68 |
| A-5 | 50.0 | 45.0 | 5.0 | - | 12800 | 1.50 |
| A-6 | 30.0 | 20.0 | 45.0 | 5.0 | 13100 | 1.60 |
| A-7 | 50.0 | 45.0 | 5.0 | - | 12700 | 1.61 |
| A-8 | 30.0 | 20.0 | 45.0 | 5.0 | 13600 | 1.58 |
| A-9 | 50.0 | 45.0 | 5.0 | - | 12000 | 1.66 |
| A-10 | 50.0 | 45.0 | 5.0 | - | 12500 | 1.65 |
| A-11 | 50.0 | 45.0 | 5.0 | - | 13100 | 1.70 |
| A-12 | 35.0 | 50.0 | 15.0 | - | 12300 | 1.62 |
| A-13 | 25.0 | 55.0 | 20.0 | - | 12600 | 1.68 |
| A-14 | 30.0 | 55.0 | 15.0 | - | 14000 | 1.66 |
| A-15 | 30.0 | 55.0 | 15.0 | - | 13200 | 1.61 |
| A-16 | 40.0 | 55.0 | 5.0 | - | 13400 | 1.77 |
| A-17 | 40.0 | 55.0 | 5.0 | - | 12700 | 1.60 |
| A-18 | 50.0 | 45.0 | 5.0 | - | 13300 | 1.77 |
| A-19 | 50.0 | 45.0 | 5.0 | - | 12000 | 1.61 |
| A-20 | 50.0 | 45.0 | 5.0 | - | 12200 | 1.66 |
| A-21 | 21.0 | 32.0 | 39.0 | 8.0 | 13600 | 1.62 |
| a-1 | 35.0 | 50.0 | 15.0 | - | 13300 | 1.63 |
| A-22 | 35.0 | 50.0 | 15.0 | - | 13400 | 1.66 |
| A-23 | 35.0 | 50.0 | 15.0 | - | 13800 | 1.68 |
| A-24 | 43.0 | 55.0 | 2.0 | - | 13700 | 1.70 |
| A-25 | 10.0 | 30.0 | 60.0 | - | 14000 | 1.66 |

[Other Photoacid Generators]

| | |
|---|---|
| P-1 | 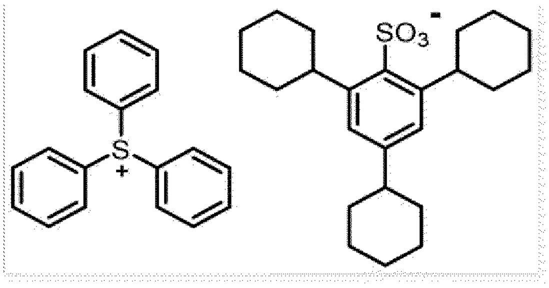 |
| P-2 | 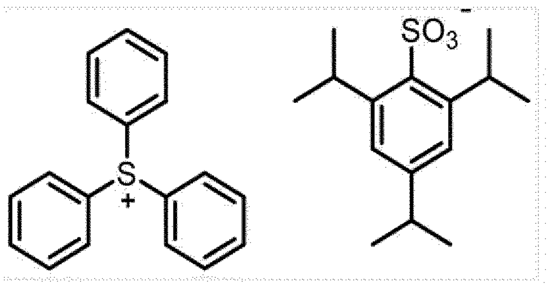 |
| P-3 | 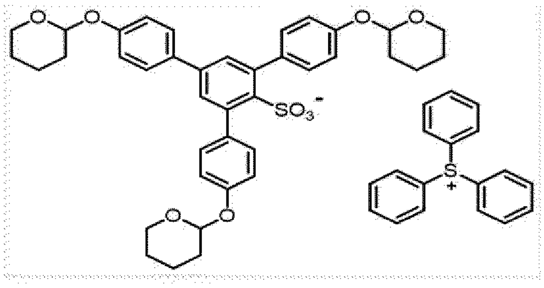 |

[Acid Diffusion Control Agent]

| | | | |
|---|---|---|---|
| Q-1 | 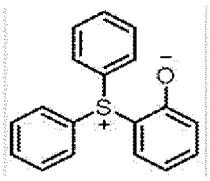 | Q-8 | 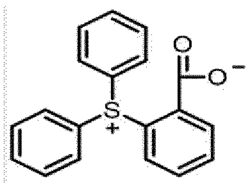 |
| Q-2 | 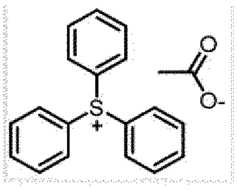 | Q-9 | 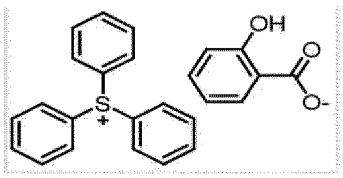 |

(continued)

| | | | |
|---|---|---|---|
| Q-3 | 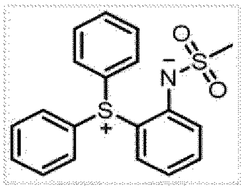 | Q-10 | 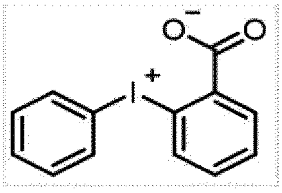 |
| Q-4 | 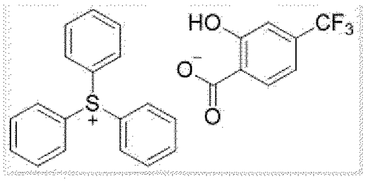 | Q-11 | 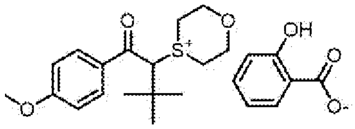 |
| Q-5 | 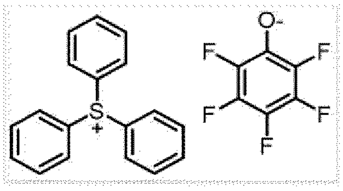 | Q-12 | 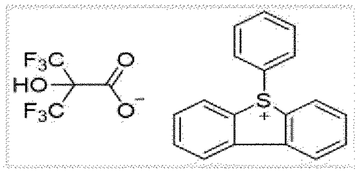 |
| Q-6 | 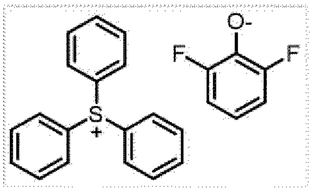 | Q-13 | 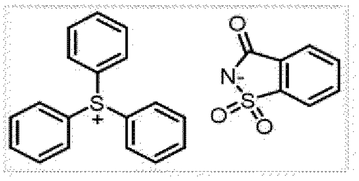 |
| Q-7 | 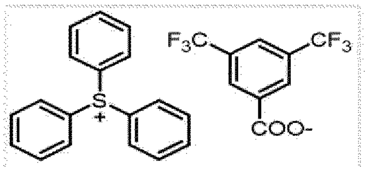 | | |

[Surfactant]

· W-1: MEGAFACE R-41 (manufactured by DIC CORPORATION)
· W-2: PolyFox PF-6320 (manufactured by OMNOVA Solutions Inc.; fluorine-based)

[Solvent]

· EL: Ethyl lactate
· PGMEA: Propylene glycol monomethyl ether acetate
· PGME: Propylene glycol monomethyl ether
. γ-BL: γ-Butyrolactone
· CyHx: Cyclohexanone

[Test]

[Preparation and Coating of Coating Liquid of Resist Composition]

(1) Preparation of Support

An 8-inch wafer on which Cr oxynitride had been vapor-deposited (a product for which a shielding film treatment used for an ordinary photo mask blank had been carried out) was prepared.

(2) Preparation of Resist Composition

A solution was prepared by dissolving components shown below in the solvent shown in the same table, and filtered through a polyethylene filter having a pore size of 0.03 μm to prepare a resist composition.

(3) Production of Resist Film

A resist composition was applied onto the 8-inch wafer using a spin coater Mark8 manufactured by Tokyo Electron Limited, and dried on a hot plate at 120°C for 600 seconds to obtain a resist film having a film thickness of 100 nm. 1 inch is 25.4 mm.

(4) Production of Resist Pattern

The resist film obtained in (3) was subjected to pattern irradiation using an electron beam drawing apparatus (manufactured by Advantest Corporation; F7000S, accelerating voltage: 50 KeV). After the irradiation, the resist film was heated on a hot plate at a temperature of 100°C for 600 seconds, immersed in a 2.38% by mass tetramethylammonium (TMAH) aqueous solution for 60 seconds, rinsed with water for 30 seconds, and then dried.

[Evaluation]

(5) Evaluation of Resist Pattern

The obtained pattern was evaluated for IS resolution and roughness performance (LWR) by the following methods. The results are shown in the tables below.

<Isolated Space Pattern (IS) Resolution>

First, the irradiation energy upon resolution of a 1:1 line-and-space pattern with a line width of 50 nm was defined as a sensitivity (Eop).
A critical resolving power (a minimum space width at which lines and spaces are separated and resolved) of an isolated space (line:space = 100:1) at the sensitivity (Eop) was determined. The value was defined as "IS resolution (nm)". As the value is smaller, the performance is better.

<LWR (Roughness Performance)>

In a case where a 20 nm (1:1) line-and-space pattern resolved with an optimum exposure amount upon resolving a line pattern having an average line width of 30 nm was observed from the upper part of the pattern using a length-measuring scanning electron microscope (SEM (S-9380II manufactured by Hitachi, Ltd.)), the line width was observed at any points, and a measurement variation thereof was evaluated as 3σ (nm). As the value is smaller, the performance is better.
The compounding amounts and evaluation results are shown in the tables below.
In Table 2, the unit of the content in each component is % by mass.
The mixing ratio of each solvent in "Solvent" is a mass ratio.
The column of "Concentration of solid contents" indicates the concentration of solid contents (% by mass) of the resist composition.
In Table 3, the column of "pKa" in "Resin" indicates the pKa of the photoacid generating group in the repeating unit a.
The column of "pKa" in "Acid diffusion control agent" indicates the pKa of the acid diffusion control agent.
The column of "Content a" indicates the content (mmol/g) of the repeating unit a per total solid content mass

of the resist composition.

The column of "$\Delta$pka" indicates a value calculated by (pKa of acid diffusion control agent) - (pKa of photoacid generating group in repeating unit a).

[Table 2]

| Resist composition | Resin | | Acid diffusion control agent | | Other photoacid generator | | Surfactant | | Solvent | Concentration of solid contents |
|---|---|---|---|---|---|---|---|---|---|---|
| | Type | Content | Type | Content | Type | Content | Type | Content | | |
| R-1 | A-1 | 94.5 | Q-1 | 5.5 | - | - | - | - | EL/PGMEA/PGME = 6/2/2 | 3 |
| R-2 | A-2 | 92.0 | Q-2 | 8.0 | - | - | - | - | EL/PGMEA/PGME = 6/2/2 | 3 |
| R-3 | A-3 | 89.0 | Q-3 | 11.0 | - | - | - | - | EL/PGMEA/PGME = 6/2/2 | 3 |
| R-4 | A-4 | 88.0 | Q-4 | 12.0 | - | - | - | - | EL/PGMEA/PGME = 6/2/2 | 3 |
| R-5 | A-5 | 89.0 | Q-5 | 11.0 | - | - | - | - | EL/PGMEA/PGME = 6/2/2 | 3 |
| R-6 | A-6 | 91.0 | Q-6 | 9.0 | - | - | - | - | EL/PGMEA/PGME = 6/2/2 | 3 |
| R-7 | A-7 | 88.0 | Q-7 | 12.0 | - | - | - | - | EL/PGMEA/PGME = 6/2/2 | 3 |
| R-8 | A-8 | 92.0 | Q-9 | 8.0 | - | - | - | - | EL/PGMEA/PGME = 6/2/2 | 3 |
| R-9 | A-9 | 81.0 | Q-9 | 14.0 | P-1 | 5.0 | - | - | EL/PGMEA/PGME = 6/2/2 | 3 |
| R-10 | A-10 | 91.0 | Q-5 | 9.0 | - | - | - | - | EL/PGMEA/PGME = 6/2/2 | 3 |
| R-11 | A-11 | 93.0 | Q-10 | 7.0 | - | - | - | - | EL/PGMEA/PGME = 6/2/2 | 3 |
| R-12 | A-12 | 80.0 | Q-9 | 20.0 | - | - | - | - | PGMEIr-BL = 8/2 | 3 |
| R-13 | A-13 | 75.0 | Q-2 | 25.0 | - | - | - | - | PGMEIr-BL = 8/2 | 3 |
| R-14 | A-14 | 70.0 | Q-6 | 25.0 | P-2 | 5.0 | - | - | PGMEIr-BL = 8/2 | 3 |
| R-15 | A-15 | 70.0 | Q-9 | 25.0 | P-3 | 5.0 | - | - | PGMEIr-BL = 8/2 | 3 |
| R-16 | A-16 | 87.0 | Q-11 | 12.0 | - | - | W-1 | 1.0 | EL/PGMEA = 8/2 | 3 |
| R-17 | A-17 | 89.0 | Q-7 | 10.0 | - | - | W-2 | 1.0 | EL/PGMEA = 8/2 | 3 |
| R-18 | A-18 | 92.0 | Q-2 | 8.0 | - | - | - | - | EL/PGMEA = 8/2 | 3 |
| R-19 | A-19 | 87.0 | Q-5 | 13.0 | - | - | - | - | EL/PGMEA = 8/2 | 3 |
| R-20 | A-20 | 91.0 | Q-6 | 9.0 | - | - | - | - | EL/PGMEA/PGME = 6/2/2 | 3 |
| r-1 | A-21 | 97.1 | Q-4 | 2.9 | - | - | - | - | CyHx/PGMEA = 7/3 | 3 |
| r-2 | a-1 | 94.3 | Q-12 | 5.7 | - | - | - | - | CyHx/PGMEA/r-BL = 4.5/4.5/1 | 3 |
| r-3 | A-22 | 95.0 | Q-13 | 5.0 | - | - | - | - | EL/PGMEA/PGME = 6/2/2 | 3 |

(continued)

| Resist composition | Resin | | Acid diffusion control agent | | Other photoacid generator | | Surfactant | | Solvent | Concentration of solid contents |
|---|---|---|---|---|---|---|---|---|---|---|
| | Type | Content | Type | Content | Type | Content | Type | Content | | |
| r-4 | A-23 | 85.0 | Q-8 | 15.0 | - | - | - | - | EL/PGMEA/PGME = 6/2/2 | 3 |
| r-5 | A-24 | 95.5 | Q-4 | 4.5 | - | - | - | - | EL/PGMEA/PGME = 6/2/2 | 3 |
| r-6 | A-25 | 65.0 | Q-7 | 35.0 | - | - | - | - | EL/PGMEA = 8/2 | 3 |

[Table 3]

| | Resist composition | Resin | | Acid diffusion control agent | | Other photoacid generator | Qp | Content a | Δpka | Evaluation result | |
|---|---|---|---|---|---|---|---|---|---|---|---|
| | | Type | pka | Type | pka | Type | | | | IS resolution | LWR |
| Example 1 | R-1 | A-1 | -0.56 | Q-1 | 5.29 | - | 0.47 | 0.42 | 5.85 | 20.0 | 4.9 |
| Example 2 | R-2 | A-2 | -2.71 | Q-2 | 4.79 | - | 0.47 | 0.53 | 7.50 | 17.5 | 4.5 |
| Example 3 | R-3 | A-3 | 0.33 | Q-3 | 7.61 | - | 0.74 | 0.42 | 7.28 | 15.0 | 3.9 |
| Example 4 | R-4 | A-4 | 1.70 | Q-4 | 2.45 | - | 0.55 | 0.47 | 0.75 | 25.0 | 5.1 |
| Example 5 | R-5 | A-5 | -0.47 | Q-5 | 5.47 | - | 0.49 | 0.43 | 5.94 | 20.0 | 4.6 |
| Example 6 | R-6 | A-6 | -0.82 | 0-6 | 7.10 | - | 0.47 | 0.49 | 7.92 | 17.5 | 4.7 |
| Example 7 | R-7 | A-7 | -1.07 | Q-7 | 3.34 | - | 0.54 | 0.43 | 4.41 | 17.5 | 4.1 |
| Example 8 | R-8 | A-8 | 1.54 | Q-9 | 3.01 | - | 0.47 | 0.42 | 1.47 | 20.0 | 4.7 |
| Example 9 | R-9 | A-9 | -0.56 | Q-9 | 3.01 | P-1 | 0.57 | 0.61 | 3.57 | 15.0 | 3.4 |
| Example 10 | R-10 | A-10 | -0.56 | Q-5 | 5.47 | - | 0.49 | 0.41 | 6.03 | 20.0 | 4.4 |
| Example 11 | R-11 | A-11 | -0.56 | Q-10 | 3.43 | - | 0.49 | 0.44 | 3.99 | 20.0 | 4.4 |
| Example 12 | R-12 | A-12 | -2.71 | Q-9 | 3.01 | - | 0.46 | 1.08 | 5.72 | 20.0 | 3.7 |
| Example 13 | R-13 | A-13 | 1.70 | Q-2 | 4.79 | - | 0.53 | 1.48 | 3.09 | 12.5 | 3.0 |
| Example 14 | R-14 | A-14 | 0.33 | Q-6 | 7.10 | P-2 | 0.54 | 1.18 | 6.77 | 15.0 | 3.3 |
| Example 15 | R-15 | A-15 | 1.70 | Q-9 | 3.01 | P-3 | 0.58 | 1.07 | 1.31 | 15.0 | 3.4 |
| Example 16 | R-16 | A-16 | -0.56 | Q-11 | 4.79 | - | 0.62 | 0.49 | 5.35 | 17.5 | 4.1 |
| Example 17 | R-17 | A-17 | -0.56 | Q-7 | 3.34 | - | 0.48 | 0.40 | 3.90 | 20.0 | 4.6 |
| Example 18 | R-18 | A-18 | -0.87 | Q-2 | 4.79 | - | 0.47 | 0.53 | 5.66 | 20.0 | 4.2 |
| Example 19 | R-19 | A-19 | 1.70 | Q-5 | 5.47 | - | 0.61 | 0.41 | 3.77 | 17.5 | 4.2 |
| Example 20 | R-20 | A-20 | 1.70 | Q-6 | 7.10 | - | 0.54 | 0.43 | 6.24 | 17.5 | 4.5 |
| Comparative Example 1 | r-1 | A-21 | -0.56 | Q-4 | 2.45 | - | 0.18 | 0.35 | 3.01 | 40 | 6.3 |
| Comparative Example 2 | r-2 | a-1 | -3.10 | Q-12 | 0.84 | - | 0.16 | 0.73 | 3.94 | 40 | 5.9 |
| Comparative Example 3 | r-3 | A-22 | 1.54 | Q-13 | 1.60 | - | 0.14 | 0.83 | 0.06 | >50 | 7.1 |
| Comparative Example 4 | r-4 | A-23 | 1.70 | Q-8 | 1.81 | - | 0.44 | 1.11 | 0.11 | >50 | 6.7 |

(continued)

| | Resist composition | Resin | | Acid diffusion control agent | | Other photoacid generator | Qp | Content a | Δpka | Evaluation result | |
|---|---|---|---|---|---|---|---|---|---|---|---|
| | | Type | pka | Type | pka | Type | | | | IS resolution | LWR |
| Comparative Example 5 | r-5 | A-24 | 0.33 | Q-4 | 2.45 | - | 0.48 | 0.20 | 2.12 | 40 | 5.7 |
| Comparative Example 6 | r-6 | A-25 | -0.56 | Q-7 | 3.34 | - | 0.45 | 1.52 | 3.90 | >50 | 7.3 |

From the evaluation results shown in Table 3, it was confirmed that the pattern obtained using the resist composition according to the embodiment of the present invention was excellent in resolution and also excellent in LWR.

In a case where Qp was 0.50 to 1.00, it was confirmed that the effect of the present invention was more excellent (comparison between Examples 7, 16, 19, and 20 and Example 1, and the like). In addition, in a case where Qp was 0.70 to 1.00, it was confirmed that the effect of the present invention was still more excellent (comparison between Example 3 and Example 2, and the like).

In a case where the content of the repeating unit a was 0.60 to 1.50 mmol/g per total solid content mass of the resist composition, it was confirmed that the effect of the present invention was more excellent (comparison between Examples 9 and 13 to 15 and Examples 7 and 16, and the like). In addition, in a case where the content of the repeating unit a was 1.20 to 1.50 mmol/g per total solid content mass of the resist composition, it was confirmed that the effect of the present invention was still more excellent (comparison between Example 13 and Examples 9, 14, and 15, and the like).

In a case of generating an acid having a pKa higher than a pKa of the acid generated from the photoacid generating group represented by Formula (c) by 1.00 or more, it was confirmed that the effect of the present invention was more excellent (comparison between Example 1 and Example 4, and the like). In addition, in a case of generating an acid having a pKa higher than a pKa of the acid generated from the photoacid generating group represented by Formula (c) by 7.00 or more, it was confirmed that the effect of the present invention was still more excellent (comparison between Examples 2, 3, and 6 and Example 1, and the like).

Furthermore, in a case of containing the other photoacid generator, it was confirmed that the effect of the present invention was more excellent (comparison between Examples 9, 14, and 15 and Example 1, and the like).

## Claims

1. An actinic ray-sensitive or radiation-sensitive resin composition comprising:

a resin A including a repeating unit a represented by Formula (1), which has a photoacid generating group represented by Formula (c) in a side chain, and
a repeating unit b having a group which is decomposed by action of acid to generate a polar group,
wherein a content of the repeating unit a is 0.40 to 1.50 mmol/g per a total solid content mass of the composition,
the actinic ray-sensitive or radiation-sensitive resin composition further contains an acid diffusion control agent which is decomposed by irradiation with an actinic ray or a radiation to generate an acid having a pKa higher than a pKa of an acid generated from the photoacid generating group by 0.50 or more, and
Qp obtained by Expression (d) is 0.40 to 1.00,

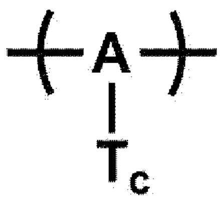

(1)

in Formula (1), A represents a group constituting a main chain, and $T_c$ represents the photoacid generating group represented by Formula (c),

$$*\text{-}L^c\text{-}A^- \, Z_c^+ \qquad (c)$$

in Formula (c), $A^-$ represents an anionic group, $Z_c^+$ represents an organic cation, $L^c$ represents a single bond or a divalent linking group having no fluorine atom, and * represents a bonding position,

$$Qp = X/Y \qquad (d)$$

X: representing a molar amount of the acid diffusion control agent,
Y: in a case where the actinic ray-sensitive or radiation-sensitive resin composition contains other photoacid

generator as a component other than the resin A and the acid diffusion control agent, representing a total molar amount of the molar amount of the acid diffusion control agent, a molar amount of the repeating unit a, and a molar amount of the other photoacid generator, or

in a case where the composition does not contain other photoacid generator as a component other than the resin A and the acid diffusion control agent, representing a total molar amount of the molar amount of the acid diffusion control agent and a molar amount of the repeating unit a.

**2.** The actinic ray-sensitive or radiation-sensitive resin composition according to claim 1,

wherein A is a group represented by any of Formulae (a-1) to (a-6),

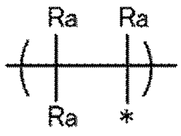

(a-1)

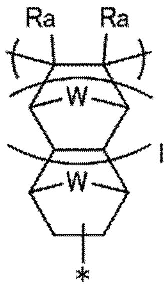

(a-2)

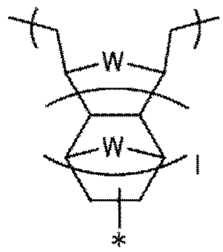

(a-3)

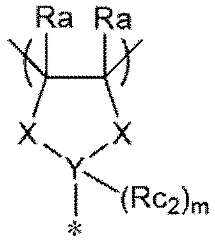

(a-4)

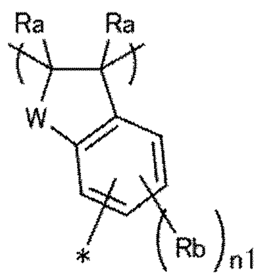

(a-5)

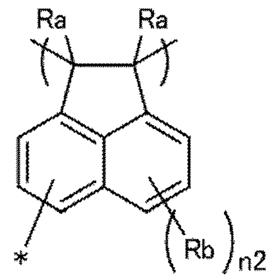

(a-6)

in Formula (a-1), Ra's each independently represent a hydrogen atom, an alkyl group, or $-CH_2-O-Ra_2$, $Ra_2$ represents a hydrogen atom, an alkyl group, or an acyl group, and * represents a bonding position,

in Formula (a-2), Ra's each independently represent a hydrogen atom, an alkyl group, or $-CH_2-O-Ra_2$, $Ra_2$ represents a hydrogen atom, an alkyl group, or an acyl group, W's each independently represent a methylene group, an oxygen atom, or a sulfur atom, 1 represents 0 or 1, and * represents a bonding position,

in Formula (a-3), W's each independently represent a methylene group, an oxygen atom, or a sulfur atom, 1 represents 0 or 1, and * represents a bonding position,

in Formula (a-4), Ra's each independently represent a hydrogen atom, an alkyl group, or $-CH_2-O-Ra_2$, $Ra_2$ represents a hydrogen atom, an alkyl group, or an acyl group, X's each independently represent $-C(Rc_1)_2-$ or -C(=O)-, $Rc_1$'s each independently represent a hydrogen atom, an alkyl group, or an alkoxy group, $Rc_2$'s each independently represent a hydrogen atom or a substituent, Y represents a nitrogen atom or a carbon atom, m represents 0 or 1, in a case where Y is a nitrogen atom, m is 0, and in a case where Y is a carbon atom, m is 1, and * represents a bonding position,

in Formula (a-5), Ra's each independently represent a hydrogen atom, an alkyl group, or $-CH_2-O-Ra_2$, $Ra_2$ represents a hydrogen atom, an alkyl group, or an acyl group, W's each independently represent a methylene group, an oxygen atom, or a sulfur atom, Rb's each independently represent an organic group, n1 represents an integer of 0 to 3, and * represents a bonding position,

in Formula (a-6), Ra's each independently represent a hydrogen atom, an alkyl group, or $-CH_2-O-Ra_2$, $Ra_2$ represents a hydrogen atom, an alkyl group, or an acyl group, Rb's each independently represent an organic group, n2 represents an integer of 0 to 5, and * represents a bonding position.

**3.** The actinic ray-sensitive or radiation-sensitive resin composition according to claim 1,

wherein the repeating unit a includes at least one selected from the group consisting of a repeating unit represented by Formula (a1) and a repeating unit represented by Formula (a2),

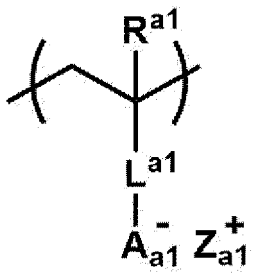
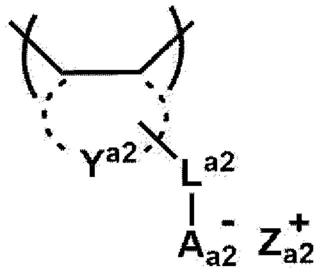

(a1) (a2)

in Formula (a1), $R^{a1}$ represents a hydrogen atom or a substituent, $L^{a1}$ represents a single bond or a divalent linking group having no fluorine atom, $A_{a1}^-$ represents an anionic group, and $Z_{a1}^+$ represents an organic cation, in Formula (a2), $Y^{a2}$ represents a ring group, $L^{a2}$ represents a single bond or a divalent linking group having no fluorine atom, $A_{a2}^-$ represents an anionic group, and $Z_{a2}^+$ represents an organic cation.

**4.** The actinic ray-sensitive or radiation-sensitive resin composition according to any one of claims 1 to 3, wherein the content of the repeating unit a is 0.60 to 1.50 mmol/g per the total solid content mass of the composition.

**5.** The actinic ray-sensitive or radiation-sensitive resin composition according to any one of claims 1 to 4,

wherein the resin A further includes a repeating unit represented by Formula (A2),

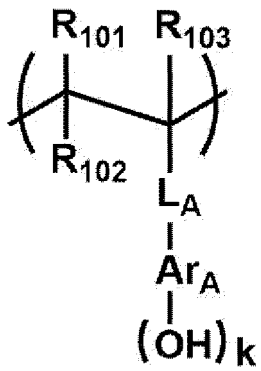

(A2)

in Formula (A2), $R_{101}$, $R_{102}$, and $R_{103}$ each independently represent a hydrogen atom, an alkyl group, a cycloalkyl group, a halogen atom, a cyano group, or an alkyloxycarbonyl group, $L_A$ represents a single bond or a divalent linking group, $Ar_A$ represents an aromatic ring group, and k represents an integer of 1 to 5, where $R_{102}$ may be bonded to $Ar_A$, and in this case, $R_{102}$ represents a single bond or an alkylene group.

**6.** The actinic ray-sensitive or radiation-sensitive resin composition according to any one of claims 1 to 5, wherein Qp is 0.50 to 1.00.

**7.** The actinic ray-sensitive or radiation-sensitive resin composition according to any one of claims 1 to 6, wherein the acid diffusion control agent generates an acid having a pKa higher than the pKa of the acid generated from the photoacid generating group by 1.00 or more.

**8.** The actinic ray-sensitive or radiation-sensitive resin composition according to any one of claims 1 to 7,

wherein the acid diffusion control agent includes at least one selected from the group consisting of a compound

represented by Formula (C1) and a compound represented by Formula (C2),

$$R^{C1a}\text{-}A_{C1}\text{-}\ M_{C1}^{+} \qquad (C1)$$

in Formula (C1), $A_{C1}^{-}$ represents $-COO^{-}$, $-O^{-}$, or $-N^{-}-SO_2-R^{C1b}$, $R^{C1a}$ and $R^{C1b}$ each independently represent an organic group, $R^{C1a}$ and $R^{C1b}$ may be bonded to each other to form a ring, and $M_{C1}^{+}$ represents a sulfonium cation or an iodonium cation,

$$A_{C2}^{-}\text{-}L^{C2}\text{-}M_{C2}^{+} \qquad (C2)$$

in Formula (C2), $A_{C2}^{-}$ represents $-COO^{-}$, $-O^{-}$, or $-N^{-}-SO_2-R^{C2}$, $L^{C2}$ represents a single bond or a divalent linking group, $M_{C2}^{+}$ represents $-S^{+}R^{C3}R^{C4}$ or $-I^{+}R^{C5}$, and $R^{C2}$ to $R^{C5}$ each independently represent an organic group.

**9.** The actinic ray-sensitive or radiation-sensitive resin composition according to any one of claims 1 to 8, wherein the actinic ray-sensitive or radiation-sensitive resin composition further contains the other photoacid generator.

**10.** A resist film formed of the actinic ray-sensitive or radiation-sensitive resin composition according to any one of claims 1 to 9.

**11.** A pattern forming method comprising:

a step of forming a resist film on a substrate using the actinic ray-sensitive or radiation-sensitive resin composition according to any one of claims 1 to 9;
a step of exposing the resist film; and
a step of developing the exposed resist film using a developer.

**12.** The pattern forming method according to claim 10,
wherein the exposing step is a step of exposing the resist film using a multi-electron beam.

**13.** A method for manufacturing an electronic device, comprising:
the pattern forming method according to claim 11 or 12.

**INTERNATIONAL SEARCH REPORT**

International application No.
**PCT/JP2022/010808**

**A. CLASSIFICATION OF SUBJECT MATTER**

***C08F 212/14***(2006.01)i; ***G03F 7/004***(2006.01)i; ***G03F 7/039***(2006.01)i; ***G03F 7/20***(2006.01)i
FI: G03F7/004 503A; G03F7/039 601; G03F7/004 501; C08F212/14; G03F7/20 501; G03F7/20 521

According to International Patent Classification (IPC) or to both national classification and IPC

**B. FIELDS SEARCHED**

Minimum documentation searched (classification system followed by classification symbols)

C08F212/14; G03F7/004; G03F7/039; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2013-137537 A (FUJIFILM CORP) 11 July 2013 (2013-07-11) claims, examples | 1-13 |
| X | JP 2012-093737 A (FUJIFILM CORP) 17 May 2012 (2012-05-17) claims, examples | 1-13 |
| X | JP 2012-037876 A (JSR CORP) 23 February 2012 (2012-02-23) claims, examples | 1-13 |
| X | JP 2015-111637 A (FUJIFILM CORP) 18 June 2015 (2015-06-18) claims, examples | 1-13 |
| X | JP 2015-043067 A (FUJIFILM CORP) 05 March 2015 (2015-03-05) claims, examples | 1-13 |
| X | JP 2015-031796 A (FUJIFILM CORP) 16 February 2015 (2015-02-16) claims, examples | 1-13 |
| X | JP 2014-240942 A (FUJIFILM CORP) 25 December 2014 (2014-12-25) claims, examples | 1-13 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 May 2022** | **24 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (January 2015)

**INTERNATIONAL SEARCH REPORT**
**Information on patent family members**

International application No.
**PCT/JP2022/010808**

| Patent document cited in search report | Publication date (day/month/year) | Patent family member(s) | Publication date (day/month/year) |
|---|---|---|---|
| JP 2013-137537 A | 11 July 2013 | US 2014/0272692 A1<br>claims, examples<br>TW 201329621 A<br>KR 10-2014-0079869 A | |
| JP 2012-093737 A | 17 May 2012 | US 2012/0076997 A1<br>claims, examples<br>KR 10-2012-0032452 A<br>TW 201219970 A | |
| JP 2012-037876 A | 23 February 2012 | TW 201202272 A | |
| JP 2015-111637 A | 18 June 2015 | US 2016/0291461 A1<br>claims, examples<br>TW 201529689 A | |
| JP 2015-043067 A | 05 March 2015 | US 2016/0011517 A1<br>claims, examples<br>TW 201445256 A<br>CN 105103051 A<br>KR 10-2015-0125692 A | |
| JP 2015-031796 A | 16 February 2015 | US 2016/0147155 A1<br>claims, examples<br>TW 201510645 A<br>KR 10-2016-0027152 A | |
| JP 2014-240942 A | 25 December 2014 | US 2015/0185612 A1<br>claims, examples<br>TW 201420612 A<br>KR 10-2015-0043442 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012037876 A
- WO 2018193954 A
- JP 2014098921 A
- WO 2020262134 A
- WO 2020066824 A
- WO 2020158337 A
- US 20160070167 A1
- US 20150004544 A1
- US 20160237190 A1
- US 20160274458 A1
- WO 2020004306 A
- WO 201819395 A
- JP 2014059543 A
- JP 2013061648 A
- JP 2020136289 A
- JP 2020145401 A